(19) Europäisches Patentamt
European Patent Office
Office européen des brevets

(11) EP 3 358 632 A1

(12) **EUROPEAN PATENT APPLICATION**
published in accordance with Art. 153(4) EPC

(43) Date of publication:
**08.08.2018 Bulletin 2018/32**

(21) Application number: **16851700.1**

(22) Date of filing: **29.09.2016**

(51) Int Cl.:
***H01L 33/22*** *(2010.01)*

(86) International application number:
**PCT/JP2016/078748**

(87) International publication number:
**WO 2017/057529 (06.04.2017 Gazette 2017/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority:
**30.09.2015 JP 2015195310**
**30.09.2015 JP 2015195311**
**30.09.2015 JP 2015195314**
**30.11.2015 JP 2015232931**
**30.11.2015 JP 2015233916**
**30.11.2015 JP 2015233917**
**21.12.2015 JP 2015248577**
**24.06.2016 JP 2016125838**

(71) Applicant: **Asahi Kasei Kabushiki Kaisha**
**Chiyoda-ku**
**Tokyo 101-8101 (JP)**

(72) Inventors:
- **MUROO, Hiroyuki**
  **Tokyo 101-8101 (JP)**
- **YAMAGUCHI, Fujito**
  **Tokyo 101-8101 (JP)**
- **KIYAMA, Tomonori**
  **Tokyo 101-8101 (JP)**
- **KOIKE, Jun**
  **Tokyo 101-8101 (JP)**
- **MAEKAWA, Tomofumi**
  **Tokyo 101-8101 (JP)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54) **OPTICAL SUBSTRATE, SUBSTRATE FOR SEMICONDUCTOR LIGHT EMITTING ELEMENT, AND SEMICONDUCTOR LIGHT EMITTING ELEMENT**

(57) To provide semiconductor films for enabling semiconductor light emitting devices particularly having excellent luminous efficiency as compared with conventional devices to be manufactured with high yields, and semiconductor light emitting devices using the films, the present invention provides an optical substrate with a concavo-convex structure (20) formed on a part or the whole of a main surface, where the concavo-convex structure has regular toothless portions. The concavo-convex structure is comprised of convex portions (21), inter-convex portion bottom portions (flat portions) (22), and a concave portion (23) (toothless portion) having a flat plane in a position lower than a main surface formed of the inter-convex bottom portions . Further, it is preferable that the convex portions are arranged with an average pitch P0, the toothless portions are disposed on vertexes of a regular polygon, or disposed on a side of the regular polygon connecting between the vertexes, and that a length of the side of the regular polygon is longer than the average pitch P0.



Printed by Jouve, 75001 PARIS (FR)

(Cont. next page)

FIG. 2

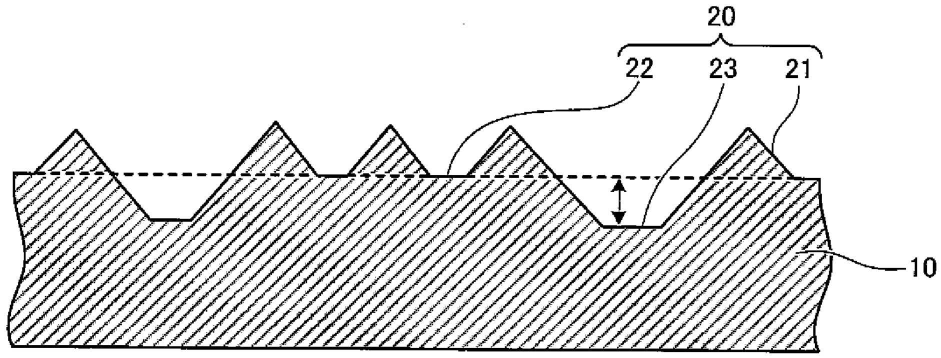

## Description

### Technical Field

The present invention relates to optical substrates having concavo-convex structures, substrates for semiconductor light emitting devices to develop epitaxial growth of semiconductor crystals on the surfaces, and semiconductor light emitting devices obtained from the substrates.

### Background Art

A light-emitting diode (LED) that is a semiconductor light emitting device using semiconductor layers has characteristics such that the size is small, power efficiency is high and that ON-OFF responsivity is fast, as compared with conventional light emitting apparatuses such as conventional fluorescent lamps and incandescent lamps, and since the diode is comprised of all solid, has many advantages such that the diode has vibration resistance and that device life is long.

Among the devices, a GaN-based semiconductor light emitting device typified by blue LED is manufactured by layering an n-layer, light emitting layer, and p-layer on a single crystal substrate by epitaxial growth, and as the substrate, generally, sapphire single crystal substrates and SiC single crystal substrates are used. However, for example, since a lattice mismatch exists between the sapphire crystal and the GaN-based semiconductor crystal, crystal dislocation defects occur by the lattice mismatch (for example, see Patent Document 1). The density of dislocation defects reaches $1x10^9/cm^2$. By the crystal dislocation defects, internal quantum efficiency decreases inside the LED, and as a result, luminous efficiency of the LED decreases.

Further, the refractive index of the GaN-based semiconductor layer is larger than that of the sapphire substrate, light generated inside the semiconductor light emitting layer is not output from the interface with the sapphire substrate at angles of the critical angle or more, and attenuates as a light guide mode, and as a result, there is the problem that external quantum efficiency is reduced.

To solve the above-mentioned problem, techniques are reported where periodical concavo-convex structures are provided on a sapphire substrate surface to develop epitaxial growth of a GaN-based semiconductor layer, and the GaN-based semiconductor layer undergoes epitaxial growth using the lateral growth mode (for example, see Patent Document 1). According the techniques, in the process of epitaxial growth of the semiconductor layer, since the semiconductor layer grown from the C-plane plane is embedded in the concavo-convex structure, the crystal dislocation defects (threading dislocation defects) are reduced, and it is possible to improve the crystal quality of the obtained semiconductor layer.

Further, since concavities and convexities exist in thus obtained interface between the semiconductor layer and the sapphire substrate, light propagating in the lateral direction is scattered, and light extraction efficiency is thereby improved (for example, see Patent Document 2).

Furthermore, techniques for making a particular arrangement of convex portions that are starting points of crystal growth are reported, in order to improve the crystal quality by the concavo-convex structure on the substrate surface as described above (see Patent Document 3).

Still furthermore, a semiconductor light emitting device substrate is reported where particular placement positions are removed from placement positions of convex portions on the substrate with a regular arrangement (see Patent Document 4).

Moreover, a substrate for semiconductor light emitting device is also reported where large-diameter convex portions having small-diameter convex portions are disposed on the surface of the substrate (see Patent Document 5).

### Prior Art Document

### Patent Document

[Patent Document 1] Japanese Unexamined Patent Publication No. 2006-352084
[Patent Document 2] Japanese Unexamined Patent Publication No. 2011-129718
[Patent Document 3] International Publication No. 2009/102033 Pamphlet
[Patent Document 4] Japanese Patent Gazette No. 5707978
[Patent Document 5] International Publication No. 2015/053363 Pamphlet

Disclosure of Invention

Problems to be Solved by the Invention

As factors to determine the external quantum efficiency EQE indicative of luminous efficiency of an LED, there is electron injection efficiency EIE, internal quantum efficiency IQE, and light extraction efficiency LEE. Among the factors, the internal quantum efficiency IQE is dependent on the crystal dislocation defect density caused by the crystal lattice mismatch of GaN-based semiconductor crystal. The light extraction efficiency LEE is improved by disturbing the waveguide mode inside the GaN-based semiconductor crystal by light scattering due to a concavo-convex structure provided on a substrate.

Therefore, in order to improve the luminous efficiency of an LED, it is necessary to decrease the crystal dislocation defect density caused by crystal lattice mismatch of GaN-based semiconductor crystal, and to increase the degree of light scattering due to the concavo-convex structure provided on the substrate.

However, in the techniques as described in Patent Document 1, in order to decrease crystal dislocation defects caused by the crystal lattice mismatch of the semiconductor crystal, it is necessary to decrease the plane density of valley portions that are starting points of crystal growth in the concavo-convex structure on the substrate surface. However, when the plane density is decreased excessively, the area of the substrate plane (for example, C-plane of a sapphire substrate) is decreased which matches with a lattice plane required for epitaxial growth, the crystal plane of an epitaxial film is not stabilized in crystal growth initialization, and contrary, there is the problem that crystal dislocation defects caused by the lattice mismatch are increased.

Also in the techniques as described in Patent Document 2, by arranging convex portions formed on the substrate surface densely, it is possible to improve the light extraction efficiency. However, when gaps between convex portions are eliminated, the substrate plane (for example, C-plane of a sapphire substrate) is lost which matches with a lattice plane that is a starting point of epitaxial growth, the crystal dislocation defects caused by the lattice mismatch are increased to decrease the crystal quality, and as a result, there is the problem that the luminous efficiency of the obtained LED is not improved.

Assuming that the average pitch of the concavo-convex structure is P0, and that the bottom diameter of the concavo-convex structure is D, a width c of a flat portion between convex portions is c=P0-D. Improvements in light extraction efficiency are developed by disturbing the waveguide mode inside the semiconductor layer with a high refractive index by the concavo-convex structure. Accordingly, to further improve the light extraction efficiency, it is preferable to decrease the rate of flat portions between convex portions so as to suppress total reflection. In other words, D is made approach to P0 without limit. On the other hand, the semiconductor layer develops crystal growth from the flat portion of the optical substrate which is a growth plane. When the area of the flat portion is small, crystal nuclei are not capable of growing sufficiently in crystal growth initialization, become association of fine crystal nuclei, and are hard to orientate. Since the size of c is required to some extent, it is not possible to approach D to P0. In a region where the width c of the flat portion is smaller than a value to some extent, when deposition of the semiconductor layer is performed, the nuclei are not associated well, dislocations piercing to the light emitting layer are increased, and the internal quantum efficiency is decreased. In other words, in the conventional concavo-convex structure, there is the tradeoff relationship such that crystal properties are decreased when the light extraction efficiency is improved.

Further, in the techniques as described in Patent Document 3, a pattern of convex planes of the substrate plane (for example, C-plane of a sapphire substrate) which matches with a lattice plane that is the starting point of epitaxial growth is made a particular pattern to decrease the crystal dislocation defect density. However, due to the convex plane pattern, voids are easy to occur inside the obtained semiconductor crystal film, the generated voids decrease the light extraction efficiency, and therefore, as a result, there is the problem that the luminous efficiency of the obtained LED is not improved. In the techniques, although the reason why voids are easy to occur is uncertain, it is considered that the top surface is blocked before valley portions between convex portions are filled with the crystal growth film, because the crystal growth rate is fast in the upper portion of the convex plane.

Furthermore, in Patent Document 4, it is described that it is possible to suppress increase in forward voltage of the obtained semiconductor light emitting device by the substrate having the convex portions with a particular arrangement. However, in the techniques, the crystal dislocation defect density is increased which is caused by the lattice mismatch of the obtained semiconductor crystal layer, and there is the problem that the crystal quality of the semiconductor crystal layer is decreased. Seemingly, the increase in forward voltage is suppressed to improve the efficiency, this is because of increase in leakage current through crystal dislocation defects caused by the lattice mismatch, and there is also the problem that the efficiency of the LED is decreased.

Still furthermore, in the techniques as described in Patent Document 5, it is described that deposition of the semiconductor layer is easy to perform due to the substrate with the large-diameter convex portion having the small-convex portion on the surface arranged, and that the light extraction efficiency is also improved. However, the size and arrangement of each convex portion is not certain and are irregular values, uniformity deteriorates inside the substrate

plane, and particular, in the substrate for semiconductor light emitting device with a large diameter of "4" or more, there is the problem that performance variations are large in the obtained semiconductor light emitting device. Further, since leakage current is increased, there is also the problem that production yield of the entire substrate is hard to increase, and the techniques are not necessarily useful in terms of industrial production.

As described above, in order to provide a concavo-convex structure on the substrate surface to decrease the crystal dislocation defect density caused by the crystal lattice mismatch of the semiconductor crystal, required is the inter-convex portion area of some degree or more, or the substrate plane (for example, C-plane of a sapphire substrate) matching with the lattice plane. On the other hand, in order to improve the light extraction efficiency, the concavo-convex structure is made dense, the structure without the plane portion as possible is required, both structures are in the tradeoff relationship, and it is not necessarily appropriate to suggest the optimal concavo-convex structure on the substrate surface. In other words, in the substrate for semiconductor light emitting device having the conventional concavo-convex structure on the surface, there is the issue that the luminous efficiency of the LED is not sufficiently improved.

Further, according to studies of the inventor of the present invention, even when improving the internal quantum efficiency IQE and light extraction efficiency LEE, there is the case that an LED exhibiting excellent light emitting characteristics is not necessarily obtained. As one of the causes, residual compression stress inside the semiconductor layer is estimated as the cause. In other words, it is necessary to improve the residual compression stress in the semiconductor layer. The luminous efficiency of the LED is thereby further improved, and it is further considered that excellent light emitting characteristics are exerted also when the LED is in a high current density state.

The present invention was made in view of such a respect, and it is an object of the invention to improve the internal quantum efficiency IQE by decreasing crystal dislocation defects inside the semiconductor layer, resolve the waveguide mode by light scattering to improve the light extraction efficiency LEE, and thereby provide optical substrates with surface structure to improve the luminous efficiency of the LED, substrates for semiconductor light emitting devices to develop epitaxial growth of a semiconductor crystal on the surfaces, and semiconductor light emitting devices obtained by using the substrates.

Means for Solving the Problem

The present invention is characterized in that an optical substrate has a concavo-convex structure formed on a part or the whole of a main surface, and that the concavo-convex structure has regular toothless portions.

In the optical substrate of the present invention, it is preferable that the concavo-convex structure is comprised of convex portions, inter-convex portion bottom portions, and a concave portion having a flat plane in a position lower than a main surface formed of the inter-convex bottom portions, and that each of the toothless portions is the concave portion.

In the optical substrate of the invention, it is preferable that the convex portions are arranged with an average pitch P0, the toothless portions are disposed on vertexes of a regular polygon, or disposed on a side of the regular polygon connecting between the vertexes, and that a length of the side of the regular polygon is longer than the average pitch P0.

Further, in the optical substrate of the invention, the length of the side of the regular polygon is preferably two times or more and five times or less the average pitch P0.

Furthermore, in the optical substrate of the invention, it is preferable that each of a plurality of the toothless portions forming the concavo-convex structure is set on a placement position set in each lattice point of a regular triangle lattice as a new unit lattice of a regular hexagon, while being provided in a position that corresponds to a vertex or a side of the regular hexagon.

Still furthermore, in the optical substrate of the invention, it is preferable that each of a plurality of the toothless portions forming the concavo-convex structure is set on a placement position set in each lattice point of a regular triangle lattice as a new regular tringle lattice, while being provided in a position that corresponds to a vertex of the newly set regular triangle.

Moreover, in the optical substrate of the invention, the toothless portions are preferably disposed so that a straight line connecting between the toothless portions is orthogonal to crystal planes to be associated in crystal growth initialization among crystal planes of a semiconductor layer deposited on the optical substrate.

A substrate for semiconductor light emitting device in the present invention is a substrate for semiconductor light emitting device to develop epitaxial growth of a semiconductor crystal on a main surface.

In the substrate for semiconductor light emitting device in the invention, it is preferable that the main surface has a plurality of epitaxial growth promotion portions, and a plurality of epitaxial growth suppression portions to be comprised thereof, peripheries of the epitaxial growth promotion portions are enclosed by the epitaxial growth suppression portions, the epitaxial growth suppression portions are comprised of at least a plurality of the convex portions and the inter-convex bottom portions, and that the epitaxial growth promotion portions are the toothless portions, and have planes parallel with the main surface.

Further, in the substrate for semiconductor light emitting device in the invention, it is preferable that each of the epitaxial growth promotion portions is a concave portion having a flat plane in a position lower than the main surface formed of the inter-convex bottom portions, and is the concave portion having a plane parallel with the main surface as a bottom portion.

Furthermore, in a plurality of the epitaxial growth promotion portions, distances Pe among a plurality of nearest-neighbor epitaxial growth promotion portions are preferably mutually equal.

Still furthermore, distances Pe among the nearest-neighbor epitaxial growth promotion portions of the epitaxial growth promotion portions and distances Pn among a plurality of the convex portions constituting the epitaxial growth suppression portions preferably meet the following equation (1).

$$1.5 \leq Pe/Pn \leq 30 \quad \text{Equation (1)}$$

Moreover, an area ratio of the epitaxial growth promotion portions to the main surface preferably ranges from 0.001 to 0.2.

The substrate for semiconductor light emitting device of the invention is characterized in that the main surface has a plurality of epitaxial growth promotion portions, and a plurality of epitaxial growth suppression portions to be comprised thereof, peripheries of the epitaxial growth suppression portions are enclosed by the epitaxial growth promotion portions, or the epitaxial growth suppression portions are sandwiched between the epitaxial growth promotion portions, the epitaxial growth suppression portions are comprised of at least a plurality of the convex portions and the inter-convex bottom portions, and that each of the epitaxial growth promotion portions is the concave portion, and is the concave portion having a plane parallel with the main surface as a bottom portion.

In the invention, in a plurality of the epitaxial growth promotion portions, distances Pe among a plurality of nearest-neighbor epitaxial growth promotion portions are preferably mutually equal.

In the invention, distances Pe among the nearest-neighbor epitaxial growth promotion portions of the epitaxial growth promotion portions and a period Pn of a plurality of the convex portions constituting the epitaxial growth suppression portions preferably meet the following equation (1).

$$1.5pe \leq Pe/Pn \leq 30 \quad \text{Equation (1)}$$

In the invention, an area ratio of the epitaxial growth promotion portions to the main surface preferably ranges from 0.001 to 0.2.

In addition, it is preferable that the epitaxial growth promotion portions are the toothless portions, and have planes parallel with the main surface.

Herein, an area ratio of the epitaxial growth suppression portions to the main surface preferably ranges from 0.80 to 0.999.

Further, the epitaxial growth suppression portions are preferably comprised of at least a plurality of the convex portions periodically disposed.

Furthermore, the substrate for semiconductor light emitting device of the invention is characterized in that the main surface has a plurality of epitaxial growth promotion portions, and a plurality of epitaxial growth suppression portions to be comprised thereof, peripheries of the epitaxial growth suppression portions are enclosed by the epitaxial growth promotion portions, or the epitaxial growth suppression portions are sandwiched between the epitaxial growth promotion portions, and the epitaxial growth suppression portions are comprised of at least a plurality of the convex portions and the inter-convex bottom portions, and that the epitaxial growth promotion portions are the toothless portions, and have planes parallel with the main surface.

Still furthermore, it is preferable that each of the epitaxial growth promotion portions is a concave portion having a flat plane in a position lower than the main surface formed of the inter-convex bottom portions, and is the concave portion having a plane parallel with the main surface as a bottom portion.

In the invention, an area ratio of the epitaxial growth suppression portions to the main surface preferably ranges from 0.80 to 0.999.

In the invention, the epitaxial growth suppression portions are preferably comprised of at least a plurality of the convex portions periodically disposed.

In the substrate for semiconductor light emitting device of the invention, it is preferable that the substrate is a single crystal substrate having a crystal structure of a hexagonal crystal, and that a nearest-neighbor direction of a plurality of nearest-neighbor epitaxial growth suppression portions is not parallel with an m-plane of the crystal structure of the substrate for semiconductor light emitting device.

The substrate for semiconductor light emitting device of the invention is characterized in that the substrate is provided with at least a first main surface, the first main surface has epitaxial growth promotion portions and epitaxial growth suppression portions, and that the epitaxial growth promotion portions and the epitaxial growth suppression portions meet the following requirements A to C.

A. Peripheries of a scattered plurality of the epitaxial growth promotion portions are enclosed by the epitaxial growth suppression portions; peripheries of a plurality of the epitaxial growth suppression portions are enclosed by the epitaxial growth promotion portions, or the epitaxial growth suppression portions are sandwiched between the epitaxial growth promotion portions;
B. arithmetic average roughness Ra with respect to the epitaxial growth suppression portions is 5 nm or less; and
C. arithmetic average roughness Ra with respect to the epitaxial growth promotion portions is 1.5 nm or less.

It is preferable that the epitaxial growth suppression portions have a plurality of concavo-convex structures to be comprised thereof, and that a duty of the concavo-convex structures is 0.85 or more, or the epitaxial growth promotion portions are periodically disposed.

Further, the substrate for semiconductor light emitting device of the invention is characterized in that the substrate is provided with at least a first main surface, the first main surface has epitaxial growth promotion portions and epitaxial growth suppression portions, and that the epitaxial growth promotion portions and epitaxial growth suppression portions concurrently meet the following requirements A to D.

A. Peripheries of a scattered plurality of the epitaxial growth promotion portions are enclosed by the epitaxial growth suppression portions; peripheries of a plurality of the epitaxial growth suppression portions are enclosed by the epitaxial growth promotion portions, or the epitaxial growth suppression portions are sandwiched between the epitaxial growth promotion portions;
B. the epitaxial growth suppression portions are comprised of a plurality of concavo-convex structures;
C. the epitaxial growth suppression portions and the epitaxial growth promotion portions are periodically arranged; and
D. a period unit A comprised of the epitaxial growth promotion portions and the epitaxial growth suppression portions is arbitrarily selected, and when the period unit A is overlapped with another period unit B arbitrarily selected, a matching rate of a concavo-convex structure S-A included in the period unit A and a concavo-convex structure S-B included in the period unit B to the first main surface by a projection area ranges from 0.60 to 0.99.

A semiconductor light emitting device of the present invention is characterized by having the optical substrate as described above, or the substrate for semiconductor light emitting device as described above, and a layered semiconductor layer formed by layering at least two or more semiconductor layers and a light emitting layer, layered on the main surface side.

In the semiconductor light emitting device of the invention, it is preferable that the device is a semiconductor light emitting device with at least a first semiconductor layer, a light emitting semiconductor layer, a second semiconductor layer and a transparent conductive film layered on a growth substrate with a concavo-convex structure formed on a part or the whole of one main surface, the concavo-convex structure has epitaxial growth promotion portions and epitaxial growth suppression portions to be comprised of, and is configured by any of that peripheries of a scattered plurality of the epitaxial growth promotion portions are enclosed by the epitaxial growth suppression portions, peripheries of a plurality of the epitaxial growth suppression portions are enclosed by the epitaxial growth promotion portions, and that the epitaxial growth suppression portions are sandwiched between the epitaxial growth promotion portions, and that a thickness (T_TE) of the transparent conductive film ranges from 30 nm to 100 nm.

Advantageous Effect of the Invention

According to the optical substrate, or the substrate for the semiconductor light emitting device of the present invention, by decreasing crystal dislocation defects inside the semiconductor layer formed on the substrate or substrate surface, the crystal quality is improved, it is thereby possible to improve the internal quantum efficiency IQE, and by resolving the waveguide mode by light scattering, it is possible to enhance the light extraction efficiency LEE. As a result, it is possible to improve the luminous efficiency of the LED, and it is possible to manufacture semiconductor light emitting devices having excellent luminous efficiency with a high yield.

Further, according to the invention, it is possible to provide semiconductor light emitting devices which are high in luminous efficiency, suppress leakage current, and which are capable of improving the luminous wavelength distribution, and further, it is possible to reduce residual compression stress with respect to the semiconductor light emitting device.

Brief Description of Drawings

FIG. 1 is a cross-sectional schematic diagram illustrating a partial longitudinal section of an optical substrate of this Embodiment;
FIG. 2 is another cross-sectional schematic diagram illustrating a partial longitudinal section of the optical substrate of this Embodiment;
FIG. 3 is a plan schematic diagram of the optical substrate of this Embodiment;
FIG. 4 is a plan schematic diagram of an optical substrate of an Embodiment different from the Embodiment in FIG. 3;
FIG. 5 is a plan schematic diagram of the optical substrate of this Embodiment, and is the diagram to explain structural requirements of this Embodiment;
FIG. 6 is a plan diagram illustrating a view of edge defects of a first semiconductor layer deposited on an optical substrate provided with concavo-convex structure;
FIG. 7 illustrates the section A-A of FIG. 6;
FIG. 8 is a cross-sectional schematic diagram illustrating a partial longitudinal diagram of the optical substrate of this Embodiment, and is an explanatory diagram to particularly explain parameters;
FIG. 9A, 9B and 9C contain plan schematic diagrams of the optical substrate of this Embodiment, and are explanatory diagrams to particularly explain parameters;
FIG. 10 is a plan schematic diagram of the optical substrate of this Embodiment, and is an explanatory diagram to particularly explain an arrangement of concave portions;
FIG. 11 is another plan schematic diagram of the optical substrate of this Embodiment, and is an explanatory diagram to particularly explain an arrangement of concave portions;
FIG. 12 is still another plan schematic diagram of the optical substrate of this Embodiment, and is an explanatory diagram to particularly explain the arrangement of concave portions;
FIG. 13 is an explanatory diagram illustrating the relationship between concave portions and initial crystal nuclei of a semiconductor layer;
FIG. 14 is another explanatory diagram illustrating the relationship between concave portions and initial crystal nuclei of the semiconductor layer;
FIG. 15 is a plan schematic diagram of a substrate for semiconductor light emitting device of this Embodiment;
FIG. 16 is a cross-section schematic diagram of the plane X-X in FIG. 15;
FIG. 17 is another plan schematic diagram of the substrate for semiconductor light emitting device of this Embodiment;
FIG. 18 is a plan schematic diagram of a substrate for semiconductor light emitting device in conventional techniques;
FIG. 19A, 19B and 19C contain cross-sectional schematic diagrams to explain a mechanism for decreasing crystal dislocation defects by the substrate for semiconductor light emitting device in conventional techniques;
FIG. 20A, 20B and 20C contain cross-sectional schematic diagrams to explain epitaxial growth in the substrate for semiconductor light emitting device of this Embodiment;
FIG. 21 is a cross-sectional schematic diagram of a substrate for semiconductor light emitting device of another Embodiment;
FIG. 22 is a plan schematic diagram of a substrate for semiconductor light emitting device according to still another Embodiment;
FIG. 23 is a plan schematic diagram of a substrate for semiconductor light emitting device of still another Embodiment;
FIG. 24 is a plan schematic diagram of a substrate for semiconductor light emitting device of still another Embodiment;
FIG. 25 is a plan schematic diagram of a substrate for semiconductor light emitting device of still another Embodiment;
FIG. 26 is a plan schematic diagram of a substrate for semiconductor light emitting device of still another Embodiment;
FIG. 27 is a plan schematic diagram of a substrate for semiconductor light emitting device of still another Embodiment;
FIG. 28 is a plan schematic diagram of a substrate for semiconductor light emitting device of still another Embodiment;
FIG. 29 is a plan schematic diagram of a substrate for semiconductor light emitting device of still another Embodiment;
FIG. 30 is a plan schematic diagram of a substrate for semiconductor light emitting device of still another Embodiment;
FIG. 31A and 31B contain plan schematic diagrams of a substrate for semiconductor light emitting device of Embodiment 2;
FIG. 32 is a plan schematic diagram of a substrate for semiconductor light emitting device of another Embodiment;
FIG. 33A, 33B and 33C contain plan schematic diagrams of epitaxial growth promotion portions and epitaxial growth suppression portions formed on a growth substrate in another Embodiment of the present invention;
FIG. 34A, 34B and 34C contain plan schematic diagrams illustrating enlarged epitaxial growth promotion portions

and epitaxial growth suppression portions of FIG. 33A, 33B and 33C;
FIG. 35A, 35B, 35C and 35D contain plan schematic diagrams to explain shapes of epitaxial growth promotion portions;
FIG. 36A, 36B and 36C contain plan schematic diagrams of epitaxial growth promotion portions and epitaxial growth suppression portions to explain a period unit comprised of epitaxial growth promotion portions and epitaxial growth suppression portions;
FIG. 37 is a cross-sectional schematic diagram of a resist layer used in manufacturing the optical substrate shown in FIG. 8;
FIG. 38 is a plan schematic diagram of a resist layer of this Embodiment;
FIG. 39 is a plan schematic diagram of an optical substrate formed by using the resist layer shown in FIG. 38;
FIG. 40 is a plan schematic diagram of a resist layer of an Embodiment different from the Embodiment shown in FIG. 38;
FIG. 41 is a cross-sectional schematic diagram of a semiconductor light emitting device according to this Embodiment;
FIG. 42A, 42B, 42C contain electron microscope photographs to compare the substrate for semiconductor light emitting device according to this Embodiment with the substrate for semiconductor light emitting device in conventional techniques; and
FIG. 43A, 43B and 43C contain schematic diagrams illustrating a part of each photograph of FIG. 42A, 42B and 42C.

Best Mode for Carrying Out the Invention

One Embodiment (hereinafter, abbreviated as "Embodiment") of the present invention will be described below in detail. In addition, the present invention is not limited to the following Embodiment, and is capable of being carried into practice with various modifications thereof within the scope of the subject matter.

(Optical substrate)

Optical substrates according to this Embodiment will be described below in detail.
The optical substrate according to this Embodiment is an optical substrate with a concavo-convex structure formed on a part or the whole of a main surface, and is characterized in that the concavo-convex structure has regular toothless portions.
According to this composition, it is possible to provide easy growth portions of an epitaxial crystal, and it is possible to manufacture semiconductor light emitting devices high in internal quantum efficiency IQE and light extraction efficiency LEE with a high yield.
The optical substrate is provided with the following characteristic composition.

(1) A concavo-convex structure is formed on a part or the whole of the main surface, and
(2) the concavo-convex structure has regular toothless portions to be comprised thereof.

Further, preferably, the substrate includes the following characteristic composition. In other words, the above-mentioned (1) and (2) are essential structural requirements in this Embodiment, and the following (3), (4), (5), (6) are selective structural requirements.

(3) The concavo-convex structure is comprised of convex portions, inter-convex portion bottom portions, and concave portions having flat planes in positions lower than a main surface formed of the inter-convex bottom portions, and the toothless portions are the concave portions.
(4) The convex portions are disposed with an average pitch P0.
(5) The toothless portion is disposed on a vertex of a regular polygon, or disposed on a side of the regular polygon connecting between the vertexes.
(6) A length L of the side of the regular polygon is longer than the average pitch P0.

FIGs. 1 and2 are cross-sectional schematic diagrams illustrating partiallongitudinal sections of the optical substrate of this Embodiment. FIG. 3 is a plan schematic diagram of the optical substrate of this Embodiment
As shown in FIG. 1, a flat portion 4 is provided with a narrow flat portion 4b with a narrow distance positioned between convex portions 3, and a wide flat portion 4a with a wide distance positioned between convex portions 3. Among the portions, the wide flat portion 4a in the composition of FIG. 1 has a width with a single convex portion 3 subjected to thinning-out. Then, in the wide flat portion 4a, the thinning-out portion of the convex portion is configured as a toothless portion 5. "Thinning-out" and "toothless" described herein do not mean that the convex portion 3 actually formed is removed in the subsequent process, and mean that the portion is formed in a distance subjected to like thinning-out and

in the thinning-out-like shape. Accordingly, an Embodiment where the wide flat portion 4a and narrow flat portion 4b are concurrently formed in a transfer process or the like is the composition of this Embodiment. Then, the toothless portion 5 exhibits a concave bottom shape in a position in which the convex portion 3 is thinned out. Accordingly, as shown in FIG. 3 and subsequent figures, the toothless portion 5 is shown in the figure with the same plane as the convex portion 3.

In the Embodiment shown in FIG. 1, height positions are the same in the toothless portion 5 (wide flat portion 4a) and narrow flat portion 4b. In addition, as described later, the toothless portion 5 may be composition including a concave bottom lower than the narrow flat portion 4b.

Described next is the case where the toothless portion 5 is a concave portion including a concave bottom lower than the narrow flat portion 4b, and in the description related to the plan diagram of the Embodiment shown in FIG. 1, the definition is made by reading the concave portion with the toothless portion.

As shown in FIGs . 2 and 3, a concavo-convex structure 20 has convex portions 21, a concave portion 23 (that corresponds to the toothless portion 5 in FIG. 1), and a flat portion (inter-convex portion bottom portion; which corresponds to the narrow flat portion 4b in FIG. 1) 22 positioned between the convex portion 21 and the concave portion 23 (the above-mentioned (1) (2) (3)). The flat portion 22 is a flat portion extending at foot portions of the convex portions 21, and is provided in a height position between the vertex of the convex portion 21 and the bottom of the concave portion 23. In addition, in FIG. 3, in order to distinguish between the convex portion 21 and the concave portion 23, the concave portion 23 is diagonally shaded.

In FIG. 3, each of the concave portions 23 is independently disposed, and as shown in FIG. 4, the concave portions may be disposed contiguously.

As shown in FIG. 5, the convex portions 21 constituting the concavo-convex structure 20 are disposed with the average pitch P0 (above-mentioned (4)).

As shown in FIG. 5, the concave portions 23 are disposed in positions of respective vertexes of the regular hexagon (above-mentioned (5)).

Further, in FIG. 5, the length L of one side of the regular hexagon is three times the average pitch P0 (above-mentioned (6)).

In the following description, names of arrangements are determined by the following rules. In the case of having independent concave portions 23 typified by FIG. 5, for example, in FIG. 5, placement of the concave portions 23 is in vertex positions of the hexagon, the length L of one side is three times the average pitch P0, and therefore, this placement is called a three-times hexagonal point arrangement.

On the other hand, in the case of having contiguous concave portions 23 typified by FIG. 4, placement of contiguous concave portions 23 is a hexagon, the length L of one is three times the average pitch P0, and therefore, this placement is called a three-times hexagonal side arrangement. In addition, the length L corresponds to a length of one side in drawing center lines of band-shaped concave portions 23 in the shape of a hexagon.

Based on the three-times hexagonal point arrangement shown in FIG. 5, described below are principles of exerting effects by the optical substrate of this Embodiment.

In this Embodiment, the optical substrate 10 is provided with the concave-convex structure 20 on its main surface, and the concavo-convex structure 20 has convex portions 21, concave portions 23, and flat portions (inter-convex portion bottom portions) 22 positioned between the convex portion 21 and the concave portion 23 to be comprised thereof. In addition, in the optical substrate 10, the "main surface" is a surface on which the concavo-convex structure 20 is formed, and the main surface in each layer deposited on the optical substrate 10 refers to a surface (surface on the side opposite to the surface on the side opposed to the optical substrate) on the upper surface side when the optical substrate 10 is disposed on the lower side.

The external quantum efficiency EQE of an LED is represented by the product of the internal quantum efficiency IQE and the light extraction efficiency LEE. In order to further improve the light extraction efficiency, it is effective to decrease the rate of the flat portions 22 to disturb the waveguide mode. However, when the flat portion area is decreased, particularly, when the flat portion width is smaller than a length of some extent to determine initial crystallinity, association of defects does effectively not occur in the initial stage in crystal growth, and the defect tends to be threading dislocation. In addition thereto, each nucleus is easy to be affected by a minute variation of surrounding concavo-convex structures, and the in-plane distribution occurs in the defect density. Since defects are unevenly distributed inside the surface, uniform film formation is difficult, which leads to roughness of the main surface and formation of pits, and increase in leakage current is provoked. The leakage current is an amount representing electric characteristics of a diode, and a current amount of a predetermined amount or more has adverse effects on performance as the light emitting device. In other words, when the flat portions 22 are decreased to intend to increase efficiency, as a result, there is the problem that chip yield per wafer decreases.

Then, as a result of much discussion, the inventors of the present invention found out that by providing the optical substrate 10 with the concavo-convex structure 20 having the convex portions 21, flat portions 22 and concave portions 23, it is possible to manufacture semiconductor light emitting devices high in internal quantum efficiency IQE and light extraction efficiency LEE with a high yield.

In this Embodiment, the concavo-convex portion 20 is intentionally provided with toothless portions. The toothless portion has a flat area that corresponds to at least a single convex portion, and becomes an easy growth portion. In other words, in order to improve the light extraction efficiency, even under conditions that a sufficient flat portion area is not ensured, by intentionally arranging the toothless portion, the toothless portion is the easy growth portion, and it is possible to cause crystal growth to proceed selectively from the easy growth portion. The "toothless" described herein does not mean that the convex portion 21 actually formed is removed in the subsequent process, and means that a distance subjected to like thinning-out is formed and that the portion is in the thinning-out-like shape.

In the Embodiment shown in FIG. 2, with respect to the toothless portion, the portion is not simply a flat region, and the concave portion 23 lower than the flat portion 22 by one step is formed. By this means, the concave portion 23 functions as an easy growth portion capable of further improving crystallinity. Thus, in this Embodiment, since the easy growth portion is the concave portion 23, it is assumed that nucleus formation from the extremely narrow flat portion 22 between the convex portions 21 is further suppressed, and that selectivity of initial defect positions is increased, and it is thereby possible to further improve crystallinity.

FIG. 6 is a plan diagram illustrating a view of edge defects of a first semiconductor layer deposited on the optical substrate provided with the concavo-convex structure. FIG. 7 illustrates the section A-A of FIG. 6.

As shown in FIG. 7, since initial crystal nuclei concentrate on the concave portion 23, a starting point of a crystal defect of a first semiconductor layer 30 also concentrates on the concave portion 23 of the optical substrate. Subsequently, in the first semiconductor layer 30, as shown in FIG. 7, the crystal grows in a lateral direction i.e. toward the center direction of each unit lattice (see FIG. 6), film formation of the first semiconductor layer 30 proceeds with the defect inside the first semiconductor layer 30 in a meandering shape in the center direction of each unit lattice, and then, the main surface is flattened.

The starting point of the defect is controlled and concentrates on the concave portion 23, the in-plane distribution of the defect density is thereby decreased, and it is possible to grow the crystal uniformly, while suppressing roughness of the main surface and formation of pits. Therefore, in addition to improvement in internal quantum efficiency derived from improvement in crystallinity, it is possible to effectively increase the number of semiconductor light emitting devices (chip yield per wafer) obtained from a wafer.

Further, since the easy growth portion is the concave portion 23, as compared with the case where the easy growth portion is flat, the side area of the concavo-convex structure is increased, and the light extraction efficiency is also improved. From the foregoing, by providing the concave portion 23 as the easy growth portion, it is possible to manufacture semiconductor light emitting devices high in internal quantum efficiency IQE and light extraction efficiency LEE with a high yield.

In addition, the above-mentioned description is given using the three-times hexagonal point arrangement, but is particularly not limited thereto, and is the same also in the case of contiguous concave portions or structure having different repetition periods.

In addition, the "regular" polygon described in this application includes polygons including a variation in length L' of each side is within ±10% with respect to the side length L (average) constituting the polygon. For example, when the average side length L is 2100 nm, polygons with the side length L' ranging from 1890 nm to 2310 nm are defined as the regular polygon.

Described next are parameters of the concave-convex structure 20.

The average pitch P0 shown in FIG. 5 is defined as an arithmetic mean of distances between nearest-neighbor vertexes of convex portions 21.

A local range used in measurement is defined as a range of about 5 times to 50 times the average pitch P0 of the concavo-convex structure. For example, when the average pitch P0 is 700 nm, measurement is performed in a measurement range of 3500 nm to 35000 nm. Therefore, for example, a field image of 7500 nm is shot, for example, in a position of the center within the region having the concavo-convex structure, and the arithmetic mean is obtained using the image. For imaging of the field image, for example, it is possible to use a scanning electron microscope (SEM) and atomic force microscope (AFM).

(Arithmetic mean)

In the case of assuming that N measurement values of a distribution of some element (variate) are x1, x2 ···, Xn, the arithmetic mean value is defined by the following equation (2).

[Mathematics 1]

$$\text{Equation (2)} \qquad \bar{x} = \frac{\sum_{i=1}^{N} xi}{N}$$

The number N of samples in calculating the arithmetic mean is defined as "20". Defining as "20" is to take an adequate statistics mean in selecting each concavo-convex structure arbitrarily within the following local range.

From the viewpoint of the light extraction efficiency, the average pitch P0 is preferably 500 nm or more, and more preferably 700 nm or more. Further, when the side length L of the unit lattice determined by the concave portion is excessively long, a film thickness of the first semiconductor layer 30 required to flatten is thick, resulting in decrease in throughput, and in addition thereto, warping is apt to occur in film formation. From the viewpoint, the average pitch P0 is preferably 2000 nm or less, and more preferably 1800 nm or less.

(Convex portion height H)

A convex portion height H is defined as a difference in height between a convex portion vertex portion and a convex portion bottom portion in the flat portion (FIG. 8). When the convex portion height H is high, the film thickness is thick in flattening with the first semiconductor layer 30, and warping is apt to occur in film formation. Therefore, the height H is preferably 1300 nm or less, and more preferably 1200 nm or less. In addition, the convex portion bottom portion is a position where the convex portion 21 contacts the flat portion 22, and the convex portion height H is specified as a height from the flat portion 22, instead of a height from the bottom position of the concave portion 23.

(Convex portion bottom portion diameter D)

In a plan view, a convex portion bottom portion diameter D is defined as a diameter of a circumscribed circle of the convex portion bottom portion. For example, when the convex portion bottom portion is a complete round, as shown in FIG. 9A, the diameter is uniquely determined. However, in the actualconcavo-convexstructure, the convex portion bottom portion is in a shape distorted from the complete round. Particularly, on etching conditions of thickening the bottom portion diameter, the circular bottom portion approaches a hexagon. In this case, the diameter of the circumscribed circle of the convex portion bottom portion is defined as the bottom portion diameter (FIG. 9B).

(Duty)

The duty is defined as a ratio (D/P0) between the convex portion bottom portion diameter D and the average pitch P0, and is an amount representing a filling degree of the concavo-convex structure. When the duty is small i.e. the convex portion bottom portion diameter D is small with respect to the average pitch P0, the rate of exposure of the flat portion 22 ishigh. In this case, crystal growth proceeds also from the flat portion 22, and position selectivity for selectively growing from the concave portion (easy growth portion) 23 is decreased. Accordingly, in order to suppress defects of the semiconductor layer and improve the internal quantum efficiency IQE, it is preferably to suppress initial crystal growth from the flat portion of the optical substrate. Therefore, the duty is preferably 0.85 or more, and more preferably 0.9 or more. On the other hand, as etching proceeds, the shape of the bottom portion of the convex portion 21 is distorted by existence of adjacent convex portions. When the shape is distorted, voids are apt to occur in crystal growth. As a result, light is scattered by the voids, and the light extraction efficiency is decreased. From this viewpoint, the duty is preferably 1.1 or less, and more preferably 1.05 or less.

(Convex portion aspect ratio A)

A convex portion aspect ratio A is defined as a ratio (H/D) between the convex portion height H and the convex bottom portion diameter D. In order to disturb the waveguide mode and improve the light extraction efficiency, the convex portion aspect ratio A is preferably 0.3 or more, and more preferably 0.4 or more. When the convex portion aspect ratio A is large, voids are easy to occur in flattening, and the light extraction efficiency is decreased. From this view point, the convex portion aspect ratio A is preferably 1 or less, and more preferably 0.85 or less.

(Concave portion depth lo_d, concave portion opening width lo_w)

A concave portion depth lo_d is defined as a difference in height between the convex portion bottom portion in the flat portion and the concave portion bottom portion (FIG. 8). Accordingly, the height H from the flat portion 22 to the vertex portion of the convex portion 21 is not included in the concave portion depth lo_d. As shown in FIG. 9A, when the concave portion 23 is independent, a concave portion opening width lo_w is an opening diameter of the concave portion 23. As shown in FIG. 9B, the width is defined as an inscribed circle with respect to the convex portion bottom portions surrounding the periphery.

On the other hand, as shown in FIG. 9C, when the concave portions 23 are contiguous, the concave portion opening width lo_w is a width of a line formed of contiguous concave portions, and as shown in FIG. 9C, is defined as

a distance between tangents of adjacent convex portion bottom portions. From the viewpoint of improving position selectivity in initial crystal growth, the concave portion depth lo_d is preferably 20 nm or more, and more preferably 25 nm or more.

Further, in the case where the concave portion depth lo_d is deep excessively, flatness degrades on the entire substrate of the semiconductor layer undergoing crystal growth from the convex portion bottom portion, and such a case is not preferable. A ratio ((lo_d)/(lo_w)) between the concave portion depth lo_d and the concave portion opening width lo_w is preferably 1 or less, and more preferably 0.85 or less.

Furthermore, from the viewpoint of improving crystallinity of initial crystal nuclei, the concave portion opening width lo_w is preferably 100 nm or more, and more preferably 200 nm or more. The width of 300 nm or more is preferable because flatness in crystal growth is improved, and the width is preferably two times or less the diameter of the adjacent convex portion bottom portion.

In the placement where the concave portions 23 are contiguous shown in FIG. 9C, bottom portions of the concave portions 23 have approximately equal widths, and are uniform inside the optical substrate plane. In a region enclosed by the concave portions 23, the convex portions are in the approximately uniform shape, in-plane uniformity is thereby enhanced, and flatness in crystal growth is improved. When the flatness in crystal growth is improved, leakage current is decreased in obtained semiconductor light emitting devices.

Further, in a side portion extending from the bottom portion of the concave portion 23 shown in FIG. 9C to the vertex portion of the convex portion 21 via the side of the concave portion 23 and the side of the convex portion 21, the side portion is a continuous oblique surface portion, and is in the shape where the side of the convex portion 21 is drawn to the bottom portion edge of the concave portion 23 continuously.

(Shape)

In addition, the concavo-convex structure 20 is formed on one main surface of the optical substrate 10. It is possible to provide the concavo-convex structure 20 on the entire surface of the main surface or on a part of the main surface. Further, as the shape of dots, for example, there are structures such as a cone, cylinder, quadrangular pyramid, quadrangular prism, hexagonal pyramid, hexagonal prism, polygonal pyramid, polygonal prism, the shape of a double ring and the shape of a multi-ring. In addition, these shapes include shapes where the outside diameter of the bottom is distorted, and the shape where the side is curved.

(Arrangement of concave portions)

The arrangement of concave portions 23 is capable of being modified as appropriate, using the length L of one side of the unit lattice formed by the concave portion 23, the thickness of the semiconductor layer required in growing in the lateral direction to flatten, and the like. For example, when the length L is extremely large, the thickness of the semiconductor layer required to flatten is remarkably thick, and warping tends to occur. Handling in process is thereby made difficult.

For example, as shown in FIG. 5, a new unit lattice 7 of a regular hexagon is set in a placement position set in each lattice point of a regular triangle lattice 9, and the concave portions 23 may be provided in placement positions (hexagonal point arrangement) that correspond to vertexes of the regular hexagon. Further, as shown in FIG. 10, the concave portions 23 may be set as a new regular triangle in placement positions set in respective lattice points of a regular triangle lattice, while being provided in positions that correspond to vertexes of the newly set regular triangle. In other words, the concave portions 23 are provided in placement positions (trigonal point arrangement) that correspond to vertexes of the triangle. Further, the newly set lattice may be in placement (FIGs. 11, 12) rotated 90 degrees with respect to the regular triangle lattice where the convex portions are disposed. In each arrangement, the length L of one side of the newly set lattice is capable of being modified as appropriate, and is not limited to the length shown in the figures. When the length of one side is short, the density of the concave portions 23 is relatively increased, and as the entire crystal, the effect is not exerted sufficiently such that the concave portions 23 are introduced to control initial defect occurring portions. From this viewpoint, the length of one side of the lattice is preferably 1.5 times the average pitch PO or more, further preferably 2 times or more, and more preferably $2\sqrt{3}$ times or more. On the other hand, when the length L is extremely large, the thickness of the semiconductor layer required to flatten is remarkably thick, and warping tends to occur. Handling in process is thereby made difficult. From this viewpoint, the length of one side of the lattice is preferably $4\sqrt{3}$ times the average pitch PO or less.

Placement of the concave portions 23 is more preferable when the placement is to associate planes of crystal nuclei growing from the concave portions 23. For example, in a hexagonal crystal, in order to decrease defects, placement where crystal nuclei are associated in crystal planes F as shown in FIG. 14 is more preferable than the case where each crystal nucleus is associated in the side (shown as the point P in FIG. 13) indicating the boundary between crystal planes as shown in FIG. 13. As shown in FIG. 14, in order to associate crystal nuclei with each other in planes, placement of

each concave portion 23 is adjusted so that a straight line M connecting between concave portions 23 is orthogonal to a crystal plane F associated in crystal growth initialization. Accordingly, placement of the concave portions 23 is determined by reflecting crystal symmetry of the first semiconductor layer 30. In addition, "association" refers to a state in which each crystal nucleus is bonded.

For example, when the first semiconductor layer 30 is a hexagonal crystal, positions of the concave portions 23 are preferably in trigonal lattices or hexagonal placement, while being preferably a quadrature arrangement when the layer 30 is a cubic crystal . Further, for example, in the case of forming a resist layer by an imprint method, with respect to a mold with toothless portions having crystal symmetry, by rotating the substrate to be orthogonal to the crystal plane F associated in crystal growth initialization, the layer is formed.

Further, when placement of the concave portions 23 is the hexagonal side arrangement shown in FIG. 4, since regions enclosed by the concave portions 23 are arranged periodically at regular intervals, in-plane uniformity is enhanced, and flatness in crystal growth is improved. In the case where the flatness in crystal growth is improved, leakage current is decreased in obtained semiconductor light emitting devices, and therefore, such a case is preferable. The case where the region enclosed by the concave portions 23 is closest packing is more preferable.

(Substrate for semiconductor light emitting device)

The substrate for semiconductor light emitting device in the present invention is a substrate for semiconductor light emitting device to develop epitaxial growth of a semiconductor crystal on a main surface, and it is preferable to apply the above-mentioned optical substrate.

The substrate for semiconductor light emitting device according to this Embodiment has at least one or more main surfaces, and is a substrate to develop epitaxial growth of a semiconductor crystal on the first main surface, and the first main surface has a plurality of epitaxial growth promotion portions, and a plurality of epitaxial growth suppression portions to be comprised thereof.

FIG. 15 is a plan schematic diagram of the substrate for semiconductor light emitting device of this Embodiment. The substrate 100 for semiconductor light emitting device has epitaxial growth promotion portions 101 and epitaxial growth suppression portions 104 to enclose peripheries of the portions 101 to be comprised thereof. The epitaxial growth suppression portion 104 is comprised of a plurality of convex portions 102 periodically arranged by hexagonal closest packing placement with a period Pn. In FIG. 15, the convex portions 102 shown by the dotted lines undergo hexagonal closest packing placement, and constitute the epitaxial growth suppression portion 104. In addition, all regions of convex portions 102 shown in FIG. 15 correspond to the epitaxial growth suppression portions 104, and for convenience in description, only a part of the convex portions 102 are shown by the dotted lines. In addition, the manner is the same as in FIGs. 17, 22, 23, 24, 25, 26, and 27.

Further, the epitaxial growth promotion portion 101 is disposed in positions to constitute a two-dimensional hexagonal lattice 103 with six epitaxial growth promotion portions 101b, 101c, 101d, 101e, 101f, 101g with mutually equal distances Pe from a nearest-neighbor epitaxial growth promotion portion 101a, and the two-dimensional hexagonal lattice 103 is periodically disposed.

In addition, FIG. 15 illustrates the example where the epitaxial growth suppression portion 104 is comprised of a plurality of convex portions 102, but is not limited thereto, and the epitaxial growth suppression portion 104 may be comprised of a plurality of concave portions.

A form where the epitaxial growth promotion portion is comprised of a plurality of convex portions will be described below, and with respect to a form where the epitaxial growth promotion portion is comprised of a plurality of concave portions, it is possible to read with a form of composition where the convex portion is replaced with the concave portion in the following description.

In the substrate 100 for semiconductor light emitting device, as compared with the epitaxial growth promotion portion 101, it is preferable that a maximum gap portion 105 among convex portions 102 is sufficiently low in epitaxial growth, has an epitaxial growth rate equal to an oblique surface portion of the convex portion 102, and does substantially not cause epitaxial growth. The maximum gap portion 105 does preferably not have a plane parallel with the main surface of the substrate 100 for semiconductor light emitting device. Further, even in the case where the maximum gap portion 105 has the plane parallel with the main surface of the substrate 100 for semiconductor light emitting device, in each maximum gap portion 105, an area of the plane parallel with the main surface is preferably 0.05 $\mu m^2$ or less, more preferably 0.02 $\mu m^2$ or less, and further preferably 0.01 $\mu m^2$ or less, because the epitaxial growth rate from the plane portion is substantially equal to or less than the convex portion 102. It is possible to calculate the area of the plane parallel with the main surface of the maximum gap portion 105, for example, by measuring the cross-sectional shape and plane shape by an electron microscope and AFM (Atomic Force Microscope).

When the convex portions 102 constituting the epitaxial growth suppression portion 104 are periodically disposed with the period Pn, it is possible to further decrease the area of the maximum gap portion 105, and to make uniformly on the first main surface of the substrate 100 for semiconductor light emitting device, the effect of decreasing crystal

dislocation defects in epitaxial growth described later acts effectively, and therefore, such portions are preferable.

Since the epitaxial growth suppression portion 104 is comprised of the convex portions 102, also when the epitaxial growth promotion portion 101 exists between convex portions 102, a relative area of the epitaxial growth promotion portion 101 to the entire convex portions 102 occupied in the epitaxial growth suppression portion 104 is small, and it is thereby possible to hold the scattering effect with respect to LED emitted light by the convex portions 102. Further, when the inventor of the present invention studied, it is clarified that by periodical existence of the epitaxial growth suppression portions 104, the scattering effect is increased and that the LEE is increased, as compared with uniform existence of the convex portions 102 on the entire surface. Although the detailed principles are uncertain that the LEE is increased by existence of the epitaxial growth suppression portions 104, it is considered that new diffraction structure is generated by that the in-plane symmetry is regularly disturbed, rather than that only the convex portions 102 exist monotonically.

Further, it is possible to set the distance Pe between the epitaxial growth promotion portions optionally, without being dependent on the diameter of the convex portion 102, and therefore, while more keeping the scattering effect on the LED emitted light, it is possible to increase the effect of decreasing crystal dislocation defects described later.

Furthermore, the area of each of the epitaxial growth promotion portions 101 is preferably 0.1 $\mu m^2$ or more, more preferably 0.2 $\mu m^2$ or more, and most preferably 0.3 $\mu m^2$ or more. By this means, an epitaxial rate difference from the epitaxial growth suppression portion 104 is increased, and the crystal dislocation decreasing effect acts effectively. Further, the area of each of the epitaxial growth promotion portions 101 is preferably 10 $\mu m^2$ or less, more preferably 7 $\mu m^2$ or less, and most preferably 5 $\mu m^2$ or less. By this means, the crystal dislocation defect tends to turn in growth in the lateral direction in epitaxial growth described later.

FIG. 16 is a cross-sectional schematic diagram of the surface X-X in FIG. 15. The epitaxial growth promotion portions 101 have planes parallel with the main surface of the substrate 100 for semiconductor light emitting device, and for example, in the case of a sapphire substrate with C-plane as the main surface, the epitaxial growth promotion portions 101 are planes comprised of C-plane. Further, in FIG. 16, the epitaxial growth suppression portions 104 are comprised of a plurality of convex portions 102, and divide the epitaxial growth promotion portions 101 at equal intervals. The distance between the epitaxial growth promotion portions 101 in FIG. 16 is equal to a lattice constant Pe of the two-dimensional hexagonal lattice 103 in FIG. 15.

In the convex portions 102 constituting the epitaxial growth suppression portions 104, a diameter $\Phi 1$ of the bottom thereof is preferably 85% or more of the placement period Pn of the convex portions 102, further preferably 90% or more, more preferably 95% or more, and is preferably the period Pn or more because the gap between convex portions is decreased, and epitaxial growth from the gap between convex portions is inhibited. When the diameter $\Phi 1$ of the bottom of the convex portion 102 is the period Pn or more, the gap between convex portions 102 is eliminated, and the convex portion bottom portion is in the shape of a polygon.

FIG. 17 illustrates a state, with the same placement as in FIG. 15, in which bottom widths (maximum widths) $\Phi$ of a plurality of convex portions 202 constituting epitaxial growth suppression portions 204 are 115% of the period Pn, and a gap between convex portions 202 is eliminated. Further, an epitaxial growth promotion portion 201 is disposed in positions to constitute a two-dimensional hexagonal lattice 203 with six epitaxial growth promotion portions 201b, 201c, 201d, 201e, 201f, 201g with mutually equal distances Pe from a nearest-neighbor epitaxial growth promotion portion 201a, and the two-dimensional hexagonal lattice 203 is periodically disposed.

Further, in FIGs . 15 and 17, a ratio between the period Pn of the convex portions 102 (202) constituting the epitaxial growth suppression portions 104 (204) and the distance Pe between epitaxial growth promotion portions is 3.46. Further, in FIG. 15, an area ratio of the epitaxial growth promotion portions 101 to the first main surface is 0.076, and in FIG. 17, the area ratio of the epitaxial growth promotion portions 201 to the first main surface is 0.066.

In the substrate 100 (200) for semiconductor light emitting device of this Embodiment, by the above-mentioned epitaxial growth suppression portions 104 (204) and epitaxial growth promotion portions 101 (201), crystal dislocation defects are decreased inside the semiconductor layer formed on the substrate surface, and the crystal quality is thereby improved. Described next is the mechanism for decreasing crystal dislocation defects inside the semiconductor layer in the substrate for semiconductor light emitting device of this Embodiment.

FIG. 18 is a plan schematic diagram of a substrate 300 for semiconductor light emitting device with convex portions formed on the surface in conventional techniques. In the substrate 300 for semiconductor light emitting device in conventional techniques, convex portions 302 are formed on a main surface 301 at regular intervals. On the main surface 301 without the convex portion 302 being formed is exposed a substrate plane (for example, C-plane of the sapphire substrate) on which a semiconductor crystal layer to develop epitaxial growth on the substrate surface and the lattice plane are matched. Therefore, in the substrate 300 for semiconductor light emitting device, epitaxial growth promotion portions for enabling epitaxial growth of the semiconductor crystal layer are continuous on the entire surface among the convex portions 302, and are comprised of maximum gap portions 305 among the convex portions and valley portions 306 continued thereto.

When epitaxial growth is carried out on the substrate 300 for semiconductor light emitting device, nucleus

formation of epitaxial growth occurs from both the maximum gap portion 305 enclosed by the convex portions 302 and the valley portion 306. Then, it is possible to decrease crystal dislocation defects by the lateral direction growth mode described later.

Further, the convex portion 302 in the substrate 300 for semiconductor light emitting device also has the effect of scattering emitted light of the obtained LED to improve the light extraction efficiency. However, since the light extraction efficiency increases corresponding to the size (bottom diameter, convex height) of the convex portion 302, when the convex portion 302 is increased so as to obtain high light extraction efficiency, as described previously, the plane area of the valley portion 305 is too small, the crystal dislocation defect density is increased, and as a result, the luminous efficiency of the obtained LED is decreased. In other words, the trade-off relationship exists between improvement in the luminous efficiency by decrease in the crystal dislocation defect density and improvement in the luminous efficiency by increase in the light extraction efficiency, and it is not expected that the luminous efficiency is improved to some extent or more.

FIG. 19A, 19B and 19C contain cross-sectional projection schematic diagrams to explain a mechanism for decreasing crystal dislocation defects by the substrate for semiconductor light emitting device in conventional techniques. FIG. 19A, 19B and 19C contain projection schematic diagrams of section Y1-Y1 shown in FIG. 18.

When epitaxial growth is carried out on the substrate 300 for semiconductor light emitting device with the convex portions 302 formed, since the substrate plane (for example, C-plane of the sapphire substrate) exists where the gap portion 305 and valley portion 306 match with the lattice plane, nucleus growth occurs, epitaxial growth starts from the gap portion 305 and valley portion 306, and epitaxial layers 310a, 320a are formed (FIG. 19A). At this point, since the gap portion 305 has a large area of the substrate plane matched with the lattice plane, the epitaxial layer 310a grows largely.

Further, when epitaxial growth is carried out on the conditions of lateral direction growth mode, crystal dislocation defects 311b, 321b, which are generated in the epitaxial layers 310b, 320b based on the lattice mismatch, are turned in the lateral direction (FIG. 19B). Since the surface area of the epitaxial layer 310b is larger than that of the epitaxial layer 320b, diffusion and re-crystallization of the epitaxial layer occurs, the growth of the epitaxial layer 310b is faster, and the epitaxial layer 310b conforms to the epitaxial layer 320.

Furthermore, after developing the lateral direction growth, finally, the conditions are changed from the lateral direction growth to the vertical direction growth, and a flat epitaxial layer 310c is obtained (FIG. 19C). Thus, the epitaxial layer 320a growing from the valley portion 306 conforms to the epitaxial layer 310a, crystal dislocation defects 311c are collected immediately above the valley portion 306, and a part of dislocation defects disappear. As a result, the dislocation defects 311c inside the epitaxial layer 310c are decreased, the defect immediately above the valley portion 306 has little room for the lateral direction growth described above, and therefore, the effect of decreasing crystal dislocations is little. As a result, crystal dislocation defects concentrate on the region of the valley portion 306 between the convex portions 302, and the lattice defects 311c of the valley portion 306 between the convex portions are decreased hardly.

In such a crystal dislocation decreasing mechanism, in order to further decrease crystal dislocation defects, it is effective to decrease the plane areas of the gap portion 305 and valley portion 306. However, when the plane areas are decreased to some extent or less, the epitaxial growth rate in the semiconductor crystal layer is too slow and is equal to the growth rate in the convex portion 302, and contrary, there is the problem that the crystal dislocation defects are increased.

Next, referring to FIG. 20A, 20B and 20C illustrating the projection schematic diagram of the section X-X in FIG. 15, described is a mechanism for suppressing crystal dislocation defects in the substrate 100 for semiconductor light emitting device of this Embodiment. In addition, the convex portions 102 shown by the oblique lines in FIG. 20A, 20B and 20C are the convex portions on the line X-X, and convex portions on its opposite sides are not convex portions on the line X-X, and represent convex portions positioned at the back of the line X-X.

When epitaxial growth is carried out on the substrate 100 for semiconductor light emitting device of this Embodiment, since the substrate plane (for example, C-plane of the sapphire substrate) exists where the epitaxial growth promotion portion 101 matches with the lattice plane, nucleus growth occurs herein, epitaxial growth starts from the epitaxial growth promotion portion 101, and an epitaxial layer 110a is generated (FIG. 20A).

In the epitaxial growth suppression portion 104, since the convex portions 102 are disposed densely, and the epitaxial growth rate of the maximum gap portion 105 (see FIG. 15) between convex portions 102 is almost equal to the epitaxial growth rate in the oblique surface portion of the convex portion 102, epitaxial growth does substantially not occur. Therefore, the crystal lattice defect between the convex portions as shown in FIG. 5 does not remain after epitaxial growth.

When the lateral direction growth mode further proceeds, crystal dislocation defects 111b based on the lattice mismatch are turned in the lateral direction (FIG. 20B), and epitaxial layers 110b growing from different epitaxial growth promotion portions 101 conform to one another. Then, the conditions are changed from the lateral direction growth to the vertical direction growth, and a flat epitaxial layer 110c is obtained (FIG. 20C).

In the substrate 100 for semiconductor light emitting device of this Embodiment, the epitaxial growth promotion

portion 101 and the epitaxial growth suppression portion 104 are divided clearly, and since all epitaxial layers 110a growing from the epitaxial growth promotion portions 101 have sufficient space to grow laterally, the crystal dislocation decreasing effect works effectively, by collisions of crystal dislocation defects 111c (see FIG. 20C) due to the lateral direction growth.

Further, in the substrate 100 for semiconductor light emitting device of this Embodiment, the area of the convex portion 102 is determined to maximize its bottom width Φ. Therefore, it is possible to maximize the scattering effect on the emitted light of the LED by the convex portion 102. Furthermore, it is possible to provide the epitaxial growth promotion portions 101, in an area ratio not to decrease the scattering effect on the emitted light of the LED, on the first main surface of the substrate 100 for semiconductor light emitting device, and the area ratio of the epitaxial growth promotion portions 101 to the first main surface is preferably in a range of 0.001 to 0.2. When the area ratio of the epitaxial growth promotion portions 101 to the first main surface falls below 0.001, it takes time for growth of the epitaxial layer provided on the substrate 100 for semiconductor light emitting device, and therefore, such ratios are not preferable in terms of industrial production. Further, the area ratio is preferably 0.002 or more, and more preferably 0.005 or more, because the effect on LED production given by the epitaxial growth rate is less in terms of industrial production.

Furthermore, when the area ratio of the epitaxial growth promotion portions 101 to the first main surface exceeds 0.3, the effect of decreasing crystal dislocation defects described previously is decreased, and therefore, such ratios are not preferable. The ratio is preferably 0.20 or less, and more preferably 0.15 or less, because the effect of decreasing crystal dislocation defects works sufficiently, and concurrently, the scattering effect on the emitted light also works more effectively. The ratio is particularly preferably 0.10 or less.

Still furthermore, as shown in FIG. 21, in a substrate 400 for semiconductor light emitting device of this Embodiment, epitaxial growth promotion portions 401 may be concave portions having planes parallel with the main surface of the substrate 400 for semiconductor light emitting device. Further, reference numerals "404" shown in FIG. 21 denote epitaxial growth suppression portions. Herein, the concave portion is a state of being dented in the other main surface direction opposite to the first main surface from the plane connecting between valley portions of the convex portions 402, and the bottom width of the concave portion is preferably 10 nm or more. Furthermore, the bottom width of the concave portion is more preferably 50 nm or more, and further preferably 100 nm or more, because the scattering effect on the emitted light of the obtained LED is more enhanced. Still furthermore, although an upper limit to the depth of the concave portion is not particularly limited, the concave portion bottom needs to have the plane parallel with the main surface of the substrate 400 for semiconductor light emitting device, and since the area is preferably 0.1 $\mu m^2$ or more, the portion is designed and selected as appropriate so that the plane of the concave portion bottom is this value or more. When the area of the concave portion bottom falls below 0.1 $\mu m^2$, the growth rate of the epitaxial layer from the epitaxial growth promotion portion 401 is slow, the crystal dislocation decreasing effect described previously does not work sufficiently, and therefore, such areas are not preferable.

As shown in FIGs. 15 and 17, in the substrate 100 (200) for semiconductor light emitting device of this Embodiment, distances Pe among nearest-neighbor epitaxial growth promotion portions in the epitaxial growth promotion portions 101 (201) are preferably mutually equal. When the distances Pe among nearest-neighbor epitaxial growth promotion portions are mutually equal, the effect of decreasing crystal dislocation defects due to the lateral direction growth occurs evenly in the epitaxial growth process, the crystal quality is made uniform, and therefore, such distances are preferable. When fluctuations occur in the crystal dislocation defect, leakage current is increased in the light emitting layer of the obtained LED, and energy efficiency of the entire LED is decreased.

By the same reason, it is preferable that the distance Pe between epitaxial growth promotion portions is uniformly disposed at regular intervals inside the plane of the first main surface of the substrate for semiconductor light emitting device of this Embodiment. In the case where the distance Pe is uniformly disposed at regular intervals inside the plane, the effect of decreasing crystal dislocation defects is uniform inside the plane, the crystal quality is uniform inside the plane, it is thereby possible to suppress decrease in luminous efficiency of the LED, and therefore, such a case is preferable.

Further, in the substrate for semiconductor light emitting device of the present invention, the substrate is preferably a single crystal substrate having a crystal structure of hexagonal system, and it is preferable that the nearest-neighbor direction of a plurality of nearest-neighbor epitaxial growth suppression portions described above is not parallel with an m-plane of the crystal structure of the substrate for semiconductor light emitting device. As shown in FIG. 17, it is preferable that the vector direction of Pn indicative of the distance between epitaxial growth suppression portions is not parallel with the m-plane of hexagonal system constituting the substrate for semiconductor light emitting device, and that specifically, a deviation of the vector direction of Pn from the m-plane of hexagonal system exceeds 0 degree and is less than 30 degrees.

In the case where the nearest-neighbor direction of epitaxial growth suppression portions deviates from the m-plane of the substrate crystal, growth of the epitaxial layer growing from the epitaxial growth promotion portion is fast, and therefore, such a case is preferable. This is because the epitaxial crystal growing from the epitaxial growth promotion portion is also a hexagonal crystal in the case where the substrate is the hexagonal system. When the nearest-neighbor

direction of epitaxial growth suppression portions is parallel with the m-plane of the substrate crystal, the epitaxial growth suppression portion exists in a position facing the growth direction of the epitaxial crystal growing from the epitaxial growth promotion portion, and growth of the entire epitaxial crystal is inhibited.

In this Embodiment, when the nearest-neighbor direction of epitaxial growth promotion portions is not parallel with the m-plane of the substrate crystal, the above-mentioned growth of the epitaxial crystal is hard to inhibit, epitaxial growth is promoted, and therefore, the Embodiment is preferable in industrial use. Further, an inhibition factor of epitaxial growth in some particular direction is resolved, surface smoothness is improved in the obtained epitaxial film, and therefore, the Embodiment is preferable.

In the substrate for semiconductor light emitting device of this Embodiment, the distance Pe between nearest-neighbor epitaxial growth promotion portions and the period Pn of convex portions or concave portions constituting the epitaxial growth suppression portions preferably meet the following equation (1).

$$1.5 \leq Pe/Pn \leq 30 \quad \text{Equation (1)}$$

When the ratio between Pe and Pn is within the range of Eq. (1), the effect of decreasing crystal dislocation defects works sufficiently, the light scattering effect on the emitted light of the obtained LED functions effectively, and therefore, such ratios are preferable.

When Pe/Pn falls down 1.5, the distance between epitaxial growth promotion portions is too close, growth space is decreased in lateral direction growth in epitaxial growth, and therefore, such ratios are not preferable. Further, when Pe/Pn exceeds 30, in the lateral direction growth of the epitaxial growth promotion portion, the number of convex portions is high in the epitaxial growth suppression portion to climb, it is hard to obtain a flat epitaxial growth layer at the finish of epitaxial growth, and therefore, such ratios are not preferable. Furthermore, when Pe/Pn exceeds 30, it is hard to flatten the top surface of the epitaxial growth layer at the finish of epitaxial growth, leakage current is thereby increased in emission of the obtained LED, and the luminous efficiency of the LED is decreased. Accordingly, Pe/Pn is preferably 30 or less.

Pe/Pn is preferably 2 or more, because the crystal dislocation defects are decreased by growth space of the distance between epitaxial growth promotion portions, and is more preferably 3.4 or more. Further, Pe/Pn is preferably 25 or less, and more preferably 21 or less, because it is easy to obtain a flat epitaxial layer.

Particularly, when Pe/Pn is in a range of 2 to 4, the effect of decreasing crystal dislocation defects works sufficiently due to the epitaxial lateral direction growth, it is made easy to obtain a flat epitaxial layer on the entire plane of the sapphire substrate with a large diameter of 4 inches or more, and such a range is the most preferable in terms of industrial production.

FIG. 22 is a plan schematic diagram of a substrate for semiconductor light emitting device of another Embodiment. The substrate 500 for semiconductor light emitting device is comprised of epitaxial growth promotion portions 501 and epitaxial growth suppression portions 504 to enclose peripheries of the portions 501, and the epitaxial growth suppression portion 504 is comprised of a plurality of convex portions 502 periodically arranged by hexagonal closest packing placement with a period Pn. Further, the epitaxial growth promotion portion 501 is disposed in positions to constitute a two-dimensional hexagonal lattice 503 with six epitaxial growth promotion portions 501b, 501c, 501d, 501e, 501f, 501g with mutually equal distances Pe from a nearest-neighbor epitaxial growth promotion portion 501a, and the two-dimensional hexagonal lattice 503 is periodically disposed.

Further, in FIG. 22, as shown in FIG. 17, bottomwidths Φ of a plurality of convex portions 502 constituting the epitaxial growth suppression portion 504 are 115% of the period Pn, resulting in a state in which the gap between convex portions 502 is eliminated.

Furthermore, in FIG. 22, a ratio between the period Pn of the convex portions 502 constituting the epitaxial growth suppression portions 503 and the distance Pe between epitaxial growth promotion portions is 3.0. Still furthermore, an area ratio of the epitaxial growth promotion portions 501 to the first main surface is 0.088.

FIG. 23 is a plan schematic diagram of a substrate for semiconductor light emitting device of still another Embodiment. The substrate 600 for semiconductor light emitting device has the same configuration as in FIG. 22, and is comprised of epitaxial growth promotion portions 601 and epitaxial growth suppression portions 604 comprised convex portions 602. Further, the epitaxial growth promotion portion 601 is disposed in positions to constitute a two-dimensional hexagonal lattice 603 with six epitaxial growth promotion portions 601b, 601c, 601d, 601e, 601f, 601g with mutually equal distances Pe from a nearest-neighbor epitaxial growth promotion portion 601a, and the two-dimensional hexagonal lattice 603 is periodically disposed. In FIG. 23, a ratio between the period Pn of the convex portions 602 and the distance Pe between epitaxial growth promotion portions is 4.0. Further, an area ratio of the epitaxial growth promotion portions 601 to the first main surface is 0.049.

FIG. 24 is a plan schematic diagram of a substrate for semiconductor light emitting device of still another

Embodiment. The substrate 650 for semiconductor light emitting device is comprised of epitaxial growth promotion portions 651 and epitaxial growth suppression portions 654 comprised convex portions 652. Further, the epitaxial growth promotion portion 651 is disposed in positions to constitute a two-dimensional hexagonal lattice 653 with six epitaxial growth promotion portions 651b, 651c, 651d, 651e, 651f, 651g with mutually equal distances Pe from a nearest-neighbor epitaxial growth promotion portion 651a, and the two-dimensional hexagonal lattice 653 is periodically disposed. In FIG. 24, a ratio between the period Pn of the convex portions 652 and the distance Pe between epitaxial growth promotion portions is 2.0. Further, an area ratio of the epitaxial growth promotion portions 651 to the first main surface is 0.200.

FIG. 25 is a plan schematic diagram of a substrate for semiconductor light emitting device of still another Embodiment. The substrate 700 for semiconductor light emitting device is comprised of epitaxial growth promotion portions 701 and epitaxial growth suppression portions 704 to enclose peripheries of the portions 701, and the epitaxial growth suppression portion 704 is comprised of a plurality of convex portions 702 periodically arranged with a period Pn. Further, the epitaxial growth promotion portion 701 is disposed in positions to constitute a two-dimensional hexagonal lattice 703 with three epitaxial growth promotion portions 701b, 701c, 701d with mutually equal distances Pe from a nearest-neighbor epitaxial growth promotion portion 701a, and the two-dimensional hexagonal lattice 703 is periodically disposed. Also in FIG. 25, as in FIG. 17, bottom widths Φ of a plurality of convex portions 702 constituting the epitaxial growth suppression portions 704 are 115% of the period Pn, resulting in a structure where any plane portion does not exist between convex portions 702. In FIG. 25, a ratio between the period Pn of the convex portions 702 and the distance Pe between epitaxial growth promotion portions is 2.0, and an area ratio of the epitaxial growth promotion portions 701 to the first main surface is 0.138.

FIG. 26 is a plan schematic diagram of a substrate for semiconductor light emitting device of still another Embodiment. The substrate 800 for semiconductor light emitting device is comprised of band-shaped epitaxial growth promotion portions 801 and band-shaped epitaxial growth suppression portions 804 to enclose peripheries of the portions 801, and the epitaxial growth suppression portion 804 is comprised of a plurality of convex portions 802 periodically arranged in trigonal lattices with a period Pn. Further, the epitaxial growth promotion portion 801 is disposed repeatedly on the first main surface with a distance Pe from a nearest-neighbor epitaxial growth promotion portion. In the substrate 800 for semiconductor light emitting device, in the vertical direction on the figure not shown, placement is similarly repeated in the in-plane direction of the first main surface, resulting in placement where the epitaxial growth promotion portion 801 is substantially sandwiched between the epitaxial growth suppression portions 804.

Further, also in FIG. 26, as in FIG. 17, bottom widths Φ of a plurality of convex portions 802 constituting the epitaxial growth suppression portions 804 are 115% of the period Pn, resulting in a structure where any plane portion does not exist between convex portions 802. In FIG. 26, a ratio between the distance Pe between epitaxial growth promotion portions and the period Pn of the convex portions 802 is 5.2, and an area ratio of the epitaxial growth promotion portions 801 to the first main surface is 0.14.

FIG. 27 is a plan schematic diagram of a substrate for semiconductor light emitting device of still another Embodiment. The substrate 900 for semiconductor light emitting device is comprised of band-shaped epitaxial growth promotion portions 901 and band-shaped epitaxial growth suppression portions 904 to enclose peripheries of the portions 901, and the epitaxial growth suppression portion 904 is comprised of a plurality of convex portions 902 periodically arranged in square lattices with a period Pn. Further, the epitaxial growth promotion portion 901 is disposed repeatedly on the first main surface with a distance Pe from a nearest-neighbor epitaxial growth promotion portion. In the substrate 900 for semiconductor light emitting device, in the vertical direction on the figure not shown, placement is similarly repeated in the in-plane direction of the first main surface, resulting in placement where the epitaxial growth promotion portion 901 is substantially sandwiched between the epitaxial growth suppression portions 904.

Further, in FIG. 27, bottom widths Φ of a plurality of convex portions 902 constituting the epitaxial growth suppression portions 904 are 141% of the period Pn, resulting in a structure where any plane portion does not exist between convex portions 902. In FIG. 27, a ratio between the distance Pe between epitaxial growth promotion portions and the period Pn of the convex portions 902 is 6.0, and an area ratio of the epitaxial growth promotion portions 901 to the first main surface is 0.17.

FIG. 28 is a plan schematic diagram of a substrate for semiconductor light emitting device of still another Embodiment. The substrate 1000 for semiconductor light emitting device is comprised of epitaxial growth promotion portions 1001 and epitaxial growth suppression portions 1004 to enclose peripheries of the portions 1001, and the epitaxial growth suppression portion 1004 is comprised of a plurality of convex portions 1002 periodically arranged with a period Pn. Further, the epitaxial growth promotion portion 1001 is disposed in positions to constitute a two-dimensional hexagonal lattice 1003 with three epitaxial growth promotion portions 1001b, 1001c, 1001d with mutually equal distances Pe from a nearest-neighbor epitaxial growth promotion portion 1001a, and the two-dimensional hexagonal lattice 1003 is periodically disposed. In FIG. 28, bottom widths Φ of a plurality of convex portions 1002 constituting the epitaxial growth suppression portions 1004 are 100% of the period Pn. In FIG. 28, a ratio between the period Pn of the convex portions 1002 and the distance Pe between epitaxial growth promotion portions is 1.73, and an area ratio of the epitaxial growth promotion portions 1001 to the first main surface is 0.295.

FIG. 29 is a plan schematic diagram of a substrate for semiconductor light emitting device of still another Embodiment. The substrate 1100 for semiconductor light emitting device is comprised of epitaxial growth promotion portions 1101, epitaxial growth suppression portions 1104 to enclose peripheries of the portions 1101, epitaxial growth coupling portions 1105 existing among adjacent epitaxial growth promotion portions 1101, and epitaxial growth suppression portions 1106 in regions except the above-mentioned region, and the epitaxial growth suppression portions 1104 and 1106 are comprised of a plurality of convex portions 1102 periodically arranged with a period Pn.

The epitaxial growth promotion portion 1101 is disposed in positions to constitute a two-dimensional hexagonal lattice 1103 with six epitaxial growth promotion portions 1101b, 1101c, 1101d, 1101e, 1101f, 1101g with mutually equal distances Pe from a nearest-neighbor epitaxial growth promotion portion 1101a, and the two-dimensional hexagonal lattice 1103 is periodically disposed.

Further, the epitaxial growth coupling portion 1105 exists between the nearest-neighbor epitaxial growth promotion portions, and is comprised of convex portions 1107 smaller than the convex portion 1102 in bottoms Φ of the convex portions 1102 periodically arranged with the period Pn.

In FIG. 29, a ratio between the period Pn of the convex portions 1102 and the distance Pe between epitaxial growth promotion portions is 3.46. Further, an area ratio of the epitaxial growth promotion portions 1101 to the first main surface is 0.076.

In the convex portion 1107 in the epitaxial growth coupling portion 1105 in this Embodiment, since the bottom width Φ is smaller than that of the convex portion 1102 constituting the epitaxial growth suppression portion 1104, an area is large where the substrate plane that is an epitaxial growth plane is exposed. Therefore, an epitaxial growth rate of the epitaxial growth coupling portion 1105 is higher than in the epitaxial growth suppression portions 1104 and 1106. Further, on the other hand, since the area where the substrate plane that is the epitaxial growth plane is exposed is smaller than in the epitaxial growth promotion portion 1101, the epitaxial growth rate is lower than in the epitaxial growth promotion portion 1101. In other words, the portion 1105 has the epitaxial growth rate in between the epitaxial growth suppression portion and the epitaxial growth promotion portion.

Since the epitaxial growth coupling portion 1105 exists between the nearest-neighbor epitaxial growth promotion portions 1101, coupling of epitaxial crystals growing from the epitaxial growth promotion portions 1101 are promoted, and it is made easy to obtain an epitaxial film with a uniform thickness inside the wafer plane, being preferable.

In this Embodiment, as described previously, the epitaxial growth promotion portion 1101 and epitaxial growth suppression portions 1104 and 1106 are provided inside the wafer plane, a difference in the epitaxial growth rate is thereby generated inside the wafer plane, and the effect is produced to improve crystallinity of the obtained epitaxial film. However, on the other hand, filmthickness ununiformity of the epitaxial film tends to occur inside the wafer plane. Therefore, by providing the epitaxial growth coupling portion 1105 between the epitaxial growth promotion portions 1101, it is possible to improve film thickness uniformity inside the wafer plane.

A mechanism for enabling film thickness ununiformity to be suppressed by existence of the epitaxial growth coupling portion 1105 between the epitaxial growth promotion portions 1101 is uncertain, but is considered as described below.

The epitaxial growth undergoes the process in which epitaxial crystals formed on the substrate plane grow largely as needed, and are coupled to one another to be the epitaxial film. In this process, since the epitaxial growth is a chemical reaction, the epitaxial crystal with a large surface area is higher in the growth rate than a crystal with a small surface area, and preferentially grows to be large. In other words, the slight size of the crystal in crystal formation initialization is amplified, as the epitaxial crystal grows. As a result, fluctuations occur in the size of the epitaxial crystal, and the film thickness tends to be nonuniform in the epitaxial film obtained by coupling of crystals.

Herein, the epitaxial growth coupling portion 1105 is provided between the epitaxial growth promotion portions 1101, coupling of crystals growing from the epitaxial growth promotion portions 1101 is promoted in crystal formation initialization, a single large epitaxial crystal is made, and it is possible to suppress the above-mentioned fluctuations in the slight size of the crystal in crystal formation initialization. As a result, it is possible to suppress film thickness ununiformity inside the wafer plane.

Since the epitaxial growth rate of the epitaxial growth coupling portion 1105 is lower than in the epitaxial growth promotion portion, the mechanism works to suppress crystal dislocation defects based on the difference in the epitaxial growth rate described previously, and the effect of improving crystallinity of the obtained epitaxial crystal film is not impaired.

The convex portion 1107 of the epitaxial growth coupling portion 1105 needs to have the bottom width Φ smaller than in the convex portions 1102 constituting the epitaxial growth suppression portions 1104 and 1106, and the bottom width is preferably 90% or less of the bottom width Φ of the convex portions 1102 constituting the epitaxial growth suppression portions 1104 and 1106, more preferably 80% or less, and preferably 60% or less, because coupling to the epitaxial growth promotion portion tends to occur. Further, in the case where the bottom width Φ is small, the difference from the epitaxial growth promotion portion 1101 is small, the effect is decreased to suppress crystal dislocation defects based on the difference in the epitaxial growth rate described previously, and therefore, the case is not preferable. The

bottom width is preferably 10% or more of the bottom width Φ of the convex portions 1102 constituting the epitaxial growth suppression portions 1104 and 1106, more preferably 20% or more, and preferably 40% or more, because of not impairing the effect of suppressing crystal dislocation defects due to the epitaxial growth promotion portion 1101.

FIG. 30 is a plan schematic diagram of a substrate for semiconductor light emitting device of still another Embodiment. The substrate 1200 for semiconductor light emitting device is comprised of epitaxial growth promotion portions 1201, epitaxial growth suppression portions 1204 to enclose peripheries of the portions 1201, epitaxial growth coupling portions 1205 existing among adjacent epitaxial growth promotion portions 1101, and epitaxial growth suppression portions 1206 in regions except the above-mentioned region, and the epitaxial growth suppression portions 1204 and 1206 are comprised of a plurality of convex portions 1202 periodically arranged with a period Pn.

The epitaxial growth promotion portion 1201 is disposed in positions to constitute a two-dimensional hexagonal lattice 1203 with six epitaxial growth promotion portions 1201b, 1201c, 1201d, 1201e, 1201f, 1201g with mutually equal distances Pe from a nearest-neighbor epitaxial growth promotion portion 1201a, and the two-dimensional hexagonal lattice 1203 is periodically disposed.

Further, the epitaxial growth coupling portion 1205 exists between the nearest-neighbor epitaxial growth promotion portions 1201, and is comprised of convex portions 1207 with a bottom width Φ smaller than in the convex portion 1202 periodically arranged with the period Pn.

In FIG. 30, a ratio between the period Pn of the convex portions 1202 and the distance Pe between epitaxial growth promotion portions is 3.46. Further, an area ratio of the epitaxial growth promotion portions 1201 to the first main surface is 0.076.

Described next are substrates for semiconductor light emitting device according to Embodiment 2 of the present invention. FIG. 31A is a plan schematic diagram of a substrate for semiconductor light emitting device according to Embodiment 2 of the invention. The substrate 1300 for semiconductor light emitting device is comprised of epitaxial growth suppression portions 1304 and epitaxial growth promotion portions 1301 to enclose peripheries of the portions 1304, and the epitaxial growth suppression portion 1304 is comprised of a plurality of convex portions 1302 periodically arranged with a period Pn.

Inside the region of the epitaxial growth promotion portions 1301, the substrate has convex portions 1307 with a bottom width Φ smaller than in the convex portions 1302 constituting the epitaxial growth suppression portions 1304.

Since the substrate has the convex portions 1307 inside the epitaxial growth promotion portions 1301, also inside the epitaxial growth promotion portions 1301, a difference in the epitaxial crystal growth rate partially occurs, and the above-mentioned effect of suppressing crystal dislocationdefects is developed. Further, in the epitaxial growth suppression portion 1304, as in the Embodiment described previously, there is the difference in the crystal growth rate between the portion 1304 and the epitaxial growth promotion portions 1301, crystal dislocation defects are thereby suppressed, and the crystal quality is improved in the obtained epitaxial film.

Further, since the epitaxial growth promotion portions 1301 are contiguous with the convex portions 1307 therebewteen, it is possible to suppress ununiformity of the epitaxial film thickness inside the wafer plane, caused by fluctuations in size of each crystal in epitaxial growth initialization.

An area ratio of the epitaxial growth suppression portions 1304 to the first main surface preferably ranges from 0.8 to 0.999. When the area ratio of the epitaxial growth suppression portions 1304 to the first main surface falls below 0.7, the effect of decreasing crystal dislocation defects described previously is decreased, and therefore, such ratios are not preferable. The ratio is preferably 0.80 or more, preferably 0.85 or more because the effect of decreasing crystal dislocation defects works sufficiently, and concurrently, the scattering effect on the emitted light also works more effectively, and particularly preferably 0.90 or more.

Further, when the area ratio of the epitaxial growth suppression portions 1304 to the first main surface exceeds 0.999, it takes time for growth of the epitaxial film on the substrate 1301 for semi conduct or light emitting device, and therefore, such ratios are not preferable in terms of industrial production. Furthermore, the area ratio is preferably 0.998 or less, and more preferably 0.995 or less, because the effect on LED production by the epitaxial growth rate is less in terms of industrial production.

In FIG. 31A, the area ratio of the epitaxial growth promotion portions 1301 to the first main surface is 0.705.

In addition, a form may be made where the epitaxial growth suppression portion 1304 are sandwiched between the epitaxial growth promotion portions 1301.

Further, in the case where the epitaxial growth suppression portions are enclosed by contiguous epitaxial growth promotion portions shown in FIG. 4, as shown in FIG. 31B, it is also preferable that the width of the epitaxial growth promotion portion is wider than the convex portion pitch Pe of the epitaxial growth suppression portion. In the placement as shown in FIG. 31B, since it is possible to increase the area ratio of the epitaxial growth suppression portions to the first main surface, the above-mentioned effect of decreasing crystal dislocation defects works sufficiently, concurrently the scattering effect on the emitted light also works more effectively, and therefore, the placement is preferable.

In FIG. 31B, peripheries of the epitaxial growth suppression portions are enclosed by the epitaxial growth promotion portions. The epitaxial growth promotion portion has at least a convex portion with the bottom shape of a

hexagon at its center, the periphery is enclosed by convex portions similarly with the bottom shape of a hexagon, and further, the periphery is enclosed by convex portions where the bottom shape of the outer region portion is an arc and the bottom shape of the inner region portion is a hexagon. The epitaxial growth suppression portion is the hexagon in the direction in which the bottom hexagon of the convex portion at its center is rotated 90 degrees.

In FIG. 31B, the width of the epitaxial growth promotion portion is preferably 20% or more of the convex portion pitch Pe of the epitaxial growth suppression portion, more preferably 30% or more, and preferably 35% or more, because the crystal decreasing effect works effectively. Further, the width is 200% or less of the convex portion pitch Pe, preferably 150% or less, and preferably 130% or less because the LEE improving effect works.

Alternatively, in FIG. 31B, the width of the bottom portion of the epitaxial growth promotion portion is preferably 100 nm or more, more preferably 200 nm or more, and further preferably 300 nm or more, because flatness in crystal growth is improved. Further, the width of the bottom portion of the epitaxial growth promotion portion is preferably 1000 nm or less, more preferably 800 nm or less, and further preferably 600 nm or less, because it is possible to increase the area ratio of the epitaxial growth suppression portions to the first main surface, the effect of decreasing crystal dislocation defects works sufficiently as described previously, and concurrently, the scattering effect on the emitted light also works more effectively.

Further, in the substrate for semiconductor light emitting device of this Embodiment, as long as the period Pn of the convex portions 1302 constituting the epitaxial growth suppression portions 1304 is the same, it is not necessary to configure the entire wafer surface in the plan schematic diagram illustrated previously, and as shown in FIG. 32, composition may be made where placement of the epitaxial growth promotion portion is mixed.

With respect to the repetition length of a region A where the composition of the epitaxial growth suppression portion is the same, when the length is 0.5 time or more a coherence length of a wavelength of emitted light of the semiconductor light emitting device to use, the scattering effect of each region is effectively exerted, and therefore, such lengths are preferable. The length is further preferably 1 time or more the coherence length of the emitted light, and preferably 1.5 times or more, because the light extraction efficiency is improved by the scattering effect.

Herein, assuming that a center wavelength of light is $\lambda$, and that a half-width of the light is $\Delta\lambda$, the coherence length Lc is defined as $Lc=(\lambda 2/\Delta\lambda)$.

In the substrate for semiconductor light emitting device of this Embodiment, as shapes of the convex portion and concave portion constituting the epitaxial growth suppression portion, as long as the shapes are in the scope of obtaining the effects of the present invention, the shapes are not limited particularly, and are capable of being modified as appropriate corresponding to use. As the shapes of the convex portion and concave portion, for example, it is possible to use the shape of a pillar or the shape of a hole, the shape of a cone, the shape of a pyramid, the shape of an elliptic cone and the like, and from the viewpoint of suppressing epitaxial growth, it is preferable that the surface of each of the convex portion and the concave portion does not have a plane parallel with the substrate plane portion.

As another Embodiment of the substrate for semiconductor light emitting device of the present invention, it is preferable that the epitaxial growth promotion portions and epitaxial growth suppression portions disposed on the first main surface concurrently meet the following requirements A to C.

A. Peripheries of a scattered plurality of the epitaxial growth promotion portions are enclosed by the epitaxial growth suppression portions; peripheries of a plurality of the epitaxial growth suppression portions are enclosed by the epitaxial growth promotion portions, or the epitaxial growth suppression portions are sandwiched between the epitaxial growth promotion portions;
B. arithmetic average roughness Ra with respect to the epitaxial growth suppression portion is 5 nm or less; and
C. arithmetic average roughness Ra with respect to the epitaxial growth promotion portion is 1.5 nm or less.

The arithmetic average roughness with respect to the epitaxial growth suppression portions is sufficiently large, as compared with the roughness Ra with respect to the epitaxial growth promotion portions. From the relationship, the epitaxial growth promotion portion functions as a starting point of crystal growth. This is because a difference in the lattice constant between the semiconductor layer and the growth substrate is smaller in the case of the epitaxial growth promotion portion than in the epitaxial growth suppression portion. Accordingly, epitaxial growth starts preferentially from the epitaxial growth promotion portion. Herein, the epitaxial growth promotion portions are provided to be scattered in the region of the epitaxial growth suppression portion, to enclose the periphery of the epitaxial growth suppression portion, or to sandwich the epitaxial growth suppression portion. Therefore, epitaxial lateral direction growth is made to cross the epitaxial growth suppression portion. By this means, association of crystals occurs on the epitaxial growth suppression portion. Accordingly, dislocation defects are decreased, and the IQE is improved. At this point, in the epitaxial growth promotion portion that is the starting point of crystal growth, the arithmetic average roughness is 1.5 nm or less. By this means, epitaxial film formation is stable film formation from its initial state. Accordingly, it is possible to actualize stable epitaxial film formation capable of enduring also the LED manufacturing process. On the other hand, in the epitaxial growth suppression portion, the arithmetic average roughness Ra is large. Concurrently, the epitaxial growth promotion

portions are provided on peripheries thereof. In other words, it is possible to regard as a state in which the region with large roughness is scattered. Accordingly, optical scattering properties are developed strongly, the waveguide mode is broken, and the LEE is improved.

FIG. 33A, 33B and 33C contain plan schematic diagrams of epitaxial growth promotion portions and epitaxial growth suppression portions formed on the growth substrate in the Embodiment of the present invention.

As shown in FIG. 33A, 33B and 33C, epitaxial growth promotion portions 101 and epitaxial growth suppression portions 104 are formed on a first main surface 100a of a growth substrate (substrate for semiconductor light emitting device) 100. The epitaxial growth promotion portions 101 and epitaxial growth suppression portions 104 are provided with one of the following states A-1, A-2 and A-3.

State A-1: Peripheries of a plurality of scattered epitaxial growth promotion portions 101 are enclosed by the epitaxial growth suppression portion 104;

State A-2: peripheries of a plurality of epitaxial growth suppression portions 104 are enclosed by the epitaxial growth promotion portion 101; and

State A-3: the epitaxial growth suppression portion 104 is sandwiched between the epitaxial growth promotion portions 101.

FIG. 33A illustrates the state A-1, FIG. 33B illustrates the state A-2, and FIG. 33C illustrates the state A-3. In FIG. 33A, it is considered that the epitaxial growth promotion portions 101 are disposed in lattice points (shown by the dotted lines) of a regular trigonal lattice. In FIG. 33B, it is considered that the epitaxial growth promotion portion 101 is disposed in lattice points and sides of closest packed lattices that regular hexagons mutually share only the sides (shown by the dotted lines) . In the case of FIG. 33C, it is considered that the epitaxial growth promotion portions 101 are arranged in the shape of mutually parallel lines and space. The arrangements and shapes of the epitaxial growth promotion portion 101 and epitaxial growth suppression portion 104 will be described later.

Further, the epitaxial growth suppression portion 104 meets the above-mentioned requirement B, and the epitaxial growth promotion portion 101 meets the above-mentioned requirement C. In other words, the arithmetic average roughness Ra with respect to the epitaxial growth suppression portion 104 is 5 nm or less, and the arithmetic average roughness Ra with respect to the epitaxial growth promotion portion 101 is 1.5 nm or less.

FIG. 34A illustrates a region to measure the arithmetic average roughness Ra with respect to the epitaxial growth promotion portion 101 in the state (state A-1) where the epitaxial growth promotion portions 101 are scattered. As shown in FIG. 34A, a region A1 to measure the arithmetic average roughness Ra is determined to be a square having an area of 50% to 60% of an area of a circle S0 in contact with the epitaxial growth suppression portion 104, inside the epitaxial growth promotion portion 101. In addition, the center of the circle S0 and the center of the square are matched with each other. Then, using an atomic force microscope (AFM) in the square region A1, the arithmetic average roughness Ra is measured in dimension of nm. Measurement is performed on 10 points arbitrarily in the region A1, and an arithmetic mean value of the obtained values is determined as the arithmetic average roughness Ra.

Further, FIG. 34B illustrates regions to measure the arithmetic average roughness Ra with respect to the epitaxial growth promotion portion 101, in the state (state A-2) where the epitaxial growth promotion portion 101 surrounds the epitaxial growth suppression portions 104. A circle S1 in contact with the epitaxial growth suppression portions 104 is set inside the epitaxial growth promotion portion 101, and a square having an area of 50% to 60% of an area of the circle S1 is determined to be a region A2 to measure the arithmetic average roughness Ra. In addition, the center of the circle S1 and the center of the square are matched with each other. Then, using the atomic force microscope (AFM) in the square region A2, the arithmetic average roughness Ra is measured in dimension of nm. Measurement is performed on 10 points arbitrarily in the region A1, and an arithmetic mean value of the obtained values is determined as the arithmetic average roughness Ra.

FIG. 34C illustrates regions to measure the arithmetic average roughness Ra with respect to the epitaxial growth promotion portion 101, in the state (state A-3) where the epitaxial growth promotion portions 101 sandwich the epitaxial growth suppression portion 104. A circle S2 in contact with the epitaxial growth suppression portions 104 is set inside the epitaxial growth promotion portion 101, and a square having an area of, for example, 50% to 60% of an area of the circle S2 is determined to be a region A3 to measure the arithmetic average roughness Ra. In addition, the center of the circle S2 and the center of the square are matched with each other. Using the atomic force microscope (AFM) in the square region A3, the arithmetic average roughness Ra is measured in dimension of nm. Measurement is performed on 10 points arbitrarily in the region A1, and an arithmetic mean value of the obtained values is determined as the arithmetic average roughness Ra.

The arithmetic average roughness Ra with respect to the epitaxial growth suppression portion 104 is measured as described below. A region A4 to measure the arithmetic average roughness Ra is determined to be a square having an area of 50% to 60% of an area of a circle S3 in contact with the epitaxial growth promotion portion 101, inside the epitaxial growth suppression portion 104. In addition, the center of the circle S3 and the center of the square are matched with each other. One example is shown in FIG. 34B that is the case of the state A-2. In addition, also in the cases of FIGs. 34A and 34C that are cases of the states A-1 and A-3, the region A4 is similarly set, and the arithmetic average

roughness Ra is measured. Using the atomic force microscope (AFM) in the square region A4, the arithmetic average roughness Ra is measured in dimension of nm. Measurement is performed on 10 points arbitrarily in the region A1, and an arithmetic mean value of the obtained values is determined as the arithmetic average roughness Ra. The area is an area of the plane parallel with the first main surface.

A difference between the epitaxial growth promotion portion 101 and the epitaxial growth suppression portion 104 is in the arithmetic average roughness Ra of the surface thereof. In the following description, the arithmetic average roughness Ra is also described as "surface roughness Ra" simply. The difference between the epitaxial growth promotion portion 101 and the epitaxial growth suppression portion 104 is a difference in flatness of the surface.

By a method of manufacturing the growth substrate 100 described later, it is possible to control the surface roughness Ra of the epitaxial growth promotion portion 101 to 1.5 nm or less. By this means, the epitaxial growth promotion portion 101 is easy to function as a starting point of crystal growth, and the IQE is improved. Further, in this case, the surface roughness Ra of the epitaxial growth promotion portion 101 is infinitesimally small. Accordingly, variations are decreased in nucleus growth that is an initial stage of epitaxial stage. By the foregoing, it is possible to actualize stable epitaxial growth capable of enduring the LED manufacturing process. When the arithmetic average roughness Ra of the epitaxial growth promotion portion 101 is 1.0 nm or less, a difference in the lattice constant is small between the epitaxial growth promotion portion 101 and the crystal. Therefore, dislocations occurring inside the epitaxial growth promotion portion 101 are more decreased, and the IQE is more improved. When the arithmetic average roughness Ra is 0.5 nm or less, diffusion on the surface of the epitaxial growth promotion portion 101 tends to be uniform. Therefore, nucleus growth that is the initial stage of epitaxial growth is stabilized. Accordingly, it is easier to actualize stable epitaxial growth capable of enduring the LED manufacturing process. In addition, when the roughness is 0.3 nm or less, the effect of improving the IQE described above and the effect of stable epitaxial growth are best exerted. In addition, a lower limit value is not particularly limited, and from the viewpoint of measurement resolution of the atomic force microscope, is 0.1 nm or more.

By providing the epitaxial growth suppression portion 104 with a plurality of concavo-convex structures, it is easy to control the surface roughness Ra of the epitaxial growth suppression portion 104. Also a method of forming the concavo-convex structure is shown in the following manufacturing method. Bythismeans, the effect is enhanced as the starting point of crystal growth in the epitaxial growth promotion portion 101. Concurrently, the growth rate of epitaxial growth is fast with respect to the epitaxial growth promotion portion 101. Therefore, before the crystal grows from the side wall of the concavo-convex structure of the epitaxial growth suppression portion 104, it is possible to fill the epitaxial growth suppression portion 104 with the crystal growing from the epitaxial growth promotion portion 101. In other words, association of crystals is easy to occur inside the region of the epitaxial growth suppression portion 104. Accordingly, dislocations are more decreased, and the IQE is improved. When the arithmetic average roughness Ra with respect to the epitaxial growth suppression portion 104 is 5 nm or less, epitaxial growth characteristics are extremely reduced in the epitaxial growth suppression portion 104. This is because types of crystal planes of the epitaxial growth suppression portion 104 are increased, when the surface roughness Ra is large. In other words, as the surface roughness Ra is increased, the difference in the lattice constant is increased between the semiconductor layer and the growth substrate. That is, the function of the epitaxial growth promotion portion 101 as the starting point of crystal growth is remarkably exhibited. Accordingly, the IQE is more improved. When the arithmetic average roughness Ra is 25 nm or more, roughness of the epitaxial growth suppression portion 104 is increased with respect to the emitted light of the LED. Therefore, optical scattering properties are more improved, and the LEE is improved. From this viewpoint, the roughness Ra is more preferably 50 nm or more. In addition, when the roughness Ra is 80 nm or more, such roughness improves both the effect as the starting point of crystal growth with respect to the epitaxial growth promotion portion 101 described above and the effect of optical scattering properties in the epitaxial growth suppression portion 104, and is thereby the most preferable. On the other hand, when the roughness Ra is 800 nm or less, it is possible to inhibit that the crystal grows from the side wall of the concavo-convex structure of the epitaxial growth suppression portion 104. In other words, in the crystal growing in the lateral direction from the epitaxial growth promotion portion 101, it is possible to prevent growth of the crystal from being inhibited by the crystal growing from the epitaxial growth suppression portion 104. Accordingly, the IQE is improved. From this viewpoint, the roughness Ra is more preferably 500 nm or less. In addition, when the roughness Ra is 350 nm or less, it is possible to decrease variations in the growth rate when the crystal growing in the lateral direction from the epitaxial growth promotion portion 101 climbs over the epitaxial growth suppression portion 104. Accordingly, an association point of crystals is near the center of the epitaxial growth suppression portion 104. Accordingly, the IQE is improved. From the same viewpoint, the roughness Ra of 250 nm or less is the most preferable.

Shapes described below are preferable as contour shapes of the epitaxial growth promotion portions 101.

(State A-1)

In the state where the epitaxial growth promotion portions 101 are scattered and the periphery of each epitaxial

growth promotion portion 101 is enclosed by the epitaxial growth suppression portion 104, the outside shape of the epitaxial growth promotion portion 101 is preferably a regular n-gon. Alternatively, as shown in FIGs. 33A, 34A and the like, the outside shape of the epitaxial growth promotion portion 101 may be the shape that with respect to the regular n-gon, each corner portion is dented to draw an arc inward, and that each side draws arcs in a range of 0 to 10 in number inward. By these shapes, it is easy to actualize epitaxial growth of a crystal with the epitaxial growth promotion portion 101 as the starting point, and it is possible to estimate improvement in IQE. In addition, from the viewpoint of epitaxial growth, in the regular n-gon, a length of each side may have distortion (variations in the length) within ±10%. Further, with respect to the outside shape of the epitaxial growth promotion portion 101, in the case of the regular n-gon, the corner portion may be a corner portion (rounded corner portion) with a radius of curvature exceeding 0. In this case, it is easy to suppress epitaxial growth unstabilized in the corner portion, and it is thereby possible to actualize stable epitaxial growth. In regard to "the shape that with respect to the regular n-gon, each corner portion is dented to draw an arc inward, and that each side draws arcs in a range of 0 to 10 in number inward", the number of arcs that the each side draws inward is assumed to be m. FIG. 33A shows the case of m=0. In other words, FIG. 33A illustrates the shape that the corner portion of the regular hexagon is dented to draw an arc inward, and in each side of the regular hexagon, the number of arcs drawn inward is "0". In this Embodiment, the number m of arcs drawn inward by each side is preferably in the range of 0 to 10. This is because by the range of 0 to 10, it is easy to decrease dislocation defects occurring inside the crystal growing from the epitaxial growth promotion portion 101, and the IQE improving effect is enhanced. FIG. 35A, 35B, 35C and 35D illustrate examples of the shape that with respect to a regular hexagon, each corner portion is dented to draw an arc inward, and that each side draws arcs in a range of 0 to 10 in number inward. FIGs. 35A, 35B, 35C and 35D respectively illustrate m=0, m=1, m=2 and m=4. In addition, the dotted lines shown in FIG. 35A, 35B, 35C and 35D are the line indicating the regular hexagon.

In the case of the state where the epitaxial growth suppression portion 104 is enclosed by the epitaxial growth promotion portion 101, the side making the epitaxial growth promotion portion 101 may be a side of straight line, or a side having deformation protruding outward where the protrusion is in a convex shape downward. It is assumed that the epitaxial growth promotion portion 101 is disposed on a predetermined lattice. As shown in FIG. 34B, in this case, viewed from the predetermined lattice, the portion has a protrusion portion B directed outward. This protrusion is the convex shape in the direction of the predetermined lattice i.e. downward. This is because by these shapes it is easy to actualize epitaxial growth of a crystal with the epitaxial growth promotion portion 101 as the starting point, and it is possible to estimate improvement in IQE. In the example of FIG. 33B, the epitaxial growth promotion portions 101 are positioned as lattices that regular hexagons mutually share only sides and are closest packed. At this point, it is understood that the side of each regular hexagon has the protrusion portion directed to the outside from the center. Then, assuming that the protruding direction is positive, the protrusion portion is in the convex shape downward. In the case of FIG. 33B, the number of protrusion portions is "1" vertically for each side. Including the case of the straight line, the number of protrusion portions may be in the range of 0 to 10 vertically for each side. By the range of 0 to 10, it is easy to decrease dislocation defects occurring inside the crystal growing from the epitaxial growth promotion portion 101, and it is possible to enhance the IQE improving effect.

(State A-3)

In the case where the epitaxial growth promotion portions 101 sandwich the epitaxial growth suppression portion 104, in the outside shape of the epitaxial growth promotion portion 101, the side may be a side of straight line, or a side having deformation protruding outward where the protrusion is in a convex shape downward. By these shapes, it is easy to actualize epitaxial growth of a crystal with the epitaxial growth promotion portion 101 as a starting point, and it is possible to estimate improvement in IQE. In the example of FIG. 33C, the epitaxial growth promotion portions 101 are disposed in the shape of a line-and-space lattice. It is understood that the outside shape has protrusion portions directed to the outside from the lattice side (shown by the dashed lines). Then, assuming that the protruding direction is positive, the protrusion portion is in the concave shape downward.

The epitaxial growth promotion portion 101 is preferably disposed periodically. By arranging the epitaxial growth promotion portion 101 periodically, association of crystals generated on the epitaxial growth suppression portion 104 occurs near the center of the epitaxial growth suppression portion 104. Therefore, crystal defects are infinitesimally small, and it is possible to extremely improve the IQE. Particularly, the following arrangements are more preferable. In other words, it is more preferable that the portion is disposed in lattice points of a regular trigonal lattice (see FIG. 33A), lattice points and sides of a regular trigonal lattice, lattice points of the lattice that regular hexagons mutually share only sides and are closest packed, lattice points and sides of the lattice that regular hexagons mutually share only sides and are closest packed, or lattice points and sides of lattices where regular hexagons, which are obtained by drawing regular hexagons in an uniaxial direction at rates ranging from 110% to 5000%, mutually share only sides and are closest packed. In these cases, this is because there are tendencies to more remarkably improve the function as the starting point of crystal growth of the epitaxial growth promotion portion 101 and association of crystals on the epitaxial growth

suppression portion 104, which distribute to improvement in IQE. In addition, in the case in view of a physical phenomenon such as epitaxial growth, the lattice distortion of a regular n-gonal lattice is apt to be allowed to ±10%. Accordingly, it is assumed that the regular n-gon of this application includes from regular n-gons to n-gons having distortion (variations in the length) within ± 10%. By making such an arrangement, when crystals preferentially growing from the epitaxial growth promotion portion 101 are associated inside the region of the epitaxial growth suppression portion 104, regularity of association is drastically improved. Accordingly, the dislocation is infinitesimally small, and the IQE is more improved.

The area of each epitaxial growth promotion portion 101 is preferably 0.05 $\mu m^2$ or more. By this means, it is easy to cause the epitaxial growth promotion portion 101 to function as a starting point of crystal growth. Particularly, the area is more preferably 0.1 $\mu m^2$ or more . In this case, the distribution of epitaxial grown is small in the epitaxial growth promotion portion 101. Accordingly, nucleus growth, which is an initial stage of epitaxial growth, is stabilized. In other words, it is easy to actualize stable epitaxial film formation capable of enduring the LED manufacturing process. The area is most preferably 0.2 $\mu m^2$ or more. In this case, the epitaxial growth rate is fast in the epitaxial growth promotion portion 101, and it is easy to actualize association of crystals inside the region of the epitaxial growth suppression portion 104. Accordingly, the dislocation is more decreased, and the IQE is improved. An upper limit value of the area of the epitaxial growth promotion portion 101 is preferably 10 $\mu m^2$ or less. By this upper limit value, it is easy to control generation of dislocation inside the epitaxial growth promotion portion 101. From the same viewpoint, the area of the epitaxial growth promotion portion 101 is more preferably 7 $\mu m^2$ or less . In addition, when the area of the epitaxial growth promotion portion 101 is 5 $\mu m^2$ or less, the area of the epitaxial growth suppression portion 104 is relatively large, and optical scattering properties are improved. Accordingly, the effect of concurrently improving the IQE and IEE is enhanced.

The area ratio of the epitaxial growth promotion portions 101 to the first main surface (entire area of the epitaxial growth promotion portions 101/area of the first main surface) preferably ranges from 0.001 to 0.2. When the area ratio is 0.001 or more, the rate of epitaxial growth is increased, and industrial productivity is maintained. When the area ratio is 0.002 or more, since it is possible to increase the area of the epitaxial growth promotion portions 101, the function is enhanced as a starting point of crystal growth of the epitaxial growth promotion portion 101, and the IQE is more improved. When the area ratio is 0.005 or more, in addition to improvements in IQE and IEE and stable epitaxial growth capable of enduring the LED manufacturing process as described above, industrial productivity is drastically improved. When the area ratio is 0.2 or less, it is possible to decrease defects of crystals growing from the epitaxial growth promotion portion 101. Therefore, the IQE is easy to improve. When the area ratio is 0.15 or less, the rate of the epitaxial growth suppression portion 104 is large, optical scattering properties are enhanced, and therefore, the improvement in LEE is remarkable. The area ratio is most preferably 0.1 or less. In this case, in a state of ensuring industrial productivity, it is possible to effectively improve the IQE and LEE, and it is possible to actualize stable epitaxial growth capable of enduring the LED manufacturing process. In addition, the area ratio is a value with respect to a region of 10 μm □. In other words, the area of the first main surface is 100 $\mu m^2$. Then, the above-mentioned ratio is a value by dividing the area of the epitaxial growth promotion portion 101 included in the region of 100 μm □ by 100 $\mu m^2$.

As another Embodiment of the substrate for semiconductor light emitting device of the present invention, it is preferable that the epitaxial growth promotion portions and epitaxial growth suppression portions disposed on the first main surface concurrently meet the following requirements a to d.

a. Peripheries of a scattered plurality of the epitaxial growth promotion portions are enclosed by the epitaxial growth suppression portions; peripheries of a plurality of the epitaxial growth suppression portions are enclosed by the epitaxial growth promotion portions, or the epitaxial growth suppression portions are sandwiched between the epitaxial growth promotion portions;
b. the epitaxial growth suppression portions are comprised of a plurality of concavo-convex structures;
c. the epitaxial growth suppression portions and the epitaxial growth promotion portions are periodically arranged; and
d. a period unit α comprised of the epitaxial growth promotion portions and the epitaxial growth suppression portions is arbitrarily selected, and when the period unit α is overlapped with another period unit β arbitrarily selected, a matching rate of a concavo-convex structure S-α included in the period unit α and a concavo-convex structure S-β included in the period unit β to the first main surface by a projection area ranges from 0.60 to 0.99.

As described previously, the epitaxial growth suppression portion is comprised of a plurality of concavo-convex portions (the above-mentioned requirement b). Therefore, the epitaxial growth rate is small with respect to the epitaxial growth suppression portion. Accordingly, the epitaxial growth promotion portion functions as a starting point of crystal growth. Herein, the epitaxial growth promotion portions are provided to be scattered in the region of the epitaxial growth suppression portion, to enclose the periphery of the epitaxial growth suppression portion or to sandwich the epitaxial growth suppression portion (above-mentioned requirement a). Therefore, association of crystals of epitaxial growth tends to occur near the center of the epitaxial growth suppression portion. Therefore, crystal defects are extremely decreased. Accordingly, the IQE is improved. At this point, with respect to the period of the epitaxial growth suppression portion and epitaxial growth promotion portion, the period unit α is arbitrarily selected. The period unit α is moved as

appropriate to overlap with another period unit β. A matching rate of areas is determined when the concavo-convex structure included in each of the periods unit α and β is projected onto the first main surface. The matching rate ranges from 0.60 to 0.99 (above-mentioned requirement d). Since the matching rate is thus within the predetermined range, it is easy to prevent a crystal from growing from the epitaxial growth suppression portion abruptly during epitaxial growth. In other words, in crystals growing from the epitaxial growth promotion portion, it is possible to prevent growth of the crystals from being inhibited by the crystal growing from the epitaxial growth suppression portion abruptly, before associating near the center of the epitaxial growth suppression portion. On the other hand, the epitaxial growth suppression portion is comprised of a plurality of concavo-convex structures, and the epitaxial growth suppression portion and the epitaxial growth promotion portion are periodically arranged. Accordingly, optical scattering properties are developed, the waveguide mode is broken, and the LEE is improved.

Further, the above-mentioned requirement d will be described with reference to the drawing. FIG. 36A, 36B and 36C contain plan schematic diagrams of epitaxial growth promotion portions and epitaxial growth suppression portions to explain the period unit comprised of epitaxial growth promotion portions and epitaxial growth suppression portions.

In FIG. 36A, 36B and 36C, the state A-1 described previously is represented, and the state A-2 and the state A-3 are similarly considered. In the form of FIG. 36A, 36B and 36C, the regular trigonal lattice that is an arrangement unit of the epitaxial growth promotion portions 101 is an arrangement unit of the epitaxial growth promotion portions and epitaxial growth suppression portions, and it is considered that the epitaxial growth promotion portions 101 are disposed in lattice points of the regular trigonal lattice. Concurrently, the epitaxial growth suppression portion 104 is comprised of a plurality of concavo-convex structures, and the concavo-convex structures are positioned in lattice points of a regular trigonal lattice. Then, in the regular trigonal lattice for determining the arrangement of the epitaxial growth promotion portions 101 and the regular trigonal lattice for determining the concavo-convex structures of the epitaxial growth suppression portion 104, the direction thereof is rotated 30 degrees and deviated.

Further, herein, the unit is selected arbitrarily, and is made the period unit α. Next, a period unit which is the same unit lattice and is different from the period unit α is selected arbitrarily. The unit is made the period unit β. FIG. 36B is a diagram where each of the period unit α and the period unit β is drawn. The concavo-convex structure S-α included in the period unit α and the concavo-convex structure S-β included in the period unit β are overlapped with each other as shown in FIG. 36C. Herein, observation is performed using a scanning electron microscope. The observation position is a top surface diagram (frontside image). In other words, it is possible to obtain a projection image of the concavo-convex structure with respect to the first main surface of the substrate. When the concavo-convex structure is a set of convex portions, a contour of bottom portions of the convex portions is observed as a single convex portion. When the concavo-convex structure is a set of concave portions, a contour of opening portions of the concave portions is observed as a single concave portion. In other words, the concavo-convex structure indicated by the circle shown in FIG. 36A, 36B and 36C is the contour of the bottom portion of the convex portion. The area of the bottom portion contour of the convex portion is obtained, in projecting the concavo-convex structure S-α included in the period unit α onto the first main surface. The measurement is similarly performed on the concavo-convex structure S-β included in the period unit β. Each area is determined to be an area of a portion included inside the period unit. For example, in the case of FIG. 36A, 36B and 36C, with respect to convex portions a1 to a7 constituting the concavo-convex structure S-α and convex portions b1 to b7 constituting the concavo-convex structure S-β, the areas are calculated as shown in the following table. The matching rate is a ratio of 1 or less. In the example of the convex portion a1 and convex portion b1, the matching rate is b1/a1. In the example of the convex portion a6 and convex portion b6, the matching rate is a6/b6. Finally, all of the matching rates are averaged, and a numeric value of "0.83" is obtained. In the above-mentioned example, only the period unit β is compared with the period unit α, and in this Embodiment, period units β2, β3, β4, β5 and β6 are arbitrarily selected. Then, the matching rate of the period unit α with respect to each of the period units β, β2, β3, β4, β5 and β6 is obtained, and a value subjected to arithmetic mean thereof is the matching rate of this application (see the following Table 1).

[Table 1]

| Convex portion | Area $nm^2$ | Convex portion | Area $nm^2$ | Matching rate |
|---|---|---|---|---|
| a1 | 373928 | b1 | 134614 | 0.36 |
| a2 | 181584 | b2 | 88976 | 0.49 |
| a3 | 184264 | b3 | 181584 | 0.99 |
| a4 | 176283 | b4 | 178924 | 0.99 |
| a5 | 181584 | b5 | 181584 | 1 |

(continued)

| Convex portion | Area nm$^2$ | Convex portion | Area nm$^2$ | Matching rate |
|---|---|---|---|---|
| a6 | 186964 | b6 | 189683 | 0.99 |
| a7 | 191873 | b7 | 186964 | 0.97 |
| Average matching rate | | | | 0.83 |

In this Embodiment, the matching rate (average matching rate) ranges from 0.60 to 0.99. Since such a matching rate is within a predetermined range, it is easy to prevent a crystal from growing from the epitaxial growth suppression portion abruptly during epitaxial growth. In other words, in crystals growing from the epitaxial growth promotion portion, it is possible to prevent growth of the crystals from being inhibited by the crystal growing from the epitaxial growth suppression portion abruptly, before associating near the center of the epitaxial growth suppression portion. Accordingly, the dislocation effectively decreases, and stability of epitaxial growth is enhanced. Particularly, when the matching rate is 0.95 or less, a difference in micro-concavo-convex structure is strong with respect to periodicity of the placement. Accordingly, in a minute view, optical scattering properties are improved. Concurrently, it is possible to also consider that a minute variation in the concave-convex structure has a function of relaxing compression stress generated by epitaxial growth. Accordingly, since distortion is decreased with respect to the crystal, the IQE is more improved. On the other hand, when the matching rate is 0.65 or more, decreased is the frequency of the crystal growing from the epitaxial growth suppression portion abruptly. Accordingly, stability of epitaxial growth is significantly improved. The matching rate is most preferably 0.70 or more.

Materials of the optical substrate or a substrate body in the substrate for semiconductor light emitting device according to this Embodiment are not limited particularly, as long as the materials are used as the optical substrate or the substrate for semiconductor light emitting device. For example, it is possible to use substrates of sapphire, SiC, SiN, GaN, silicon, zinc oxide, magnesiumoxide, manganese oxide, zirconiumoxide, manganese zinc ferrite, magnesium aluminum oxide, zirconium boride, gallium oxide, indium oxide, lithium gallium oxide, lithium aluminum oxide, neodymium gallium oxide, lanthanum strontium aluminum tantalum oxide, strontium titanium oxide, titanium oxide, hafnium, tungsten, molybdenum, GaP, GaAs and the like. Among the substrates, from the viewpoint of lattice matching with the semiconductor layer, it is preferable to apply substrates of sapphire, GaN, GaP, GaAs, SiC and the like. For example, it is possible to use a sapphire substrate with the C-plane (0001) as the main surface for the optical substrate. Further, the materials may be used alone, a substrate of hetero structure may be made in which another substrate is provided on the substrate body using these materials, or a hetero structure may be made where the concavo-convex portion is a different substrate.

(Manufacturing method)

Described next are methods of manufacturing the optical substrate and the substrate for semiconductor light emitting device according to this Embodiment. In addition, the manufacturing methods described below are one example, and the methods of manufacturing the substrate for semiconductor light emitting device are not limited thereto.

The methods of manufacturing the substrate for semiconductor light emitting device will be described below in detail, and the methods are the same as in the optical substrate, and are defined by reading the substrate for semiconductor light emitting device with the optical substrate in the following description.

The methods of manufacturing the substrate for semiconductor light emitting device as described above are not limited particularly, and among the methods are a normal photolithography method, imprint method, nanoimprint method, nanoimprint lithography method and the like. For example, in the nanoimprint lithography method, after forming a resist layer on a predetermined substrate surface, using an inverse mold of a required transfer pattern, transfer is performed by the nanoimprint method to obtain the resist layer with the required concavo-convex pattern formed on the surface.

Further, it is possible to use a dry film nanoimprint lithography method, where a dry film pattern sheet is formed with a dry film layer formed on the sheet surface with a concavo-convex inverse structure of a required predetermined concavo-convex pattern beforehand formed, and the sheet is transferred to a substrate surface to obtained a dry film resist layer with the concavo-convex pattern formed on the surface.

According to the above-mentioned dry film nanoimprint lithography method, there are advantages that it is possible to form the concavo-convex pattern with a mask layer with high etching resistance, and that the concavo-convex pattern formation on the substrate surface is easy, and therefore, the method is preferable. Further, the method requires only the process of bonding the dry film to the substrate, eliminates the need for high-accuracy imprint apparatus and exposure apparatus, is capable of increasing production efficiency, and is thereby useful in terms of industrial production. From the foregoing, it is suitable to use the dry film nanoimprint lithography method.

Herein, the method will be described further, using a sapphire substrate as representative.

First, the first main surface of the sapphire substrate is polished. At this point, it is possible to control surface roughness Ra of the first main surface, by controlling types of abrasive particles, the number of abrasive particles, polish rate, pH and the like. Particularly, it is preferable to perform polishing so that arithmetic average roughness is 1.5 nm or less. This is because the surface polishing accuracy is correlated with the surface roughness Ra of the manufactured epitaxial growth promotion portion. Among the values, when the arithmetic average roughness is 0.5 nm or less, the distribution of the manufactured epitaxial growth promotion portion is small with respect to the sapphire substrate of 4 inches, 6 inches or the like, and therefore, such roughness is preferable. From the viewpoints of IQE improvement and stable epitaxial growth, the arithmetic average roughness is most preferably 0.3 nm or less. Further, an off-angle, plane direction and the like of a selected substrate are selected as appropriate, and are capable of being incorporated into required specifications of semiconductor light emitting device.

For example, a sapphire substrate with surface roughness Ra within a predetermined range is washed and cleaned using a mixed solution (SPM solution) of sulfuric acid and hydrogen peroxide solution. On the other hand, prepared is a dry film pattern sheet provided with position information of the epitaxial growth promotion portion and epitaxial growth suppression portion with accuracy of correlation coefficient of 0.9 or more. For example, a pattern is formed on a glass mother roll by applying a thermal-lithography method. At this point, by controlling irradiation pulses of the laser, it is possible to form the position information of the epitaxial growth promotion portion and epitaxial growth suppression portion on the glass mother roll. A mold is manufactured from the mother roll, by a photo-nanoimprint method. Further, the mold may be transferred to another mold to replicate.

Next, the above-mentioned obtained mold is filled with a first resist of inorganic or organic-inorganic hybrid composition. For example, it is possible to contain organic metal, metal oxide fine particles and the like in the resist. The filling state in this stage is a state in which the resist is not completely charged inside the pattern of the mold, the mold is not flattened by the resist, and a part of the pattern is exposed after applying the first resist.

Next, a second resist that is an organic resist is applied to the first resist-filled mold. Herein, as distinct from the prior stage, film formation is performed to flatten. The mold with films of the first resist and second resist formed is referred to as a dry film pattern sheet. Herein, two layers are described, and it is also possible to use a single layer resist with only the film of the second resist formed, and multi-layer dry film pattern sheet further having a third resist. The organic resist may be a negative type or a positive type, and preferably contains at least a radical polymerization system that exhibits curing effect by ultraviolet light, or chemical amplification system. In the case where the resist contains phenol novolac, cresol novolac, acryl-modified epoxy novolac, methacryl-modified epoxy novolac, adamantane, fluorene, carbazole, polyvinyl carbazole, poly(para-hydroxystyrene) and the like, processability of the substrate is improved, and therefore, such a case is preferable. Particularly, in the case of preparing a mixture containing oligomer or polymer, monomer and polymerization initiator, the function of maintaining a thin film state of the applied resist is improved, and therefore, such a case is desirable.

Next, the dry film pattern sheet is bonded to the sapphire substrate. After bonding, the resist is stabilized by light and heat, and then, the mold is removed. Alternatively, after removing the mold, the resist is stabilized by light and heat.

By the above-mentioned operation, the second resist layer and first resist layer are transferred onto the main surface of the sapphire substrate. An inverse structure of the mold is transferred to the surface of the resist, and the inverse structure has an arrangement of the epitaxial growth promotion portion and epitaxial growth suppression portion as the position information.

Finally, by etching using the resist layer formed on the substrate surface as a mask, it is possible to form the epitaxial growth promotion portion and epitaxial growth suppression portion on the substrate surface. As an etching method, it is possible to apply wet etching, dry etching, method obtained by combining both etching and the like. Particularly, from the viewpoints of control of surface roughness Ra of the epitaxial growth promotion portion and control of the convex portion of the epitaxial growth suppression portion, it is preferable to use the dry etching method. Among the dry etching methods, anisotropy dry etching is preferable, and ICP-RIE and ECM-RIE are preferable. As a reactive gas used in dry etching, the gas is not particularly limited, as long as the gas reacts with the materials of the substrate. $BCl_3$, $Cl_2$, $CHF_3$ or a mixed gas thereof are preferable, and it is possible to mix Ar, $O_2$, $N_2$ or the like as appropriate.

In this Embodiment, in order to provide the concavo-convex structure 20 having the convex portion 21, flat portion 22 and concave portion 23 on the optical substrate 10 as shown in FIG. 8, for example, a resist layer 11 shown in FIG. 37 is provided on an optical substrate, not shown, with the flat main surface (without the concavo-convex 20 being formed).

As shown in FIG. 37, a plurality of convex portions 12 is provided on the main surface of the resist layer 11, and the convex portions 12 are opposed, in the thickness direction (Z direction), to positions of the convex portions 21 formed on the optical substrate. As shown in FIG. 37, each of the narrow flat portion 13 and wide flat portion 14 is provided between the convex portions 12, and the wide flat portions 14 are opposed, in the film thickness direction (Z direction), to positions of the concave portions 23 formed on the optical substrate. In other words, the wide flat portion

14 provided in the resist layer 11 constitutes the toothless portion (hereinafter, referred to as toothless portion 14) comprised of a wide width with the predetermined number ("1" in FIG. 37) of convex portions thinned.

By performing etching using the resist layer 11 of FIG. 37, it is possible to form the concavo-convex structure 20 having the convex portion 21, flat portion 22, and concave portion 23. For example, in the case of forming the concavo-convex structure by dry etching, by providing a difference between an etching rate of the wide flat portion 14 and an etching rate of the narrow flat portion 13 between the convex portions 12, it is possible to provide the concave portion 23 in the wide flat portion (toothless portion) 14 of the resist layer 11. Therefore, when a distance s between convex portion bottom portions (shown in FIGs. 9A, 9B) is particularly 200 nm or less (preferably, 100 nm or less) and the ratio lo_w/s of the width lo_w of the concave portion opening portion to the distance s between convex-portion bottom portions is 6 or more, the difference between the etching rates is large, and the concave portions are easy to form.

In this case, as the reason why the difference in the etching rate occurs between the wide flat portion 14 and the narrow flat portion 13 between the convex portions 12, there is a microloading effect in dry etching. Particularly, since the narrow flat portion 13 between the convex portions 12 is narrow as described above, the etching rate of the narrow flat portion 13 is decreased, and the microloading effect remarkably works.

The substrate for semiconductor light emitting device according to the Embodiment of the present invention of this application is formed by the above-mentioned dry film resist method and dry etching method.

For example, by using the resist layer 11 having the toothless portions 14 in positions of black circles of FIG. 38, it is possible to obtain the substrate for semiconductor light emitting device of FIG. 39 having independent concave portions 23.

Further, by using the resist layer 11 having the toothless portions 14 in positions of black circles of FIG. 40, it is possible to obtain the substrate for semiconductor light emitting device of FIG. 4 having contiguous concave portions 23.

(Semiconductor light emitting device)

Described next are semiconductor light emitting devices to which is applied the substrate for semiconductor light emitting device according to this Embodiment of the present invention. The substrate for semiconductor light emitting device will be described below in detail, and the optical substrate of the present invention is also the same, and is defined by reading the substrate for semiconductor light emitting device with the optical substrate.

The semiconductor light emitting device according to this Embodiment contains at least one or more substrates for semiconductor light emitting device according to this Embodiment as described above in the composition. By incorporating the substrate for semiconductor light emitting device according to this Embodiment into the composition, it is possible to perform improvement in IQE and improvement in IEE.

The semiconductor light emitting device according to this Embodiment has a layered semiconductor layer configured by layering at least two or more semiconductor layers and light emitting layer on the first main surface of the substrate for semiconductor light emitting device.

For example, FIG. 41 is a cross-sectional schematic diagram of the semiconductor light emitting device according to this Embodiment. As shown in FIG. 41, in the semiconductor light emitting device A00, an undoped type semiconductor layer A51, n-type semiconductor layer A52, light emitting semiconductor layer A53 and p-type semiconductor layer S54 are successively layered on one main surface of the substrate A01 for semiconductor light emitting device. Further, a transparent conductive film A55 is formed on the p-type semiconductor layer A54.

Further, a cathode electrode A57 is formed on the surface of the n-type semiconductor layer A52, and an anode electrode A56 is formed on the surface of the transparent conductive film A55. Inaddition, then-type semiconductor layer A52, light emitting semiconductor layer A53 and p-type semiconductor layer S54 successively layered on the substrate A01 for semiconductor light emitting device are referred to as a layered semiconductor layer A60.

Herein, it is preferable that the main surface of the undoped type semiconductor layer A51 is a flat plane. By the main surface of the undoped type semiconductor layer A51 being a flat plane, it is possible to increase efficiency of performance of the n-type semiconductor layer A52, light emitting semiconductor layer A53 and p-type semiconductor layer S54, and the internal quantum efficiency IQE is thereby improved.

Further, it is preferable that a buffer layer not shown exists in an interface between the undoped type semiconductor layer A51 and the substrate A01 for semiconductor light emitting device. By existence of the buffer layer, nucleus generation and nucleus growth, which is initial conditions of crystal growth of the undoped type semiconductor layer A51, is made excellent, performance is increased as the semiconductor of the layered semiconductor layer A60, and the internal quantum efficiency IQE is thereby improved.

Although the buffer layer may be formed to cover the entire surface of the concave-convex structure, it is possible to provide partially on the surface of the concavo-convex structure, and it is possible to particularly provide the buffer layer preferentially on the epitaxial growth promotion portion on the surface of the substrate A01 for semiconductor light emitting device.

A thickness of the buffer layer preferably ranges from 5 nm to 100 nm, and more preferably ranges from 10

nm to 50 nm. By this means, an effect caused by a ratio (TexD/TDD) described later is exerted more remarkably. This is because fluctuations in the growth rate of the undoped type semiconductor layer A51 are decreased by the thickness of the buffer layer and association points are easy to control . In addition, the effect by the ratio (TexD/TDD) will be described later.

For example, in the buffer layer, it is possible to adopt GaN structure, AlGaN structure, AlN structure, AiInN structure, InGaN/GaN superlattice structure, InGaN/GaN layered structure, AlInGaN/InGaN/GaN layered structure and the like. Among the structures, the GaN structure, AlGaN structure and AlN structure are the most preferable. By this means, since fluctuations in the growth rate of the undoped type semiconductor layer A51 described above are further decreased, controllability of association points is thereby improved, and it is easy to decrease surface roughness of the undoped type semiconductor layer A51.

Further, in film formation of the buffer layer, it is possible to set film formation temperatures within a range of 350°C to 600°C. Furthermore, it is preferable that the buffer layer undergoes film formation by MOCVD (Metal Organic Chemical Vapor Deposition) method or sputtering method.

In the semiconductor light emitting device according to this Embodiment, the undoped type semiconductor layer A51 and the buffer layer are defined together as a primary layer to describe.

In the semiconductor light emitting device according to this Embodiment, as the undoped type semiconductor layer A51, for example, it is possible to apply element semiconductors of silicon, germanium and the like, or compound semiconductors of group III-V, group II-VI, group IVI-IV and the like. Particularly, an undoped nitride layer is preferable. As the undoped nitride layer, for example, by supplying $NH_3$ and TMGa at a growth temperature ranging from 900°C to 1500°C, it is possible to perform deposition.

A film thickness of the undoped type semiconductor layer A51 preferably ranges from 0.5 μm to 10 μm, and more preferably ranges from 1.3 μm to 8 μm, from the viewpoint of residual stress with respect to the undoped type semiconductor layer A51.

In the semiconductor light emitting device according to this Embodiment, as the n-type semiconductor layer, particular limitations are not imposed, as long as materials are capable of being used as the n-type semiconductor layer suitable for semiconductor light emitting devices. For example, it is possible to apply materials obtained by doping various elements as appropriate in element semiconductors of silicon, germanium and the like, compound semiconductors of group III-V, group II-VI, group IV-IV and the like. Further, in the n-type semiconductor layer and p-type semiconductor layer, it is possible to provide an n-type clad layer and p-type clad layer not shown, as appropriate.

As an n-type GaN layer, for example, it is possible to form by supplying $NH_3$ at $3x10^{-2}$~$4.2x10^{-2}$ mol/min, trimethyl gallium (TMGa) at $0.8x10^{-4}$~$1.8x10^{-4}$ mol/min, and silane gas containing an n-type dopant typified by Si at $5.8x10^{-9}$~$6.9x10^{-9}$ mol/min. From the viewpoint of electron injection properties to the active layer, the film thickness is preferably 800 nm or more, and more preferably 1500 nm or more.

As the semiconductor light emitting layer, particular limitations are not imposed, as long as materials have light emitting properties as the semiconductor light emitting device. For example, as the semiconductor light emitting layer, it is possible to use semiconductor layers of AsP, GaP, AlGaAs, InGaN, GaN, AlGaN, ZnSe, AlHaInP, ZnO and the like. Further, the light emitting semiconductor layer may be doped with various elements as appropriate corresponding to properties.

Further, it is preferable to make single quantum well structure (SQW) or multi-quantum well structure (MQW).

For example, at a growth temperature ranging from 600°C to 850°C, by supplying $NH_3$, TMGa and trimethyl indium (TMIn) using nitrogen as a carrier gas, it is possible to grow an active layer comprised of INGaN/GaN to a thickness ranging from 100Å to 1250Å. Further, in the case of the multi-quantum well structure, with respect to InGaN constituting a single layer, it is also possible to vary the In element concentration.

Further, it is possible to provide an electron block layer (not shown) between the light emitting semiconductor layer A53 and the p-type semiconductor layer S54. For example, the electron block layer is comprised of p-AlGaN.

In the semiconductor light emitting device according to this Embodiment, materials of the p-type semiconductor layer are not limited particularly, as long as the materials are capable of being used as the p-type semiconductor layer suitable for semiconductor light emitting devices. For example, it is possible to apply materials obtained by doping various elements as appropriate in element semiconductors of silicon, germanium and the like and compound semiconductors of group III-V, group II-VI, group VI-IV and the like. For example, in the case of a p-type GaN layer, by increasing a growth temperature to 900°C or more, and applying TMGa and CP2Mg, it is possible to perform deposition in a thickness of hundreds to thousands of angstroms.

It is possible to deposit these layered semiconductor layers (n-type semiconductor layer, light emitting semiconductor layer and p-type semiconductor layer) on the substrate surface by publicly known techniques. For example, as the deposition method, it is possible to apply Metal Organic Chemical Vapor Deposition method (MOCVD), Hydride Vapor Phase Epitaxy method (HVPE), Molecular Beam Epitaxy method (MBE) and the like.

In the semiconductor light emitting device according to this Embodiment, materials of the transparent conductive film are not limited particularly, as long as the materials are capable of being used as the transparent conductive film

suitable for semiconductor light emitting devices. For example, it is possible to apply metal thin films of Ni/Au electrode and the like, and conductive oxide films of ITO, ZnO, $In_2O_3$, $SnO_2$, IZO, IGZO and the like. Particularly, from the viewpoints of transparency and electrical conductivity, ITO is preferable.

In the semiconductor light emitting device according to this Embodiment, a thickness of the transparent conductive film preferably ranges from 30 nm to 100 nm. The role of the transparent conductive film is to diffuse current from the anode electrode A56 and inject to the p-type semiconductor layer A54. Since resistance of the transparent conductive film A55 is lower, as the thickness is thicker, the thickness (T_TE) of the transparent conductive film A55 is preferably 30 nm or more, and more preferably 40 nm or more. As an upper limit, from the viewpoints of enabling transmittance with respect to an incident angle of the critical angle or less to be extremely increased using thin film interference, in addition to suppression of light absorption, and suppressing the transmittance distribution of the critical angle or less, the thickness (T_TE) of the transparent conductive film A55 is preferably 100 nm or less, and more preferably 80 nm or less.

For example, it is possible to measure the thickness (T_TE) of the transparent conductive film A55, using STEM (Scanning Transmission Electron Microscopy). Measurement with STEM is capable of clarifying the boundary between the film and the layered semiconductor layer from contrast of the image, and is preferable.

In this Embodiment, with respect to conventional techniques, it is possible to make the height of the concavo-convex structure 1 μm or less, and when the concavo-convex structure is thus nano-order particularly, the thickness is made thin which is required to flatten the concave-convex structure with the undoped type semiconductor layer A51. Therefore, since the semiconductor layer for absorbing light from the light emitting semiconductor layer A53 is thin, further improvement is estimated in the light extraction efficiency LEE, it is made possible to suppress warpage of the n-type semiconductor layer A52, and the light emitting semiconductor layer A53 and p-type semiconductor layer S54successively layered thereon, and it is possible to make the semiconductor light emitting device with a larger area than previously. From the foregoing, the thickness of the primary layer A51 is preferably 5 μm or less, more preferably 4 μm or less, further preferably 3.5 μm or less, further more preferably 2.5 μm or less, and most preferably 1.5 μm or less

(Reflecting layer)

In the semiconductor light emitting device according to this Embodiment of the present invention, a reflecting layer not shown may be provided on a main surface on the backside of the main surface of the substrate A01 on which the layered semiconductor layer is formed.

Materials of the reflecting layer are not limited particularly, as long as reflectance at luminous wavelengths is high. For example, among metals, Ag, Al, alloy thereof or the like is selected, for example, in terms of reflectance, adherence to the substrate A01 for semiconductor light emitting device and the like. Alternatively, to make higher reflectance, a dielectric multi-layer film may be formed. The film thickness and the number of layers are not limited particularly, as long as reflectance is within a desired range, and for example, it is possible to use titanium oxide, zirconium oxide, niobium oxide, tantalum oxide and aluminium nitride as a high refractive index layer, and silicon oxide as a low refractive index layer. Further, after forming the dielectric multi-layer film, metal may be deposited.

Further, in order to improve adherence to the substrate A01 for semiconductor light emitting device, an adherence layer may be formed between the substrate A01 for semiconductor light emitting device and the reflecting layer. As the adherence layer, for example, it is possible to use silicon oxide.

(Relationship between the semiconductor film and the dislocation density)

In the semiconductor light emitting device of this Embodiment, dislocation penetrating the light emitting semiconductor layer A53 is made threading dislocation, and the density thereof is defined as the dislocation density (Threading Dislocation Density: TDD(/$cm^2$)).

According to the substrate for semiconductor light emitting device of this Embodiment, by controlling a ratio between the pattern density of the substrate and the dislocation density (TDD) within a predetermined range, it is possible to deposit the semiconductor layer with the dislocation decreased and the crystal quality improved. It is possible to measure the dislocation density (TDD) with a cross-sectional transmission electron microscope. In this case, since a measurement region is small and fluctuations are large, an arithmetic mean value of 5 points is adopted.

In the semiconductor light emitting device of the present invention shown in FIG. 41, with attention directed toward the main surface on the substrate for semiconductor light emitting device side of the primary layer, the layer is in an inverse pattern shape of the substrate for semiconductor light emitting device, and therefore, has texture of hole structure comprised of a plurality of concave portions mutually spaced by contiguous convex portions.

According to the substrate for semiconductor light emitting device of this Embodiment, as described previously using FIGs. 6 and 7, the defects concentrate on the center of the epitaxial growth suppression portion and are decreased, and therefore, the IQE is improved in the obtained semiconductor light emitting device.

In other words, the primary layer in the semiconductor light emitting device of this Embodiment is in the following preferable state. That is, the layer has the main surface in the inverse pattern shape of the substrate for semiconductor light emitting device of this Embodiment, and the ratio (TexD/TDD) between the dislocation density (TDD) of the dislocation penetrating the light emitting layer and the density (TexD) of the texture is 0.3 or more.

The ratio (TexD/TDD) is a ratio of the density of the concavo-convex structure to the dislocation density TDD. In the case where the dislocation density TDD approaches "0", or in the case where the scale of the concavo-convex structure disperses infinitely, it holds that the ratio (TexD/TDD)$\rightarrow\infty$. On the other hand, in the case where the dislocation density TDD is infinitesimally large, or in the case where the concavo-convex structure is decreased to the atomic level, it holds that the ratio (TexD/TDD)$\rightarrow$0.

The density D of the concavo-convex structure is the density of dot-shaped convex portions, and its dimension is (/$cm^2$). In the following description, the density of the concavo-convex structure will be simply described as the number of concavo-convex structures, and it is assumed that the number indicates the number per unit area i.e. the density. In other words, the number of concavo-convex structures means the number (density) of convex portions when the portions are in the shape of dots. Similarly, the dislocation density will be sometimes described also as the number of dislocations, and it is also assumed that the number indicates the number per unit area i.e. the density.

The ratio (TexD/TDD) is capable of translating into a balance between the number of concavo-convex structures and the number of dislocations. Particularly, the ratio (TexD/TDD) is capable of being regarded as the number of dislocations allocated to a single concavo-convex structure.

Further, in the primary layer, it is preferable that dislocations leading to the epitaxial growth promotion portion of the opposed substrate for semiconductor light emitting device are higher in number than dislocations leading to the epitaxial growth suppression portion. Such a primary layer is capable of reducing residual compression stress in deposition with respect to the semiconductor light emitting device, and is preferable. Further, it is preferable that the dislocations leading to the epitaxial growth promotion portion are twice or more the dislocations leading to the epitaxial growth suppression portion.

A detailed mechanism for enabling the residual compression stress in deposition to be reduced in the above-mentioned composition is uncertain, but is estimated as described below.

Since the epitaxial growth suppression portion is spread two-dimensionally with respect to the primary layer main surface, it is considered that the residual compression stress with respect to the primary layer with the epitaxial growth suppression portion as a starting point is dispersed by two-dimensionally spreading, and is reduced. On the other hand, the epitaxial growth promotion portions are mutually independent, and therefore, are not capable of dispersing the residual compression stress. Herein, the treading defect itself is a defect with respect to the crystal, but is capable of reducing residual stress inside the primary layer, because, continuity of the crystal is disconnected. In other words, morphologically, it is possible to decrease the residual compression stress, by forming many dislocations in the primary layer in the epitaxial growth promotion portions which are mutually independent and are not capable of reducing the residual compression stress.

By the residual compression stress inside the semiconductor layer being decreased, internal polarization is relieved in passage of current, and light emitting properties are improved. Particularly, it is considered that light emitting intensity is improved in the high current density.

Characteristic portions of this Embodiment will be described below.

In other words, the optical substrate of this Embodiment is characterized by being an optical substrate with a concavo-convex structure formed on a part or the whole of the main surface, where the concavo-convex structure has regular toothless portions.

Further, the optical substrate of this Embodiment is characterized in that the concavo-convex structure is comprised of convex portions, inter-convex portion bottom portions, and a concave portion having a flat plane in a position lower than a main surface formed of the inter-convex bottom portions, and that each of the toothless portions is the concave portion (see FIG. 2).

In this Embodiment, it is preferable that the convex portions are arranged with an average pitch P0, the toothless portions are disposed on vertexes of a regular polygon, or disposed on a side of the regular polygon connecting between the vertexes, and that a length of the side of the regular polygon is longer than the average pitch P0 (see FIG. 4 and 5).

Further, the length of the side of the regular polygon is preferably two times or more and five times or less the average pitch P0 (see FIGs. 4 and 5).

Furthermore, it is preferable that each of a plurality of the toothless portions forming the concavo-convex structure is set on a placement position set in each lattice point of a regular triangle lattice as a new unit lattice of a regular hexagon, while being provided in a position that corresponds to a vertex or a side of the regular hexagon (see FIG. 5).

Still furthermore, it is preferable that each of a plurality of the toothless portions forming the concavo-convex structure is set on a placement position set in each lattice point of a regular triangle lattice as a new regular tringle lattice, while being provided in a position that corresponds to a vertex of the newly set regular triangle (see FIG. 10).

Moreover, the toothless portions are preferably disposed so that a straight line connecting between the toothless portions is orthogonal to crystal planes to be associated in crystal growth initialization among crystal planes of a semiconductor layer deposited on the optical substrate (see FIG. 14).

Particularly, the optical substrate in this Embodiment is characterized by being an optical substrate with a concavo-convex structure formed on a part or the whole of the main surface, where the concavo-convex structure is set on a placement position set in each lattice point of a regular triangle lattice, and has convex portions, inter-convex portion bottom portions, and a concave portion having a flat plane in a position lower than a main surface formed of the inter-convex bottom portions to be formed thereof, and the concave portion is disposed on a vertex of a regular polygon connecting between convex-portion vertexes or on a side of the regular polygon (see FIGs. 2 and 5, etc.)

In the above-mentioned Embodiment, a generation position (flat portion) of a crystal nucleus is formed regularly in the position lower than the main surface, thereby actualizing threading dislocation amount suppression by defect starting point position control and increase in the area on the concave-convex structure side, and semiconductor light emitting devices having excellent luminous efficiency are actualized, through compatibility between the internal quantum efficiency IQE and the light extraction efficiency LEE.

Further, the substrate for semiconductor light emitting device in this Embodiment is a substrate for semiconductor light emitting device using the optical substrate described above to develop epitaxial growth of a semiconductor crystal on the main surface, and is characterized in that the main surface has a plurality of epitaxial growth promotion portions, and a plurality of epitaxial growth suppression portions to be comprised thereof, peripheries of the epitaxial growth promotion portions are enclosed by the epitaxial growth suppression portions, the epitaxial growth suppression portions are comprised of at least a plurality of the convex portions and the inter-convex bottom portions, and that the epitaxial growth promotion portions are the toothless portions, and have planes parallel with the main surface (see FIG. 15, etc.).

In this Embodiment, in a plurality of the epitaxial growth promotion portions, distances Pe among a plurality of nearest-neighbor epitaxial growth promotion portions are preferably mutually equal (see FIGs. 15 and 17).

Further, distances Pe among the nearest-neighbor epitaxial growth promotion portions of the epitaxial growth promotion portions and period Pn among a plurality of the convex portions constituting the epitaxial growth suppression portions preferably meet the following equation (1) (see FIGs. 15 and 17, etc.).

$$1.5Pe \leq Pe/Pn \leq 30 \quad \text{Equation (1)}$$

Furthermore, the area ratio of the epitaxial growth promotion portions to the main surface preferably ranges from 0.001 to 0.2.

Moreover, the substrate for semiconductor light emitting device in this Embodiment is a substrate for semiconductor light emitting device using the optical substrate described above to develop epitaxial growth of a semiconductor crystal on the main surface, and is characterized in that the main surface has a plurality of epitaxial growth promotion portions, and a plurality of epitaxial growth suppression portions to be comprised thereof, peripheries of the epitaxial growth suppression portions are enclosed by the epitaxial growth promotion portions, or the epitaxial growth suppression portions are sandwiched between the epitaxial growth promotion portions, the epitaxial growth suppression portions are comprised of at least a plurality of convex portions and inter-convex bottom portions, and that the epitaxial growth promotion portions are the toothless portions, and have planes parallel with the main surface.

Further, it is preferable that the epitaxial growth promotion portions are concave portions having flat planes in positions lower than the main surface formed of the inter-convex bottom portions, and are concave portions having planes parallel with the main surface as bottom portions.

In this Embodiment, the area ratio of the epitaxial growth suppression portions to the main surface preferably ranges from 0.80 to 0.999.

Further, the epitaxial growth suppression portions are preferably comprised of at least a plurality of the convex portions periodically disposed (see FIG. 31A and 31B).

Furthermore, it is preferable that the substrate for semiconductor light emitting device is a single crystal substrate having a crystal structure of hexagonal system, and that a nearest-neighbor direction of a plurality of nearest-neighbor epitaxial growth suppression portions is not parallel with an m-plane of the crystal structure of the substrate for semiconductor light emitting device.

Moreover, the semiconductor light emitting device in this Embodiment is characterized by having the optical substrate as described above, or the substrate for semiconductor light emitting device as described above, and the layered semiconductor layer formed by layering at least two or more semiconductor layers and the light emitting layer, layered on the main surface side.

Further, the growth substrate in this Embodiment is characterized in that the substrate is provided with at least the first main surface, the first main surface has growth promotion portions (epitaxial growth promotion portions) and

growth suppression portions (epitaxial growth suppression portions), and that the growth promotion portions and the growth suppression portions meet the following requirements A to C (see FIG. 33A, 33B and 33C).

A. Peripheries of a scattered plurality of the growth promotion portions are enclosed by the growth suppression portions; peripheries of a plurality of the growth suppression portions are enclosed by the growth promotion portions, or the growth suppression portions are sandwiched between the growth promotion portions;
B. arithmetic average roughness Ra with respect to the growth suppression portions is 5 nm or less; and
C. arithmetic average roughness Ra with respect to the growth promotion portions is 1.5 nm or less.

Furthermore, it is preferable that the growth suppression portions have a plurality of concavo-convex structures to be comprised thereof, and that a duty of the concavo-convex structures is 0.85 or more.

Still furthermore, it is preferable that the growth promotion portions are periodically disposed (see FIG. 33A, 33B and 33C).

Moreover, the growth substrate in this Embodiment is characterized in that the substrate is provided with at least the first main surface, the first main surface has growth promotion portions and growth suppression portions, and that the growth promotion portions and the growth suppression portions concurrently meet the following requirements a to d (see FIG. 36A, 36B and 36C).

a. Peripheries of a scattered plurality of the growth promotion portions are enclosed by the growth suppression portions; peripheries of a plurality of the growth suppression portions are enclosed by the growth promotion portions, or the growth suppression portions are sandwiched between the growth promotion portions;
b. the growth suppression portions are comprised of a plurality of concavo-convex structures;
c. the growth suppression portions and the growth promotion portions are periodically arranged; and
d. a period unit A comprised of the growth promotion portions and the growth suppression portions is arbitrarily selected, and when the period unit $\alpha$ is overlapped with another period unit $\beta$ arbitrarily selected, a matching rate of a concavo-convex structure S-$\alpha$ included in the period unit $\alpha$ and a concavo-convex structure S-$\beta$ included in the period unit $\beta$ to the first main surface by a projection area ranges from 0.60 to 0.99.

Further, the semiconductor light emitting device in this Embodiment is characterized in that the device is a semiconductor light emitting device with at least the first semiconductor layer, light emitting semiconductor layer, second semiconductor layer and transparent conductive film layered on the growth substrate with the concavo-convex structure formed on a part or the whole of one main surface, the concavo-convex structure has growth promotion portions (epitaxial growth promotion portions) and growth suppression portions (epitaxial growth suppression portions) to be comprised of, and is configured by any of that peripheries of a scattered plurality of the growth promotion portions are enclosed by the growth suppression portions, peripheries of a plurality of the growth suppression portions are enclosed by the growth promotion portions, and that the growth suppression portions are sandwiched between the growth promotion portions, and that the thickness (T_TE) of the transparent conductive film ranges from 30 nm to 100 nm (see FIG. 41).

[Examples]

The present invention will be described below more specifically based on Examples performed to clarify the effects of the present invention. In addition, the present invention is not limited by the following Examples at all.

[Examples 1 to 3]

First, a substrate (optical substrate) for LED was prepared. A pattern of the substrate for LED was prepared using a nano-processing sheet. The nano-processing sheet will be described later. A c-plane sapphire of 2 inches with a mirror plane on one side was prepared and cleaned. Then, the sapphire was disposed on a hot plate at 120°C. Next, the nano-processing sheet was bonded to the sapphire, using a laminate roll heated to 120°C. Bonding was performed at a pressure of 0.5 MPa and at a linear velocity of 50 mm/sec. The sapphire with the nano-processing sheet bonded was irradiated with ultraviolet light over the sapphire. The ultraviolet light was applied from a UV-LED light source with a wavelength of 365 nm, and was set so that the integral light amount was 1500 mJ/$cm^2$. Next, the nano-processing sheet and sapphire were nipped between two parallel plates heated to 120°C. The pressure in the nip was 0.3 MPa, and the time was 10 seconds. Then, the resultant was cooled to room temperature by air cooling, and the nano-processing sheet was peeled off from the sapphire at a velocity of 50 mm/sec. By the above-mentioned operation, a two-layer resist layer was transferred and added onto the main surface of the sapphire. The main surface of the resist layer was provided with a concavo-convex structure. The pattern of the substrate for LED was controlled by the shape and arrangement of the concavo-convex structure, layer composition of the two-layer resist and dry etching conditions described below.

The nano-processing sheet is a compact for enabling a processing mask to be transferred and added onto a workpiece by bonding operation and peeling operation. As the composition, the sheet is comprised of a mold made of resin, first resist layer and second resist layer. The resin mold has a concavo-convex structure on the main surface, and the inside of the concave portion of the concavo-convex portion is filled with the first resist layer. Then, the second resist layer was disposed so as to flatten the concavo-convex structure of the resin mold and the first resist layer.

First, the mold made of resin was manufactured, using a photo-nanoimprint method of roll-to-roll. The width was 500 mm, and the length was 180 m. As a layer composition, provided was the composition where a transfer layer with a thickness of 1.5 μm was present on an easy adhesion surface of a PET film with a thickness of 50 μm, and the concavo-convex structure transferred by the photo-nanoimprint method was present on the main surface of the transfer layer. Further, a contact angle of a water droplet with respect to the concavo-convex structure surface of the resin mold was between 140° and 153°.

Materials of the transfer layer were a mixture described below.

(Transfer layer)

Materials obtained by mixing Fluorine-containing urethane (meth)acrylate (OPTOOL DAC HP (made by Daikin Industries, Ltd.)) : Trimethylolpropane (EO-modified) triacrylate (M350 (made by TOAGOSEI Co., Ltd.)): 1-Hydroxy-cyclohexyl-phenyl-ketone (Irgacure (Registered Trademark) 184 (made by BASF Company)): 2-Benzyl-2-dimethylamino-1-(4-morpholino phenyl) -butanone-1 (Irgacure (Registered Trademark) 369 (made by BASF Company))=17.5g:100g:5.5g:2.0g

Next, the first resist layer was formed on the concave-convex structure of the resin mold by a die coat method. The first resist layer was obtained by mixing compounds shown below, and the titanium-containing organic-inorganic complex resist of the composition was prepared.

(First resist layer)

Materials obtained by preparing Titanium tetrabutoxide monomer (made by Wako Pure Chemical Industries, Ltd.): 3-Acryloxypropyl trimethoxysilane (made by Shin-Etsu silicone corporation) : Phenyl-modified silicone (made by Dow Corning Toray Co., Ltd.): 1-Hydroxy-cyclohexyl-phenyl-ketone (Irgacure 184, made by BASF Company): 2-Benzyl-2-dimethylamino-1-(4-morpholino phenyl)-butanone-1 (Irgacure 369, made by BASF Company)= 65.2g:34.8g:5.0g:1.9g:0.7g and diluting with propylene glycol monomethyl ether. Further, high molecular surface active agent KF-945 (made by Shin-Etsu Chemical Co., Ltd.) was added to be 0.000625 mass% to the solid content. It is supposed that the molecular weight of KF-945 is about 2500, and that the molecular structure is the following chemical formula (1).

[Chemistry 1]

Chemical formula (1)

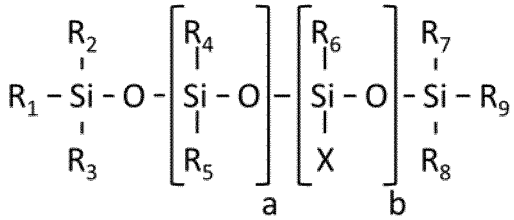

The titanium-containing organic-inorganic complex resist was diluted with a mixed solvent obtained by mixing a solvent A with surface tension of 24.0 mN/m or less, and a solvent B with surface tension of 27.0 mN/m or more to be a coating liquid. In coating by the die coat method, the pressure on the upstream side of die lips was reduced. The velocity of coating was 10 m/min, and by controlling a discharge amount, a filling amount of the first resist layer was controlled. After coating, air of 120°C was blown to dry, and subsequently, the resultant was wound and collected. Herein, the resin mold with the first resist layer formed was analyzed, and a state of the first resist layer was grasped. Analysis was performed using the scanning electron microscope, transmission electron microscope, and energy dispersive X-ray spectroscopy together. The first resist layer was charged inside the concave portion of the concavo-convex structure of the resin mold. On the other hand, a residue (aggregate) of the first resist layer of the order of several nanometers was sometimes observed on the top face of the convex portion of the concavo-convex structure of the resin mold, but

a thick film of the first resist layer was not formed on the tope face. Further, with respect to die coat film formation, it was ascertained that the filling amount of the first resist layer is varied by varying the discharge amount of the coating liquid, and that in association therewith, the filling diameter of the first resist layer is varied.

Next, the second resist layer was formed on the resin mold filled with the first resist layer. The film formation method was performed in the same manner as in the first resist layer. The second resist layer was of a mixture of the following composition, and was diluted with a solvent with surface tension of 25.0 mN/m or less to be a coating liquid.

(Second resist layer)

Materials obtained by mixing epoxy novolac resin with acryloyl group modification rate of 100%, dipentaerythritol polyacrylate, and 2,2-dimethoxy-1,2-diphenyethane-1-one in a ratio of 80g:20g:4.5g.

Drying was performed at 105°C. After drying, a PE/EVA protective film with haze (turbidity) of 10% or less was bonded, and the resultant was wound and collected. Herein, the manufactured nano-processing sheet was analyzed to grasp states of the first resist layer and second resist layer. Analysis was performed using the scanning electron microscope, transmission electron microscope, and energy dispersive X-ray spectroscopy together. The first resist layer was not changed prior and subsequent to film formation of the second resist layer. The second resist layer was formed to flatten the concavo-convex structure of the resin mold and the first resist layer. Further, it was ascertained that it is possible to control the film formation thickness by varying the discharge amount of die coat film formation. In other words, the filling diameter of the first resist layer and the film thickness of the second resist layer were varied, by controlling the discharge amount of die coat film formation.

Using the manufactured nano-processing sheet, as described already, the two-layer resist layer comprised of the first resist layer and second resist layer was transferred and added onto the main surface of the sapphire . Next, etching for processing the resist layer and etching for processing the sapphire was carried out successively inside the same chamber. An oxygen gas was used for etching of the resist layer. Herein, the first resist layer functioned as an etching mask of the second resist layer, and the second resist layer was etched until the main surface of the sapphire was partially exposed. The etching conditions were conditions with a processing gas pressure of 1 Pa and processing power of 300 W. Then, using a mixed gas of $BCl_3$ gas and $Cl_2$ gas, reactive ion etching was carried out to etch the sapphire. Herein, the second resist layer was an etching mask, and the sapphire was etched. The processing conditions were varied as appropriate, according to the pattern.

The etching-processed sapphire was removed, and was cleaned with a mixed solution of sulfuric acid and hydrogen peroxide solution in a weight ratio of 2:1. At this point, the temperature of the processing liquid was controlled to 100°C or more.

The pattern was formed on the main surface of the manufactured sapphire. It was possible to arbitrarily adjust the shape (diameter Φ of the convex portion bottom portion, height H) of the pattern, by the filling diameter of the first resist layer and the film thickness of the second resist layer of the nano-processing sheet and the processing conditions of dry etching.

As a buffer layer, a low-temperature growth buffer layer of $Al_xGa_{1-x}N$ ($0 \leq x \leq 1$) of 100 Å was deposited on the obtained sapphire substrate. Next, as an undoped first semiconductor layer, undoped GaN was deposited.

Subsequently, as a doped first semiconductor layer, Si-doped GaN was deposited on the obtained substrate. Next, a strain compensation layer was formed, and subsequently, as a light emitting semiconductor layer, an active layer (well layer, barrier layer=undoped InGaN, Si-doped GaN) of multi-quantum well was layered in respective film thicknesses (60 Å, 250 Å) alternately so that the well layer was six layers and that the barrier layer was seven layers. As a second semiconductor layer, Mg-doped AlGaN, undoped GaN and Mg-doped GaN were layered on the light emitting semiconductor layer so as to include an electron blocking layer, and a layered semiconductor layer was obtained.

Subsequently, as a transparent conductive film, ITO was deposited, and after the electrode formation process, leakage current was measured. With respect to 3000 LED devices or more obtained on the sapphire substrate of 2 inches, using an auto-prober, leakage current (Ir) was measured in applying -5 V (reverse bias) to between the p-electrode pad and the n-electrode pad.

Subsequently, the implementation process was performed. The sapphire substrate was polished to a thickness of 160 μm, and a reflecting layer was provided on the backside. As the reflecting layer, an Ag-Pd-Cu-based alloy was deposited. Subsequently, with respect to the semiconductor light emitting devices obtained via the cutting process, among 3000 semiconductor light emitting devices described previously, implementation was performed on 20 devices to obtain an average . By bonding to the gold-plated TO can with Ag paste and performing wire bonding, current was passed between the p-electrode and the n-electrode to measure light emission output. In addition, the size of the chip was 350 μm square, the current was 20 mA, and the luminous wavelength was 450 nm.

Evaluations were made in the following four items. First, by removing in the stage of depositing the first semiconductor layer on the optical substrate, surface flatness of the obtained semiconductor layer was observed in a field of vision of 200 μm by AFM, and root-mean-square surface roughness (RMS) of this point was measured. The case

where the RMS was 10 nm or less was made good. Next, the X-ray rocking curve was acquired, and the full width at half maximum (XRC-FWHM) with respect to GaN (102) was acquired. Herein, 350 arcsec or less was judged as good. Further, the leakage current inside the substrate plane was measured in applying -5 V, and 0.01 mA or less was made good. Finally, with respect to the obtained semiconductor light emitting device, light output thereof was measured by integrating sphere.

[Comparative Example 1]

Comparative Example 1 was the case of hexagonal arrangement with the average pitch of 700 nm. The distance (width of the flat portion) between convex portion bottom portions was 50 nm and thus narrow, the concave portion as an easy growth portion did not exist, crystallinity was thereby poor, and as shown in the following Table 2, it was understood that surface roughness after deposition, and leakage current was large.

[Comparative Example 2]

Comparative Example 2 was the optical substrate without the concave portion substantially existing, prepared by wet etching with a solution of phosphoric acid: sulfuric acid=1:1, using a mask (the mask herein was a resist different from Examples and Comparative Example 1) provided with toothless portions in a three-times hexagonal point arrangement. In this case, the toothless portion of the mask was the flat portion on the optical substrate, and was the easy growth portion, crystallinity was thereby improved as compared with Comparative Example 1, but the degree was small, and it was understood that the main surface after deposition was rough and that the leakage current was large.

In Example 1, although the resist having the same toothless arrangement as in Comparative Example1 was used, the optical substrate was prepared by dry etching, and was provided with the concave portion as the easy growth portion. It was understood that crystallinity is improved as compared with Comparative Example 1, by the concave portion as the easy growth portion having a predetermined depth. Then, since the concave-portion side portion has an angle different from that in the flat portion, it is supposed that the light extraction efficiency is improved, and that output as the device is improved.

Example 2 was the optical substrate provided with the concave portion as the easy growth portion, prepared by dry etching using a resist provided with the toothless portion in the three-times hexagonal side arrangement. In this case, it was understood that crystallinity is improved, by providing the concave portion as the easy growth portion. Further, since the concave-portion side portion has an angle different from that in the flat portion, it is supposed that the light extraction efficiency is improved, and that output as the device is improved.

Further, flatness is high, and the leakage current is capable of being suppressed. It is supposed this is because in-plane uniformity is high in the obtained semiconductor light emitting device.

Example 3 was the case where the length of one side was $2\sqrt{3}P0$ in the arrangement shown in FIG. 10. In addition, the height of the convex portion formed in the lower surface of the semiconductor layer was 40 nm. As shown in Table 2, light emission output is improved by improving the light extraction efficiency LEE, while keeping crystallinity high, and it was understood that surface roughness is also good, and that the yield is also high.

[Table 2]

| | Average pitch P0 /nm | Toothless arrangement | Convex portion height H /nm | Convex portion bottom portion width D /nm | Convex portion duty | Concave portion depth lo_d/nm | FWHM (102) /arcsec | Surface after deposition RMS /nm | Leakage current /mA | Light emission output ratio | Total |
|---|---|---|---|---|---|---|---|---|---|---|---|
| Example 1 | 700 | Three-times hexagonal point arrangement | 480 | 630 | 0.90 | 50 | 310 | 8.8 | <0.01 | 1.05 | ○ |
| Example 2 | 700 | Three-times hexagonal side arrangement | 350 | 660 | 0.94 | 300 | 295 | 8.1 | <0.01 | 1.10 | ○ |
| Example 3 | 700 | 2√3-times trigonal point arrangement | 350 | 660 | 0.94 | 40 | 303 | 8.2 | <0.01 | 1.06 | ○ |
| Comparative Example 1 | 700 | None (Hexagonal arrangement) | 470 | 650 | 0.93 | - | 412 | 19.7 | ~0.1 | 0.97 | × |
| Comparative Example 2 | 700 | Three-times hexagonal point arrangement | 480 | 630 | 0.90 | - | 380 | 15.2 | ~0.1 | 1.00 | × |

[Example 4]

As in Example 1, a dry film resist layer with a convex-shaped mask pattern formed was formed on the surface of the C-plane main surface of a sapphire single crystal substrate with a diameter of 2 inches with one-side mirror finish with the C-plane as the main surface, by the dry film resist imprint lithography method using the nano-processing sheet described previously.

The formed mask pattern was the same convex pattern as shown in FIG. 25, where the convex portion is disposed in the hexagonal lattice with a lattice constant of a pitch of 0.70 μm, and the plane portion without the convex pattern being provided is positioned in each vertex of the regular hexagon with one side of 1.40 μm and is disposed repeatedly.

Convex mask diameter: 0.62 μm
Convex mask height: 1.47 μm
Convex mask pitch (Pn): 0.70 μm
Inter-convex mask plane portion pitch (Pe) : 1.40 μm

Next, using an ICP dry etching apparatus, with the mask pattern as a mask, reactive ion etching was performed using a mixed gas of $BCl_3$ gas and $Cl_2$ gas, and the sapphire substrate was etched. The processing conditions were ICP : 150 W, BIAS: 50 W, pressure 0.2 Pa.

The etching-processed sapphire substrate was cleaned at 100°C or more, using an SPM solution obtained by mixing sulfuric acid and hydrogen peroxide solution in a weight ratio of 2:1.

When the surface of the sapphire substrate obtained by the above-mentioned operation was observed with an electron microscope, the surface had the convex portion and plane portion in the same placement as in the convex mask pattern (FIG. 42A). In addition, FIG. 43A is a schematic diagram illustrating a part of FIG. 42A.

Convex portion diameter: 0.66 μm
Convex portion height: 0.38 μm
Convex portion pitch (Pn): 0.70 μm
Inter-convex portion plane portion pitch (Pe): 1.40 μm

(Electron microscope)

Apparatus; HITACHI s-5500
Acceleration voltage; 10 kV
MODE; Normal

[Example 5]

The sapphire substrate prepared in Example 4 was placed inside a MOCVD apparatus to prepare LEDs. First, the substrate was heated in an atmosphere of hydrogen, and the surface was cleaned. Then, the low-temperature growth buffer layer of $Al_xGa_{1-x}N$ ($0 \leq x \leq 1$) was deposited in 200 Å. Next, an undoped GaN layer was deposited, the raw material composition ratio, deposition temperature and deposition pressure were adjusted as appropriate, and while filling the concavities and convexities on the surface of the sapphire substrate with the GaN layer, a flattened undoped GaN layer was obtained.

The crystal quality of the undoped GaN layer was evaluated, by measuring the X-ray rocking curve full width at half maximum (XRC-FWHM) of GaN (102).

(XRC)

Apparatus: X-Ray diffractometer-SmartLab
(made by Rigaku)
Tube voltage: 45 keV
Tube current: 200 mA

Next, as an n-type GaN layer, Si-doped GaN was deposited. Next, a strain compensation layer was provided. Subsequently, as a light emitting layer, an active layer of multi-quantum well was deposited. The light emitting layer was comprised of well layers and barrier layers comprised of undoped InGaN and Si-doped GaN. Further, respective film thicknesses were set at 25 Å and 130 Å, and the layers were alternately layered so that the well layer was six layers and that the barrier layer was seven layers. On the light emitting layer, Mg-doped AlGaN, undoped GaN and Mg-doped GaN were layered so as to include an electron blocking layer. Next, ITO was deposited, and after etching processing, electrode pads were attached to obtain the LED of this Embodiment.

[Example 6]

On the surface of the C-plane main surface of a sapphire single crystal substrate with a diameter of 2 inches with one-side mirror finish with the C-plane as the main surface, a dry film resist layer with a convex-shaped mask pattern formed was formed, by the dry film resist imprint lithography method.

The formed mask pattern was the same convex pattern as shown in FIG. 25, where the convex portion is disposed in the hexagonal lattice with a lattice constant of a pitch of 1.20 μm, and the plane portion without the convex pattern being provided is positioned in each vertex of the regular hexagon with one side of 2.40 μm and is disposed repeatedly.

Convex mask diameter: 1.00 μm
Convex mask height: 1.55 μm
Convex mask pitch (Pn): 1.20 μm
Inter-convex mask plane portion pitch (Pe) : 2.40 μm

Next, as in Example 1, using the ICP dry etching apparatus, with the mask pattern as a mask, the sapphire substrate was etched, and then, was cleaned.

When the surface of the obtained sapphire substrate was observed with the electron microscope, the surface had the convex portion and plane portion in the same placement as in the convex mask pattern.

Convex portion diameter: 1.19 μm
Convex portion height: 0.65 μm
Convex portion pitch (Pn): 1.20 μm
Inter-convex portion plane portion pitch (Pe): 2.40 μm

(Electron microscope)

Apparatus; HITACHI s-5500
Acceleration voltage; 10 kV
MODE; Normal

Next, as in Example 5, the GaN layer and the like were formed to obtain the LED of the present invention.

Among the semiconductor light emitting devices obtained from the 2inches substrate as described above, implementation was performed on 20 devices to obtain an average of light emission output. By bonding to the gold-plated TO can with Ag paste and performing wire bonding, the p-electrode pad and the n-electrode pad were connected, and sealing was performed in the shape of a semi-sphere with a resin with a refractive index of 1.46. The current was passed through the device to measure light emission output. In addition, the size of the chip was 350 μm square, the current was 20 mA, and the luminous wavelength was 450 nm.

Further, the crystal quality of the undoped GaN layer was evaluated, by measuring the X-ray rocking curve full width at half maximum (XRC-FWHM) of GaN (102). The result is shown in the following Table 3.

[Comparative Example 3]

The sapphire single crystal substrate with the C-plane as the main surface in one-side mirror finish as in Example 4 was prepared, and a dry film resist layer with a convex-shaped mask pattern formed was formed, by the dry film resist imprint lithography method.

The formed mask pattern was the convex pattern of a simple hexagonal lattice.

Convex mask diameter: 0.62 μm
Convex mask height: 1.47 μm
Convex mask pitch (Pn): 0.70 μm

Next, as in Example 4, using the ICP dry etching apparatus, with the mask pattern as a mask, reactive ion etching was performed using the mixed gas of $BCl_3$ gas and $Cl_2$ gas, and the sapphire substrate was etched. At this point, etching conditions were adjusted, so that the diameter of the convex portion obtained on the sapphire diameter was smaller than in Example 1.

The etching-processed sapphire substrate was cleaned, using the SPM solution obtained by mixing sulfuric acid and hydrogen peroxide solution in a weight ratio of 2:1. The temperature of the processing solution was controlled to 100°C or more.

When the surface of the sapphire substrate obtained by the above-mentioned operation was observed with the electron microscope, the surface had the convex portion and plane portion in the same placement as in the convex mask pattern (FIG. 42B). FIG. 43B is a schematic diagram illustrating a part of FIG. 42B.

Convex portion diameter: 0.60 μm
Convex portion height: 0.34 μm

Next, as in Example 5, on the surface of the sapphire substrate, using the MOCVD apparatus, a flat undoped GaN layer was formed on the surface of the sapphire substrate. Table 3 shows a measurement result of XRC-FWHM of the obtained undoped GaN layer.

[Comparative Example 4]

The sapphire single crystal substrate with the C-plane as the main surface in one-side mirror finish as in Example 4 was prepared, and a dry film resist layer with a convex-shaped mask pattern formed was formed, by the dry film resist imprint lithography method.

The formed mask pattern was the same convex pattern as in Example 4, where the convex portion is disposed in the hexagonal lattice with the hexagonal lattice of a pitch of 0.70 μm, and the plane portion without the convex pattern being provided is positioned in each vertex of the regular hexagon with one side of 1.40 μm.

Convex mask diameter: 0.62 μm
Convex mask height: 1.47 μm
Convex mask pitch (Pn): 0.70 μm
Inter-convex mask plane portion pitch (Pe) : 1.40 μm

Next, as in Example 4, using the ICP dry etching apparatus, with the mask pattern as a mask, reactive ion etching was performed using the mixed gas of $BCl_3$ gas and $Cl_2$ gas, and the sapphire substrate was etched. At this point, etching conditions were adjusted, so that the diameter of the convex portion formed on the sapphire diameter was smaller than in Example 4.

The etching-processed sapphire substrate was cleaned, using the SPM solution obtained by mixing sulfuric acid and hydrogen peroxide solution in a weight ratio of 2:1. The temperature of the processing solution was controlled to 100°C or more.

When the surface of the sapphire substrate obtained by the above-mentioned operation was observed with the electron microscope, the surface had the convex portion and plane portion in the same placement as in the convex mask pattern (FIG. 42C). In addition, FIG. 43C is a schematic diagram illustrating a part of FIG. 42C.

Convex portion diameter: 0.60 μm
Convex portion height: 0.34 μm
Convex portion pitch (Pn): 0.70 μm
Inter-convex portion plane portion pitch (Pe): 1.40 μm

Next, as in Example 5, on the surface of the sapphire substrate, using the MOCVD apparatus, a flat undoped GaN layer was formed on the surface of the sapphire substrate. Table 3 shows a measurement result of XRC-FWHM of the obtained undoped GaN layer.

[Comparative Example 5]

The sapphire single crystal substrate with the C-plane as the main surface in one-side mirror finish as in Example 1 was prepared, a dry film resist layer with a convex-shaped mask pattern formed was formed by the dry film resist imprint lithography method, and then, by dry etching, the sapphire substrate with the following convex portion and plane portion was obtained.

Convex portion diameter: 1.19 μm
Convex portion height: 0.65 μm
Convex portion pitch (Pn): 1.20 μm

Next, as in Example 6, the GaN layer and the like were formed to obtain the LED of the present invention.
Further, as in Example 6, among the semiconductor light emitting devices obtained from the 2 inches substrate, implementation was performed on 20 devices to obtain an average of light emission output. By bonding to the gold-plated TO can with Ag paste and performing wire bonding, the p-electrode pad and the n-electrode pad were connected, and sealing was performed in the shape of a semi-sphere with the resin with a refractive index of 1.46. The current was passed through the device to measure light emission output. In addition, the size of the chip was 350 μm square, the current was 20 mA, and the luminous wavelength was 450 nm.
Further, the crystal quality of the undoped GaN layer was evaluated, by measuring the X-ray rocking curve full width at half maximum (XRC-FWHM) of GaN (102). The result is shown in the following Table 3.

[Table 3]

| | GaN(102) XRC FWHM /arcsec | Light emission output ratio |
|---|---|---|
| Example 5 | 347 | |
| Example 6 | 280 | 1.21 |
| Comparative Example 3 | 608 | |
| Comparative Example 4 | 506 | |
| Comparative Example 5 | 498 | 1 |

From Table 3, it was understood that the XRC-FWHM of the obtained undoped GaN layer in the substrate for semiconductor light emitting device of the Examples is significantly smaller than the XRC-FWHM of the GaN layer obtained in the substrate for semiconductor light emitting device in conventional techniques. There is correlation between the FWHM of the GaN (102) obtained from the XRC and the crystal dislocation defect density, and when the value is small, the GaN is regarded as the GaN layer of good crystal quality with a low crystal dislocation defect density. The GaN (102) with 350 arcsec represents substantially the GaN layer having the good crystal quality.
In the layered semiconductor layer formed on the undoped GaN layer, because of the same crystal lattice, crystal dislocation defects existing in the undoped GaN layer do not disappear and has almost the same crystal dislocation defect density. In other words, the layered semiconductor layer of good crystal quality is obtained from the undoped GaN layer with a low crystal dislocation defect density, and it is possible to exhibit high internal quantum efficiency in the obtained LED.
Further, from Table 3, in the LED obtained from the substrate for semiconductor light emitting device of the Examples, the layered semiconductor layer of good crystal quality was obtained, and the obtained LED exhibited light emission output with high efficiency.

[Examples 7 to 9, and Comparative Examples 6 to 9]

As in Example 1, the pattern was formed on the main surface of the sapphire substrate. It was possible to arbitrarily adjust the shape (diameter Φ of the convex portion bottom portion, height H) of the pattern, by the filling diameter of the first resist layer and the film thickness of the second resist layer of the nano-processing sheet and the processing conditions of dry etching.
As the buffer layer, the low-temperature growth buffer layer of $Al_xGa_{1-x}N$ ($0 \leq x \leq 1$) of 100 Å was deposited on the obtained sapphire substrate. In addition, as the Comparative Example, subsequent deposition was performed, including a commercially available sapphire substrate with a pattern. Next, as the undoped first semiconductor layer, undoped GaN was deposited.

The substrate was removed in this state, surface flatness of the obtained semiconductor layer was observed in a field of vision of 200 μm by AFM, root-mean-square surface roughness (RMS) of this point was measured and compared to evaluate, and the case where the RMS was 10 nm or less was judged as being good.

Subsequently, as the doped first semiconductor layer, Si-doped GaN was deposited on the obtained substrate. Next, the strain compensation layer was formed, and subsequently, as the light emitting semiconductor layer, the well layer (undoped InGaN) and barrier layer (Si-doped GaN)constituting the active layer of multi-quantum well were layered alternately in respective film thicknesses (60 Å, 250 Å) so that the well layer was six layers and that the barrier layer was seven layers. Further, as the second semiconductor layer, Mg-doped AlGaN, undoped GaN and Mg-doped GaN were layered on the light emitting semiconductor layer so as to include the electron blocking layer, and a layered semiconductor layer was obtained.

Subsequently, as the transparent conductive film, ITO was deposited, and after the electrode formation process, leakage current was measured. With respect to 3000 LED devices or more obtained on the sapphire substrate of 2 inches, using the auto-prober, leakage current (Ir) was measured in applying -5 V (reverse bias) to between the p-electrode pad and the n-electrode pad. The rate (%) of devices where the leakage current in this measurement was less than 0.01 mA was measured as a yield (%).

The internal quantum efficiency IQE was greatly affected by the density of crystal defects. Accordingly, crystallinity evaluations were made by X-rays. In other words, the X-ray rocking curve was acquired, and the full width at half maximum (XRC-FWHM) with respect to GaN (102) was acquired.

Subsequently, the implementation process was performed. The sapphire substrate was polished to a thickness of 160 μm, and a reflecting layer was provided on the backside. As the reflecting layer, the Ag-Pd-Cu-based alloy was deposited. Subsequently, with respect to the semiconductor light emitting devices obtained via the cutting process, among 3000 semiconductor light emitting devices described previously, implementation was performed on 20 devices to obtain an average . By bonding to the gold-plated TO can with Ag paste and performing wire bonding, current was passed between the p-electrode and the n-electrode to measure light emission output. In addition, the size of the chip was 350 μm square, the current was 20 mA, and the luminous wavelength was 450 nm.

Comparative Example 6 was a semiconductor light emitting device prepared from the commercially available sapphire substrate with the pattern. Both the crystallinity and the surface roughness were good, the leakage current was low, and the yield was 80%. As shown in the following Table 4, the light emission output was made "1", and light emission output of each sample was normalized.

Comparative Example 7 was the case of hexagonal arrangement with the average pitch of 700 nm. The bottom portion diameter D of the convex portion 3 of the concavo-convex structure was 450 nm, and the duty was 0.64. Since the flat portion was high in number, association of nuclei effectively occurred in crystal growth, both the crystallinity and the surface roughness were good, the leakage current was low, and the yield was equal to the commercially available sapphire substrate with the pattern. However, on the optical substrate side that corresponds the growth plane of the semiconductor layer, since the flat portion that corresponds to the bottom portion of the concave-shaped portion is high in number, improvement in light extraction efficiency LEE was small, and as shown in the following Table 4, it was understood that the light emission output ratio was smaller than in the commercially available sapphire substrate with the pattern.

Comparative Example 8 was the case of hexagonal arrangement with the average pitch of 700 nm and the bottom portion diameter was larger than in Comparative Example 6. Specifically, the bottom portion diameter was set at 660 nm, and the duty was thereby increased to 0.94. Since the flat portion was low in number on the main surface side of the optical substrate, improvement in light extraction efficiency LEE was expected, the internal quantum efficiency IQE was lowered as compared with Comparative Example 7 in association with decrease in crystallinity in deposition of the semiconductor layer, and as shown in the following Table 4, it was understood that the light emission output ratio was smaller than in the commercially available sapphire substrate with the pattern.

In addition, in the above-mentioned Comparative Examples 7 and 8, the toothless portion in the Example was not formed.

In Example 7, based on the shape in Comparative Example 7, the concavo-convex structure was formed in the arrangement shown in FIG. 5. In other words, the toothless portion was regularly formed as shown in FIG. 5. In addition, the height of the convex portion formed on the lower surface of the semiconductor layer was 30 nm. Further, the repetition period L of the unit lattice (see FIG. 5) was 3P0 and 2100 nm. As shown in Table 3, as compared with Comparative Examples 7 and 8, by improving the light extraction efficiency LEE, while keeping the crystallinity high, the light emission output is improved, and it was understood that the surface roughness is also good, and that the yield is also high.

In Example 8, based on the shape in Comparative Example 7, the concavo-convex structure was formed in the arrangement shown in FIG. 25. In other words, the toothless portion was regularly formed as shown in FIG. 25. In addition, the height of the convex portion formed on the lower surface of the semiconductor layer was 30 nm. Further, the repetition period L of the unit lattice (see FIG. 5) was 2P0 and 1400 nm. As shown in Table 3, as compared with

Comparative Examples 7 and 8, by improving the light extraction efficiency LEE, while keeping the crystallinity high, the light emission output is improved, and it was understood that the surface roughness is also good, and that the yield is also high.

Example 9 was the case where the length of one side was 2√3P0 in the arrangement shown in FIG. 17. In addition, the height of the convex portion formed on the lower surface of the semiconductor layer was 30 nm. As shown in Table 4, by improving the light extraction efficiency LEE, while keeping the crystallinity high, the light emission output is improved, and it was understood that the surface roughness is also good, and that the yield is also high.

Comparative Example 9 was the case of decreasing the duty to 0.80 based on Example 7. In this case, a crystal nucleus was easy to form on the narrow flat portion between normal convex portions, selective crystal growth from the toothless portion was thereby not sufficiently exhibited, the crystallinity was lowered, and therefore, it is supposed that the internal quantum efficiency IQE was decreased. Further, since the rate occupied by the narrow flat portion was high, it is understood that improvement in light extraction efficiency LEE was small.

[Table 4]

| | Average pitch P0 /nm | Length L of one side /nm | Height /nm | Convex portion bottom portion diameter D /nm | duty | FWHM(1 02) /arcsec | Light emission output ratio | Surface after deposition RMS /nm | Yield | Total |
|---|---|---|---|---|---|---|---|---|---|---|
| Example 7 | 700 | 2100 (that corresponds to 3P0 in FIG. 5) | 320 | 660 | 0.94 | 268 | 1.05 | 7.9 | 79% | ○ |
| Example 8 | 700 | 1400 (that corresponds to 2P0 in FIG. 25) | 330 | 660 | 0.94 | 279 | 1.04 | 8.3 | 80% | ○ |
| Example 9 | 700 | 2√3*P0 of trigonal arrangement (2425 nm) | 330 | 660 | 0.94 | 273 | 1.04 | 8,2 | 78% | ○ |
| Comparative Example 6 | 3000 | - (Hexagonal arrangement) | 1550 | 2800 | 0.93 | 310 | 1.00 | 8.7 | 80% | × |
| Comparative Example 7 | 700 | - (Hexagonal arrangement) | 350 | 450 | 0.64 | 291 | 0.95 | 92 | 78% | × |
| Comparative Example 8 | 700 | - (Hexagonal arrangement) | 320 | 660 | 0.94 | 377 | 0.95 | 14.9 | 69% | × |
| Comparative Example 9 | 700 | 2100 (that corresponds to 3P0 in FIG. 5) | 330 | 560 | 0.80 | 390 | 0.89 | 15.5 | 65% | × |

[Examples 10 to 13, and Comparative Examples 10 and 11]

As in Example 1, the growth substrate was prepared, CVD deposition was performed on the substrate, and the primary layer was formed. Subsequently, the layered semiconductor was deposited, and the electrodes were formed to make the semiconductor light emitting device.
The prepared growth substrates are shown in Table 5.

[Table 5]

| | Growth promotion portion | | | Growth suppression portion | |
|---|---|---|---|---|---|
| | Placement | Period Pe/nm | Surface roughness Ra/nm | Surface roughness Ra/nm | Duty |
| Example 10 | A-1 | 3118 | 0.17 | 98 | 1.12 |
| Example 11 | A-1 | 6235 | 0.15 | 102 | 1.14 |
| Example 12 | A-2 | 1400 | 0.19 | 75 | 0.97 |
| Example 13 | A-1 | 1400 | 0.17 | 66 | 1.06 |
| Comparative Example 10 | A-1 | 3118 | 1.60 | 99 | 0.96 |
| Comparative Example 11 | A-1 | 3118 | 0.18 | 4 | 0.01 |

The substrate used in Example 10 is as described below, with the state A-1 where the growth promotion portions are scattered around the growth suppression portion. The growth promotion portions werepositioned in latticepoints of a regular trigonal lattice, and the period Pe of the growth promotion portions which was the side of the lattice was 3118 nm. Further, the surface roughness Ra of the growth promotion portion was 0.17 nm. The outside shape of the growth promotion portion was the shape where each corner portion was dented to draw an arc inward with respect to the regular hexagon, and each side drew 0 arc inward, and was the shape illustrated in FIG. 35A. On the other hand, the growth suppression portion was comprised of a plurality of convex portions, and the surface roughness Ra was 98 nm. The duty of the concavo-convex structure constituting the growth suppression portion was 1.12, and was in the state in which the diameter of the convex portion was larger than the period Pn of the concavo-convex structure. The convex portions were positioned in lattice points of regular trigonal lattices, and the outside shape of the convex portion bottom portion was a hexagon with rounded corner portions. The shape of the convex portion section was the shape where the diameter was thinned toward the vertex portion from the bottom portion, and the vertex portion of the convex portion was a rounded corner portion. A difference was 30 degrees between the direction of the regular triangle for defining the placement of the growth promotion portions and the direction of the regular triangle for determining the arrangement of the convex portions of the growth suppression portion. In addition, the ratio (Pe/Pn) of the distance Pe of the growth promotion portions to the distance Pn of the convex portions was 3.46.
The substrate used in Example 11 differed from the substrate of Example 10 described above only in the following respects. In other words, the period Pe of the growth promotion portions was 6235 nm. Further, the surface roughness Ra of the growth promotion portion was 0.15 nm. Furthermore, the surface roughness Ra of the growth suppression portion was 102 nm. The duty of the concavo-convex structure constituting the growth suppression portion was 1.14. The ratio (Pe/Pn) was 6.93.
The substrate used in Example 12 is as describedbelow, with the state A-2 where peripheries of the growth suppression portions are enclosed by the growth promotion portions. The growth promotion portions were positioned in lattice points and sides of the lattice where regular hexagons mutually shared only the sides and were closet packed. The period Pe of the growth promotion portions which was the side of the lattice was 1400 nm. Further, the surface roughness Ra of the growth promotion portion was 0.19 nm. Furthermore, the side of each regular hexagon had the protrusion portion in the convex shape downward from the center toward the outside, and the number thereof was "1" in each side vertically in the shape referred to FIG. 33B. On the other hand, the growth suppression portion was comprised of a plurality of convex portions, and the surface roughness Ra was 75 nm. Further, the duty of the concavo-convex structure constituting the growth suppression portion was 0.97, and was in the state in which the diameter of the convex portion was smaller than the period Pn of the concavo-convex structure. The convex portions were positioned in lattice points of regular trigonal lattices, and the outside shape of the convex portion bottom portion was an intermediate shape between a hexagon and a circle. The shape of the convex portion section was the shape where the diameter was thinned toward the vertex portion from the bottom portion, and the vertex portion of the convex portion was a rounded corner

portion. The direction of the hexagon for defining the placement of the growth promotion portions was the same as the direction of the hexagon made by regular triangles for determining the arrangement of the convex portions of the growth suppression portion. The ratio (Pe/Pn) was 2.

The substrate used in Example 13 is as described below, with the state A-1 where the growth promotion portions are scattered around the growth suppression portion. The growth promotionportions were positioned in lattice points of the lattice where regular hexagons mutually shared only the sides and were closet packed. The period Pe of the growth promotion portions which was the side of the lattice was 1400 nm. Further, the surface roughness Ra of the growth promotion portion was 0.17 nm. The outside shape of the growth promotion portion was the shape where each corner portion was dented to draw an arc inward with respect to the regular hexagon, and each side draws 0 arc inward, and was the shape illustrated in FIG. 35A. On the other hand, the growth suppression portion was comprised of a plurality of convex portions, and the surface roughness Ra was 66 nm. Further, the duty of the concavo-convex structure constituting the growth suppression portion was 1.06, and was in the state in which the diameter of the convex portion was larger than the period Pn of the concavo-convex structure. The convex portions were positioned in lattice points of regular trigonal lattices, and were a regular hexagon with rounded corner portions. The shape of the convex portion section was the shape where the diameter was thinned toward the vertex portion from the bottom portion, and the vertex portion of the convex portion was a rounded corner portion. The direction of the hexagon for defining the placement of the growth promotion portions was the same as the direction of the hexagon made by regular triangles for determining the arrangement of the convex portions of the growth suppression portion. The ratio (Pe/Pn) was 2.

The substrate used in Comparative Example 10 differed from the substrate of Example 10 described above only in the following respects. In other words, the surface roughness Ra of the growth promotion portion was 1.60 nm. Further, the surface roughness Ra of the growth suppression portion was 99 nm. Furthermore, the duty of the concavo-convex structure constituting the growth suppression portion was 0.96.

The substrate used in Comparative Example 11 differed from the substrate of Example 10 described above only in the following respects. In other words, the surface roughness Ra of the growth promotion portion was 0.18 nm. Further, the surface roughness Ra of the growth suppression portion was 4 nm. Furthermore, the duty of the concavo-convex structure constituting the growth suppression portion was 0.01.

The CVD process was applied to the growth substrate to manufacture the LED. First, the low-temperature growth buffer layer of $Al_xGa_{1-x}N$ ($0 \leq x \leq 1$) was deposited in 200 Å. Next, undoped GaN was deposited on the conditions that the temperature was in a range of 1100°C and 1200°C, V/III ratio was in a range of 240 to 280, and that an ammonia flow rate was in a range of 190 sccm to 220 sccm. Further, the deposition pressure was changed from a range of 400 Torr to 600 Torr to a range of 150 Torr to 250 Torr during the deposition to improve flatness of the primary layer. The low-temperature growth buffer layer and undoped GAN are also called the primary layer. Next, as the n-type GaN layer, Si-doped GAN was deposited. Next, the strain compensation layer was provided. Subsequently, as the light emitting layer, the active layer of multi-quantum well was deposited. The light emitting layer was comprised of the well layer and the barrier layer comprised of undoped InGaN and Si-doped GaN. Further, respective film thicknesses were 25 Å, 130 Å, and the well layer and the barrier layer were alternately layered so that the well layer was six layers and that the barrier layer was seven layers. Mg-doped AlGaN, undoped GaN and Mg-doped GaN were layered on the light emitting layer so as to include the electron blocking layer. Next, ITO was deposited, and after etching processing, electrode pads were attached.

Since it is grasped that the dislocation that is the crystal defect is correlated with the X-ray rocking curve, the crystal defect was evaluated by the X-ray rocking curve. The acquired data was the full width at half maximum XRC-FWHM with respect to GaN (102). The results are described in Table 6.

[Table 6]

| | GaN (102) XRC FWHM /arcsec |
|---|---|
| Example 10 | 337 |
| Example 11 | 342 |
| Example 12 | 291 |
| Example 13 | 283 |
| Comparative Example 10 | 689 |
| Comparative Example 11 | 581 |

From Table 6, it was understood that the XRC-FWHM of the GaN layer is significantly small in the growth substrates of the Examples, by suitably controlling the surface roughness Ra of each of the growth promotion portion

and the growth suppression portion. There is correlation between the FWHM of the GaN (102) obtained from the XRC and the dislocation density of the crystal, and when the value is small, the GaN is regarded as the GaN layer of good crystal quality with few crystal defects. The GaN (102) with 350 arcsec represents the GaN layer having the good crystal quality.

The layered semiconductor layer formed on the undoped GaN layer is of the same crystal lattice. Crystal defects existing in the undoped GaN layer do not disappear, and are of almost the same crystal defect density. In other words, the layered semiconductor layer of good crystal quality is obtained from the undoped GaN layer with few crystal defects. Accordingly, when the XRC-FWHM of the GaN (102) falls below 350 arcsec, it is possible to exhibit high internal quantum efficiency.

Using the growth substrates in the Examples and Comparative Examples, epitaxial film formation was repeatedly carrier out. One standard was that the XRC-FWHM of GaN (102) falls below 350 arcsec in the above-mentioned Examples. In the case of the Examples, even with the standard deviation taken, it was understood that the XRC-FWHM falls below 250 arcsec. From the foregoing, it is understood that it is possible to develop stable epitaxial growth capable of enduring the LED manufacturing process.

It is difficult to evaluate corruption of the waveguide mode inside the light emitting diode . In another study, light scattering with respect to the growth substrate was evaluated as turbidity. As a result, although being dependent on the arrangement of the growth promotion portions, it was ascertained that the turbidity is larger, as the surface roughness Ra of the growth suppression portion is larger, as a tendency. Particularly, the turbidity curve rose from the point where the surface roughness Ra of the growth suppression portion was about 5 nm, and started to be saturated from a range of 70 nm to 100 nm. Accordingly, it was understood that the growth substrates described in the Examples exhibit extremely strong light scattering properties. In other words, it is supposed that the effect of resolving the waveguide mode formed inside the light emitting diode is large.

[Examples 14 to 17, and Comparative Examples 12 and 13]

As in Example 1, the growth substrate was formed, CVD deposition was performed on the growth substrate, and the primary layer was formed. Subsequently, the layered structure was deposited, and the electrodes were formed to make the semiconductor light emitting device.

The prepared growth substrates are shown in Table 7.

[Table 7]

| | Growth promotion portion | | Growth suppression portion | Matching rate |
|---|---|---|---|---|
| | Placement | Period Pe/nm | Concave-convex structure | |
| Example 14 | A-1 | 3118 | convex portion • regular trigonal lattice | 0.93 |
| Example 15 | A-1 | 3118 | convex portion • regular trigonal lattice | 0.79 |
| Example 16 | A-2 | 1400 | convex portion • regular trigonal lattice | 0.97 |
| Example 17 | A-2 | 1400 | convex portion • regular trigonal lattice | 0.71 |
| Comparative Example 12 | A-1 | 3118 | convex portion • regular trigonal lattice | 0.43 |
| Comparative Example 13 | A-1 | 3118 | convex portion • regular trigonal lattice | 0.49 |

The substrate used in Example 14 is as described below, with the state A-1 where the growth promotion portions are scattered around the growth suppression portion. The growth promotionportions were positioned in lattice points of a regular trigonal lattice, and the period Pe of the growth promotion portions which was the side of the lattice was 3118 nm. On the other hand, the growth suppression portion was comprised of a plurality of convex portions with a pitch of 900 nm. The duty was 0.99, and was in the state in which the diameter of the convex portion was larger than the period Pn of the concavo-convex structure. The convex portions were positioned in lattice points of a regular trigonal lattice, and were circular. The shape of the convex portion section was the shape where the diameter was thinned toward the vertex portion from the bottom portion, and the vertex portion of the convex portion was a rounded corner portion. A difference was 30 degrees between the direction of the regular triangle for defining the placement of the growth promotion portions and the direction of the regular triangle for determining the arrangement of the convex portions of the growth suppression portion. Further, the matching rate was 0.93.

The substrate used in Example 15 was different, only in the matching rate, from the substrate in Example 14 as described above, and the matching rate was 0.79.

The substrate used in Example 16 is as describedbelow, with the state A-2 where peripheries of the growth

suppression portions are enclosed by the growth promotion portions. The growth promotion portions were positioned in lattice points and sides of the lattice where regular hexagons mutually shared only the sides and were closet packed. The period Pe of the growth promotion portions which was the side of the lattice was 1400 nm. The growth suppression portion was comprised of a plurality of convex portions with a pitch of 700 nm. The duty was 0.89, and was in the state in which the diameter of the convex portion was smaller than the period Pn of the concavo-convex structure. The convex portions were positioned in lattice points of regular triangle lattices, and the outside shape of the convex-portion bottom portion was circular. The shape of the convex portion section was the shape where the diameter was thinned toward the vertex portion from the bottom portion, and the vertex portion of the convex portion was a rounded corner portion. The direction of the hexagon for defining the placement of the growth promotion portions is the same as the direction of the hexagon made by regular triangles for determining the arrangement of the convex portions of the growth suppression portion. The matching rate was 0.97.

The substrate used in Example 17 was different, only in the matching rate, from the substrate in Example 16 as described above, and the matching rate was 0.71.

The substrate used in Comparative Example 12 was different, only in the matching rate, from the substrate in Example 14 as described above, and the matching rate was 0.43.

The substrate used in Comparative Example 13 was different, only in the matching rate, from the substrate in Example 14 as described above, and the matching rate was 0.49.

Next, the CVD process was applied to each substrate as in Example 1 to prepare the semiconductor light emitting device. Further, the crystal defect in each substrate was evaluated by the X-ray rocking curve. The acquired data was the full width at half maximum XRC-FWHM with respect to GaN (102). The results are described in Table 6.

[Table 8]

| | GaN (102) XRC FWHM /arcsec |
|---|---|
| Example 14 | 332 |
| Example 15 | 349 |
| Example 16 | 268 |
| Example 17 | 271 |
| Comparative Example 12 | 690 |
| Comparative Example 13 | 579 |

From Table 8, it is understood that the matching rate is an important factor. When the matching rate is small such as 0.43 and 0.49 as in the Comparative Examples, the XRC-FWHM is extremely large. The growth substrate in the epitaxial film formation process was removed, and was subjected to observation with the scanning electron microscope. As a result, in the case of using the growth substrates of the Comparative Examples, it was understood that the crystal grew abruptly from the growth suppression portion, and inhibited epitaxial growth from the growth promotion portion toward the growth suppression portion. In the case of the Examples, the XRC-FWHM is small. There is correlation between the FWHM of the GaN (102) obtained from the XRC and the dislocation density of the crystal, and when the value is small, the GaN is regarded as the GaN layer of good crystal quality with few crystal defects. The GaN (102) with 350 arcsec represents the GaN layer having the good crystal quality.

The layered semiconductor layer formed on the undoped GaN layer is the same crystal lattice. The crystal defects existing inside the undoped GaN layer do not disappear, and are of almost the same crystal defect density. In other words, the layered semiconductor layer of good crystal quality is obtained from the undoped GaN layer with few crystal defects. Accordingly, when the XRC-FWHM of GaN (102) falls below 350 arcsec, it is possible to exhibit high internal quantum efficiency.

Using the growth substrates in the Examples and Comparative Examples, epitaxial film formation was repeatedly carrier out. One standard was that the XRC-FWHM of GaN (102) falls below 350 arcsec in the above-mentioned Examples. In the case of the Examples, even with the standard deviation taken, it was understood the XRC-FWHM falls below 350 arcsec. From the foregoing, it is understood that it is possible to develop stable epitaxial growth capable of enduring the LED manufacturing process.

It is difficult to evaluate corruption of the waveguide mode inside the light emitting diode . In another study, light scattering with respect to the growth substrate was evaluated as turbidity. As a result, although being dependent on the arrangement of the growth promotion portions, the turbidity was comparable to the generally used Patterned Sapphire Substrate. Accordingly, it is understood that light scattering properties are extremely strong. In other words, it is supposed that the effect of resolving the waveguide mode formed inside the light emitting diode is large.

Next, with respect to Embodiment 16, studies were performed using only the duty as a variable, and optimization of the concave-convex structure of the growth suppression portion was carried out. The duty was changed to 0.5, 0.6, 0.7, 0.8, 0.85 and 0.9. As a result, it is found that the large criticality of the XRC-FWHM exists between the duties 0.8 and 0.85. More specifically, the XRC-FWHM was changed largely from 331 to 273. From the foregoing, by concurrently meeting the requirement that the duty of the concavo-convex structure constituting the growth suppression portion is 0.85 or more, it is understood that the IQE is more improved.

[Examples 18 to 21, and Comparative Examples 14 to 16]

As in Example 1, the growth substrate was prepared, CVD deposition was performed on the growth substrate, and the primary layer was formed. Subsequently, the layered structure was deposited, and the electrodes were formed to make the semiconductor light emitting device.

The prepared growth substrates are shown in Table 9.

[Table 9]

| | Average pitch Pn /nm | Arrangement of growth promotion portions | Convex portion height H /nm | Convex portion bottom portion width D /nm | Convex portion duty | Thickness of transparent conductive film T_TE /nm | FWHM (102) /arcsec | Light emission output ratio | Total |
|---|---|---|---|---|---|---|---|---|---|
| Example 18 | 1200 | Fig.39 | 480 | 1150 | 0.96 | 60 | 315 | 1.05 | ○ |
| Example 19 | 1200 | Fig.24 | 450 | 1180 | 0.98 | 60 | 293 | 1.06 | ○ |
| Example 20 | 1200 | Fig.39 | 500 | 1150 | 0.96 | 75 | 310 | 1.05 | ○ |
| Example 21 | 1200 | Fig.24 | 550 | 1150 | 0.96 | 45 | 329 | 1.05 | ○ |
| Comparative Example 14 | 1200 | None (Hexagonal arrangement) | 500 | 1150 | 0.96 | 60 | 498 | 0.87 | × |
| Comparative Example 15 | 1200 | Fig.39 | 510 | 1140 | 0.95 | 200 | 319 | 1.00 | × |
| Comparative Example 16 | 1200 | Fig.39 | 420 | 1130 | 0.94 | 15 | 324 | 0.94 | × |

As the film thickness of ITO, among the devices used in implement at ion after measuring the light emission output, images of three devices were taken by STEM to measure the length, and an arithmetic mean was obtained.

Evaluations were made in the following two items. First, by removing in the stage of depositing the first semiconductor layer on the optical substrate, the X-ray rocking curve was acquired, and the full width at half maximum (XRC-FWHM) with respect to GaN (102) was acquired. Herein, 350 arcsec or less was judged as good. Next, with respect to the obtained light emitting device, light output thereof was measured by integrating sphere.

Comparative Example 14 was the case of hexagonal arrangement with an average pitch of 1200 nm. The distance (width of the flat portion) between convex portion bottom portions was 50 nm and thus narrow, crystallinity was thereby poor because the growth promotion portion did not exist, and it was understood that performance was low as the semiconductor light emitting device.

Comparative Example 15 was the case of the device provided with the growth promotion portions in the arrangement shown in FIG. 39 with a transparent conductive layer thickness of 200 nm. The light output in this case was made "1". It is understood that crystallinity is improved as compared with Comparative Example 14, because the growth promotion portion exists.

Comparative Example 16 was the case of the same arrangement as in Comparative Example 15 with a transparent conductive layer thickness of 15 nm. The light emission output ratio in this case was lower than in Comparative Example 15. It is supposed that current is not effectively injected because the transparent conductive film is thin.

In Example 18, the arrangement of the growth promotion portions was the same as in Comparative Example 15, and a thickness of the transparent conductive film was in a predetermined range. It is understood that crystallinity is improved because of existence of the growth promotion portion, the light extraction efficiency is effectively improved because the thickness of the transparent conductive film is in a predetermined range, and that light output higher than in Comparative Example is thereby obtained.

In Example 19, the arrangement of the growth promotion portions was as shown in FIG. 24, and a thickness of the transparent conductive film was in a predetermined range. As in Example 18, it is understood that high light output is obtained.

In Examples 20 and 21, the arrangement of the growth promotion portions was the same as in Examples 18 and 19, respectively, and the thickness of the transparent conductive film was varied. As in Examples 18 and 19, it is understood that high light output is obtained.

In addition, the present invention is not limited to the above-mentioned Embodiment, and is capable of being carried into practice with various modifications thereof. In the above-mentioned Embodiment, the size, shape and the like shown in the figures are not limited thereto, and are capable of being modified as appropriate within the scope of exhibiting the effects of the invention.

## Industrial Applicability

According to the present invention, by a plurality of epitaxial growth promotion portions and a plurality of epitaxial growth suppression portions provided on the surface of the substrate for semiconductor light emitting device, crystal dislocation defects in the semiconductor layer formed on the substrate surface are decreased, the crystal quality is thereby improved, the internal quantum efficiency IQE is improved, and the waveguide mode is resolved by light scattering to enable the light extraction efficiency LEE to be increased. As a result, it is possible to improve the luminous efficiency of the LED. Accordingly, the substrate for semiconductor light emitting device and semiconductor light emitting device of the present invention have high luminous efficiency, enable effective use of power, and are capable of greatly contributing to energy saving.

The present application is based on Japanese Patent Applications No. 2015-195310, No. 2015-195311 and No. 2015-195314 filed on September 30, 2015, Japanese Patent Applications No.2015-232931, No. 2015-233916 and No. 2015-233917 filed on November 30, 2015, Japanese Patent Application No. 2015-248577 filed on December 21, 2015, and Japanese Patent Application No. 2016-125838 filed on June 24, 2016, entire contents of which are expressly incorporated by reference here.

## Claims

1. An optical substrate with a concavo-convex structure formed on a part or the whole of a main surface, wherein the concavo-convex structure has regular toothless portions.

2. The optical substrate according to claim 1, wherein the concavo-convex structure is comprised of convex portions, inter-convex portion bottom portions, and a concave portion having a flat plane in a position lower than a main surface formed of the inter-convex bottom portions, and each of the toothless portions is the concave portion.

3. The optical substrate according to claim 1 or 2, wherein the convex portions are arranged with an average pitch P0, the toothless portions are disposed on vertexes of a regular polygon, or disposed on a side of the regular polygon connecting between the vertexes, and a length of the side of the regular polygon is longer than the average pitch P0.

4. The optical substrate according to any one of claims 1 to 3, wherein the length L of the side of the regular polygon is two times or more and five times or less the average pitch P0.

5. The optical substrate according to any one of claims 1 to 4, wherein each of a plurality of the toothless portions forming the concavo-convex structure is set on a placement position set in each lattice point of a regular triangle lattice as a new unit lattice of a regular hexagon, while being provided in a position that corresponds to a vertex or a side of the regular hexagon,.

6. The optical substrate according to any one of claims 1 to 4, wherein each of a plurality of the toothless portions forming the concavo-convex structure is set on a placement position set in each lattice point of a regular triangle lattice as a new regular tringle lattice, while being provided in a position that corresponds to a vertex of the newly set regular triangle.

7. The optical substrate according to any one of claims 1 to 6, wherein the toothless portions are disposed so that a straight line connecting between the toothless portions is orthogonal to crystal planes to be associated in crystal growth initialization among crystal planes of a semiconductor layer deposited on the optical substrate.

8. A substrate for semiconductor light emitting device using the optical substrate according to claim 1 to develop epitaxial growth of a semiconductor crystal on the main surface,
wherein the main surface has a plurality of epitaxial growth promotion portions, and a plurality of epitaxial growth suppression portions to be comprised thereof, peripheries of the epitaxial growth promotion portions are enclosed by the epitaxial growth suppression portions,
the epitaxial growth suppression portions are comprised of at least a plurality of convex portions and inter-convex bottom portions, and
the epitaxial growth promotion portions are the toothless portions, and have planes parallel with the main surface.

9. The substrate for semiconductor light emitting device according to claim 8, wherein each of the epitaxial growth promotion portions is a concave portion having a flat plane in a position lower than the main surface formed of the inter-convex bottom portions, and is the concave portion having a plane parallel with the main surface as a bottom portion.

10. The substrate for semiconductor light emitting device according to claim 8 or 9, wherein in a plurality of the epitaxial growth promotion portions, distances Pe among a plurality of nearest-neighbor epitaxial growth promotion portions are mutually equal.

11. The substrate for semiconductor light emitting device according to claim 10, wherein distances Pe among the nearest-neighbor epitaxial growth promotion portions of the epitaxial growth promotion portions and a period Pn of a plurality of the convex portions constituting the epitaxial growth suppression portions meet the following equation (1).

$$1.5 \leq Pe/Pn \leq 30 \qquad \text{Equation (1)}$$

12. The substrate for semiconductor light emitting device according to any one of claims 8 to 11, wherein an area ratio of the epitaxial growth promotion portions to the main surface ranges from 0.001 to 0.2.

13. A substrate for semiconductor light emitting device using the optical substrate according to claim 1 to develop epitaxial growth of a semiconductor crystal on the main surface,
wherein the main surface has a plurality of epitaxial growth promotion portions, and a plurality of epitaxial growth suppression portions to be comprised thereof, peripheries of the epitaxial growth suppression portions are enclosed by the epitaxial growth promotion portions, or the epitaxial growth suppression portions are sandwiched between the epitaxial growth promotion portions,
the epitaxial growth suppression portions are comprised of at least a plurality of convex portions and inter-convex bottom portions, and

the epitaxial growth promotion portions are the toothless portions, and have planes parallel with the main surface.

**14.** The substrate for semiconductor light emitting device according to claim 13, wherein each of the epitaxial growth promotion portions is a concave portion having a flat plane in a position lower than the main surface formed of the inter-convex bottom portions, and is the concave portion having a plane parallel with the main surface as a bottom portion.

**15.** The substrate for semiconductor light emitting device according to claim 13 or 14, wherein an area ratio of the epitaxial growth suppression portions to the main surface ranges from 0.80 to 0.999.

**16.** The substrate for semiconductor light emitting device according to any one of claims 8 to 15, wherein the epitaxial growth suppression portions are comprised of at least a plurality of the convex portions periodically disposed.

**17.** The substrate for semiconductor light emitting device according to claim 16, wherein the substrate for semiconductor light emitting device is a single crystal substrate having a crystal structure of hexagonal system, and a nearest-neighbor direction of a plurality of nearest-neighbor epitaxial growth suppression portions is not parallel with an m-plane of the crystal structure of the substrate for semiconductor light emitting device.

**18.** A semiconductor light emitting device comprising:

the optical substrate according to any one of claims 1 to 7, or the substrate for semiconductor light emitting device according to any one of claims 8 to 17; and
a layered semiconductor layer formed by layering at least two or more semiconductor layers and a light emitting layer, layered on the main surface side.

FIG. 1

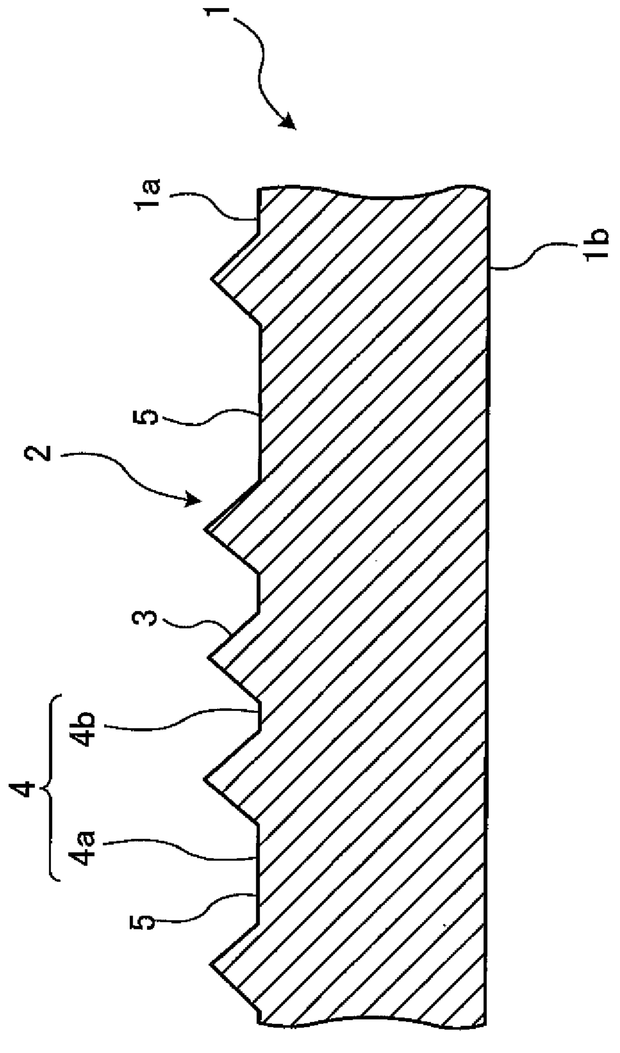

FIG. 2

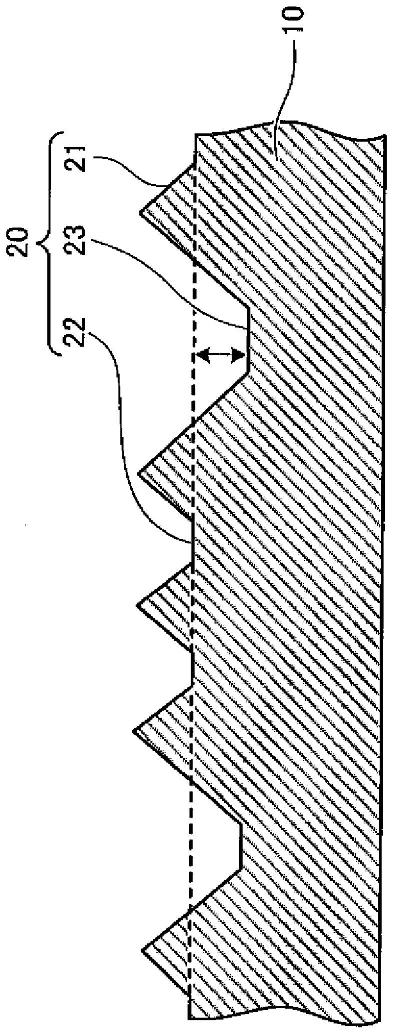

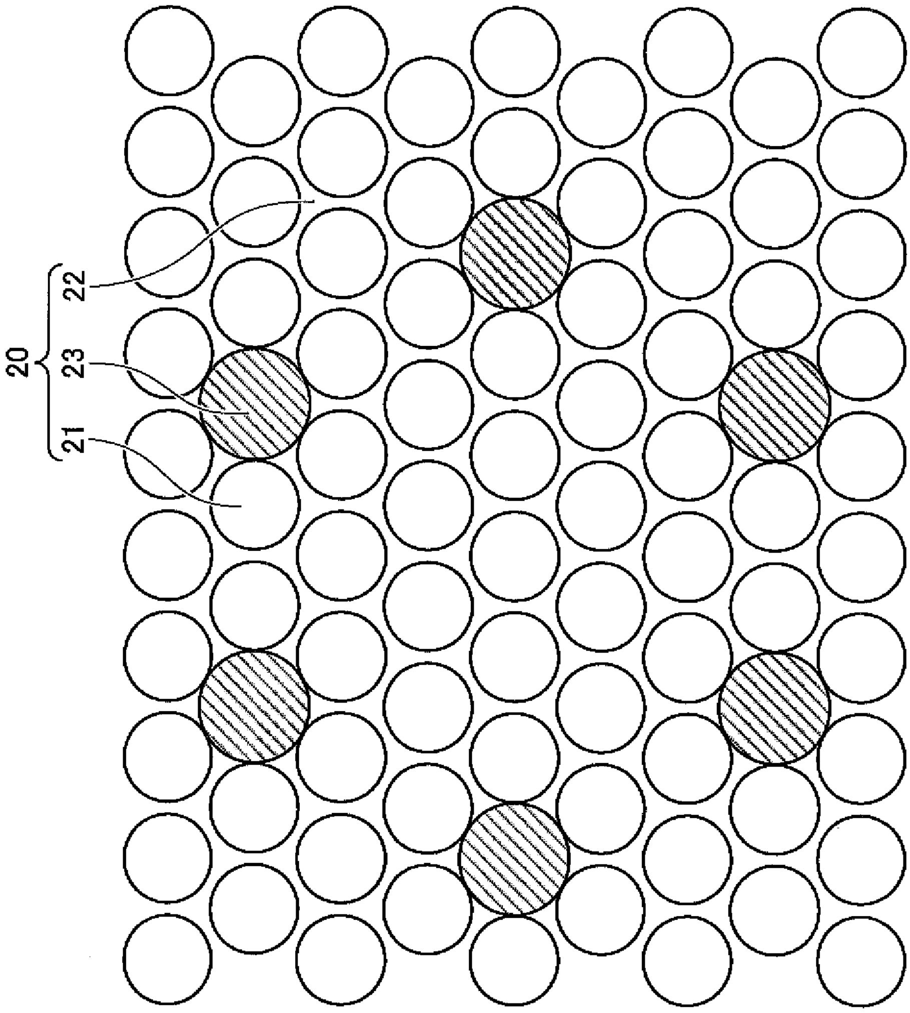


FIG. 3

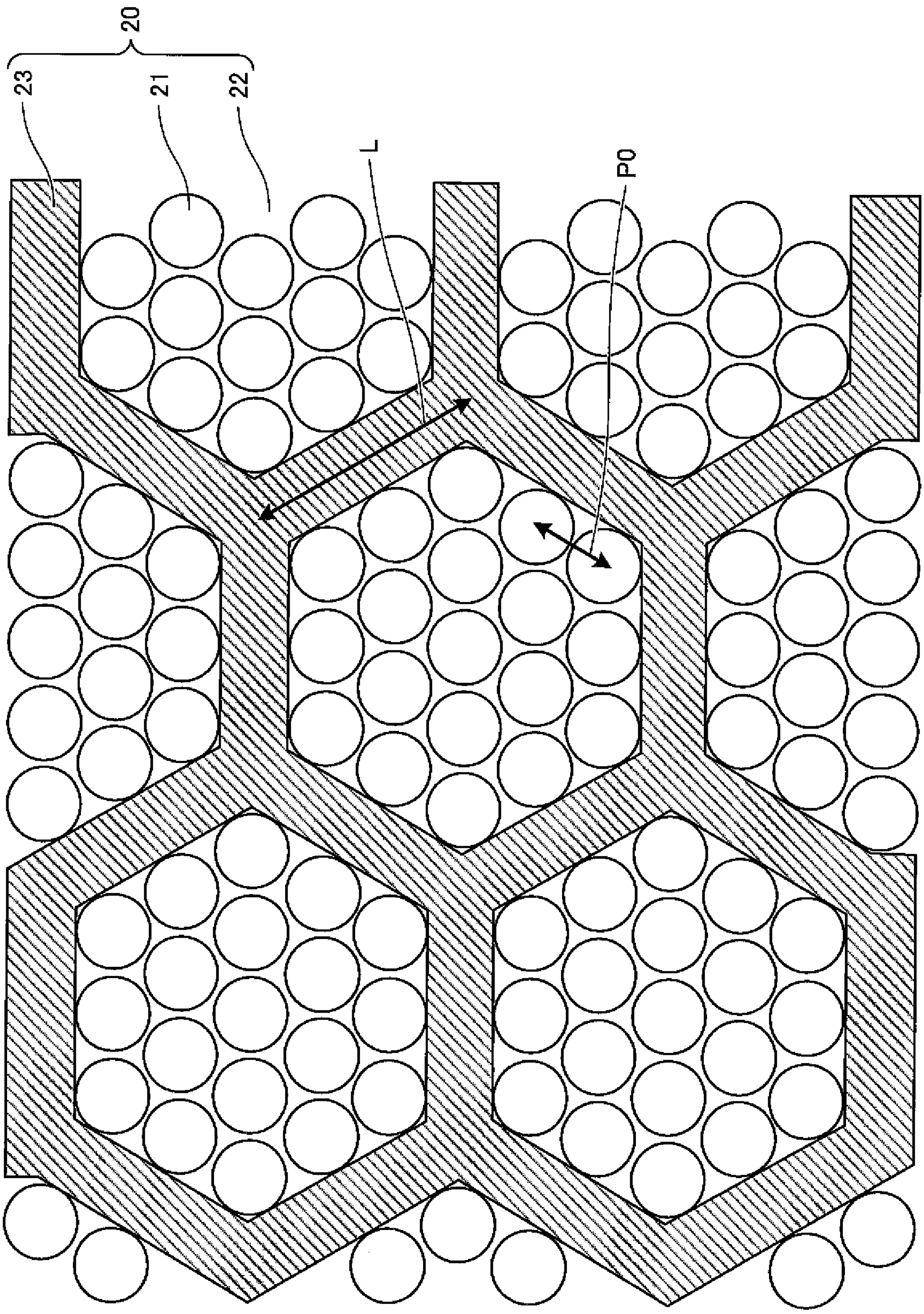


FIG. 4

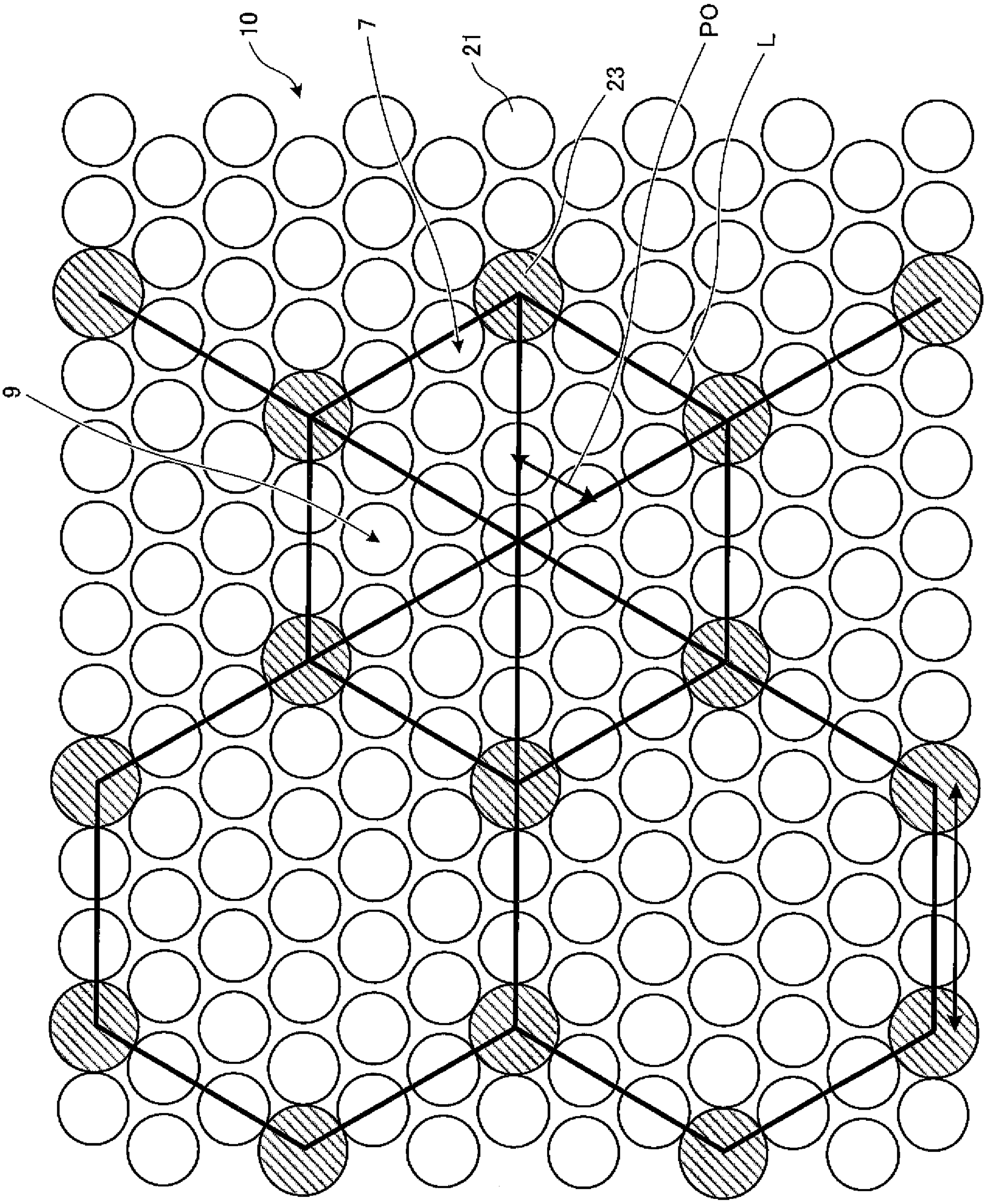


FIG. 5

FIG. 6

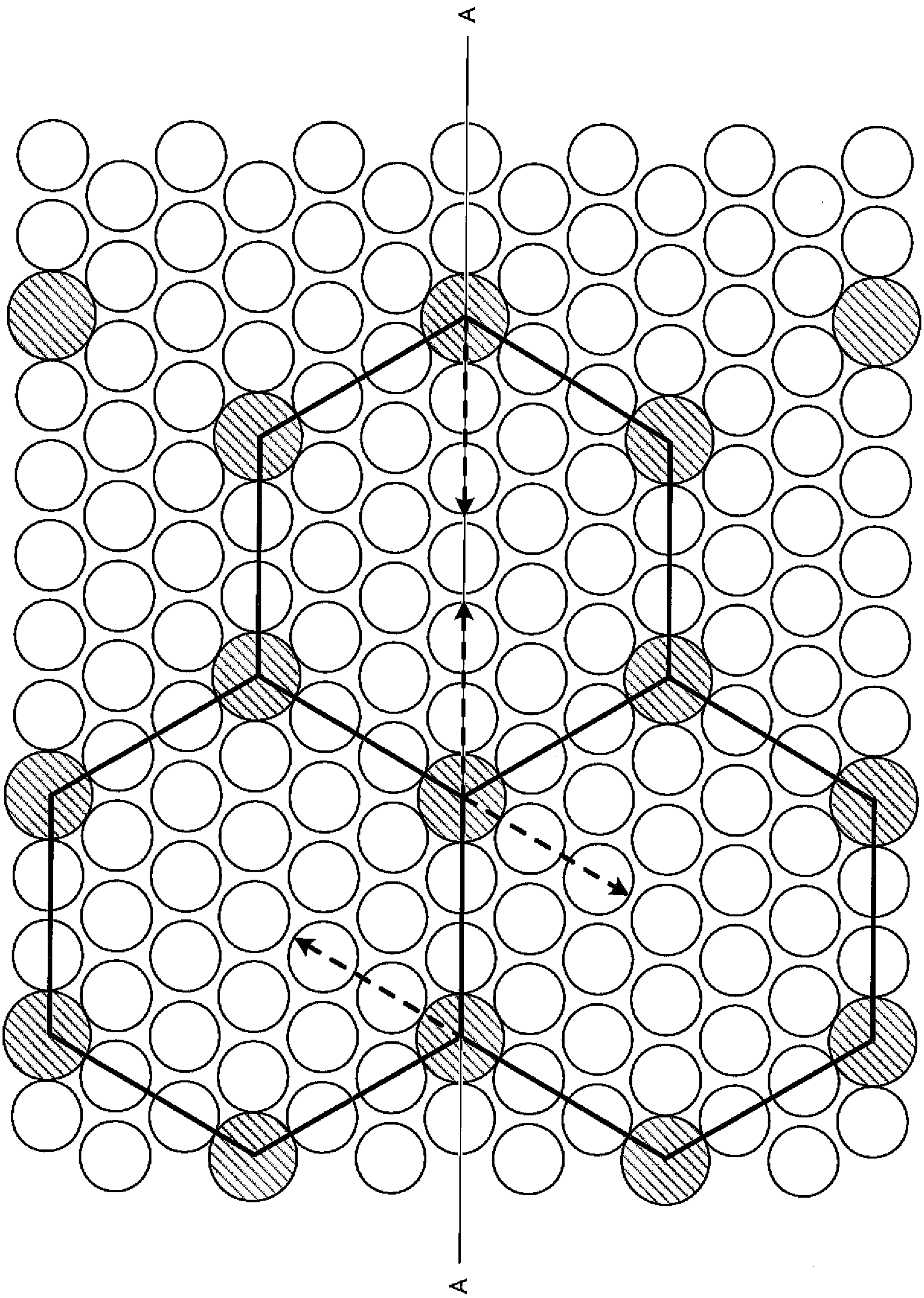

FIG. 7

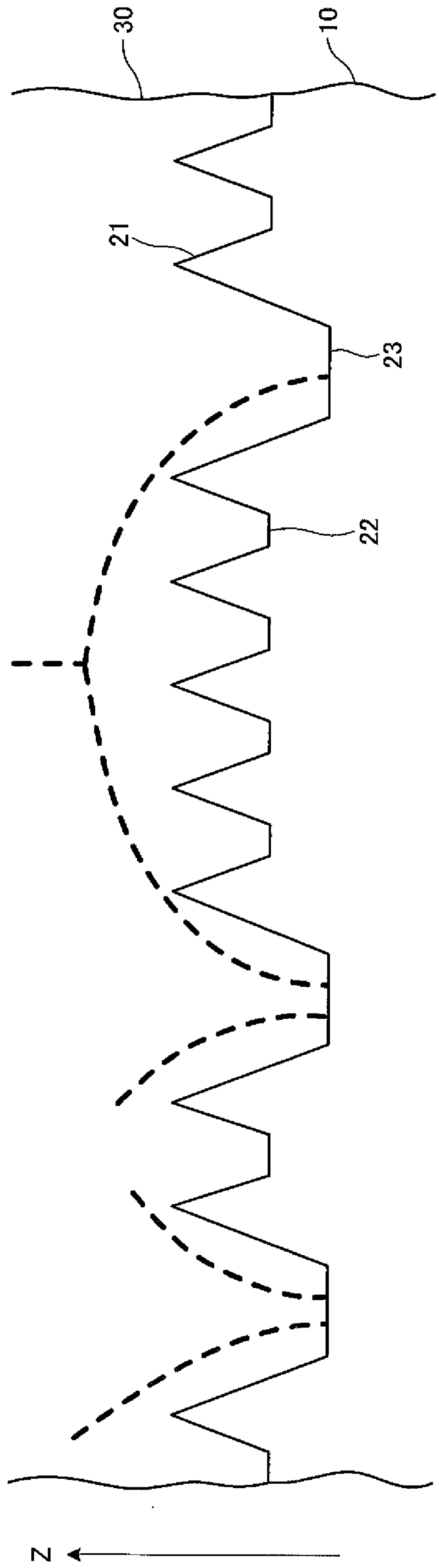

FIG. 8

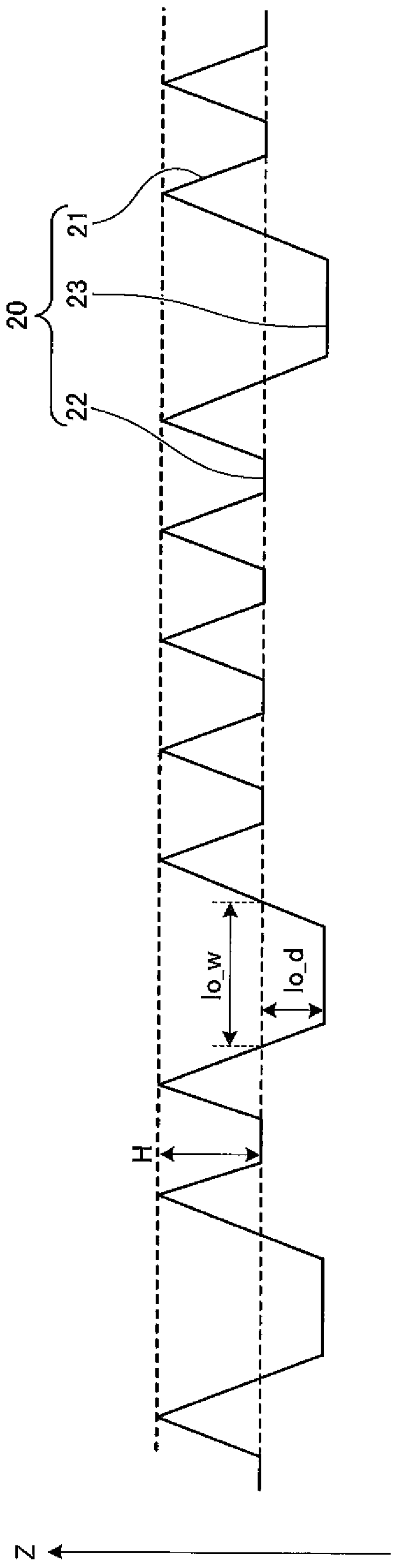

FIG. 9A

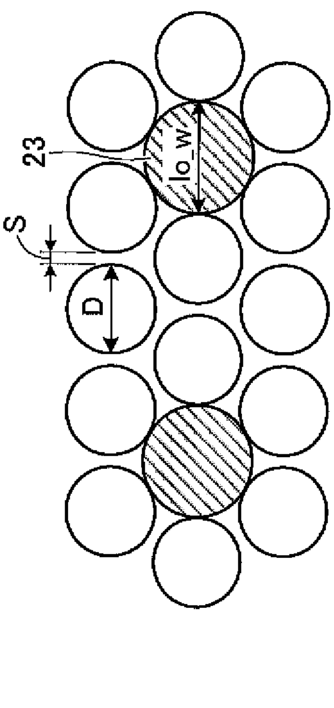


FIG. 9B

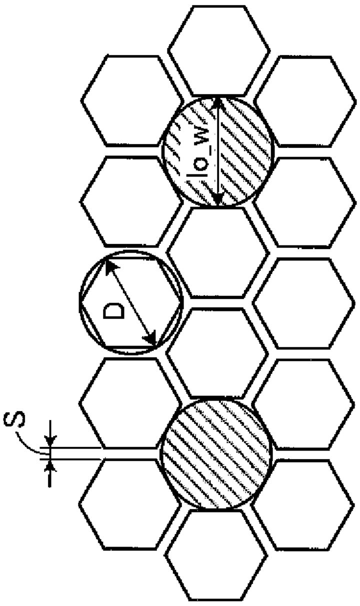


FIG. 9C

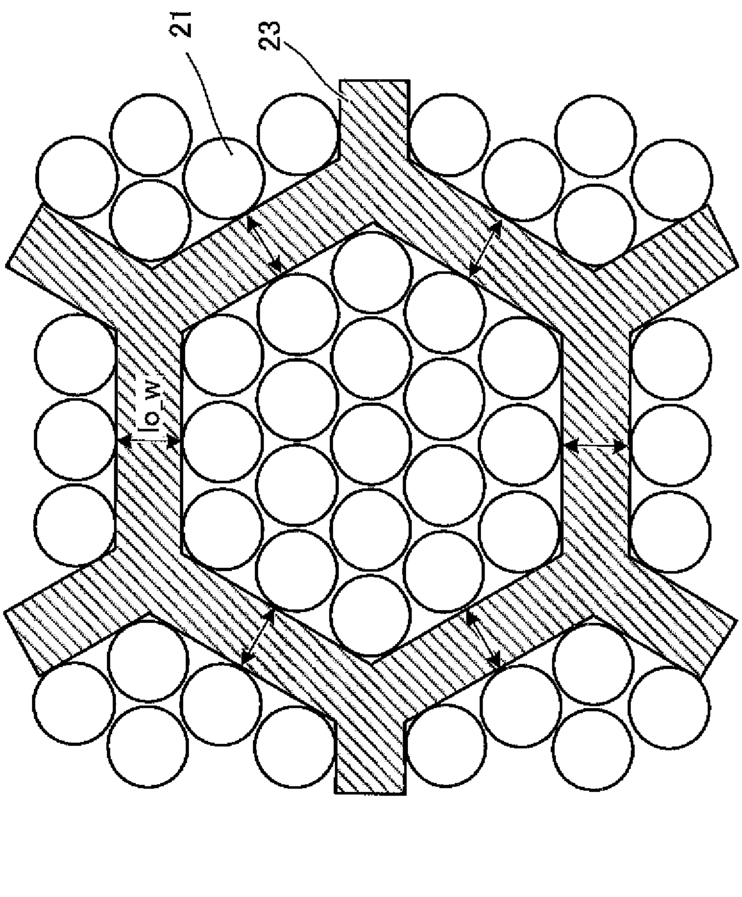

FIG. 10

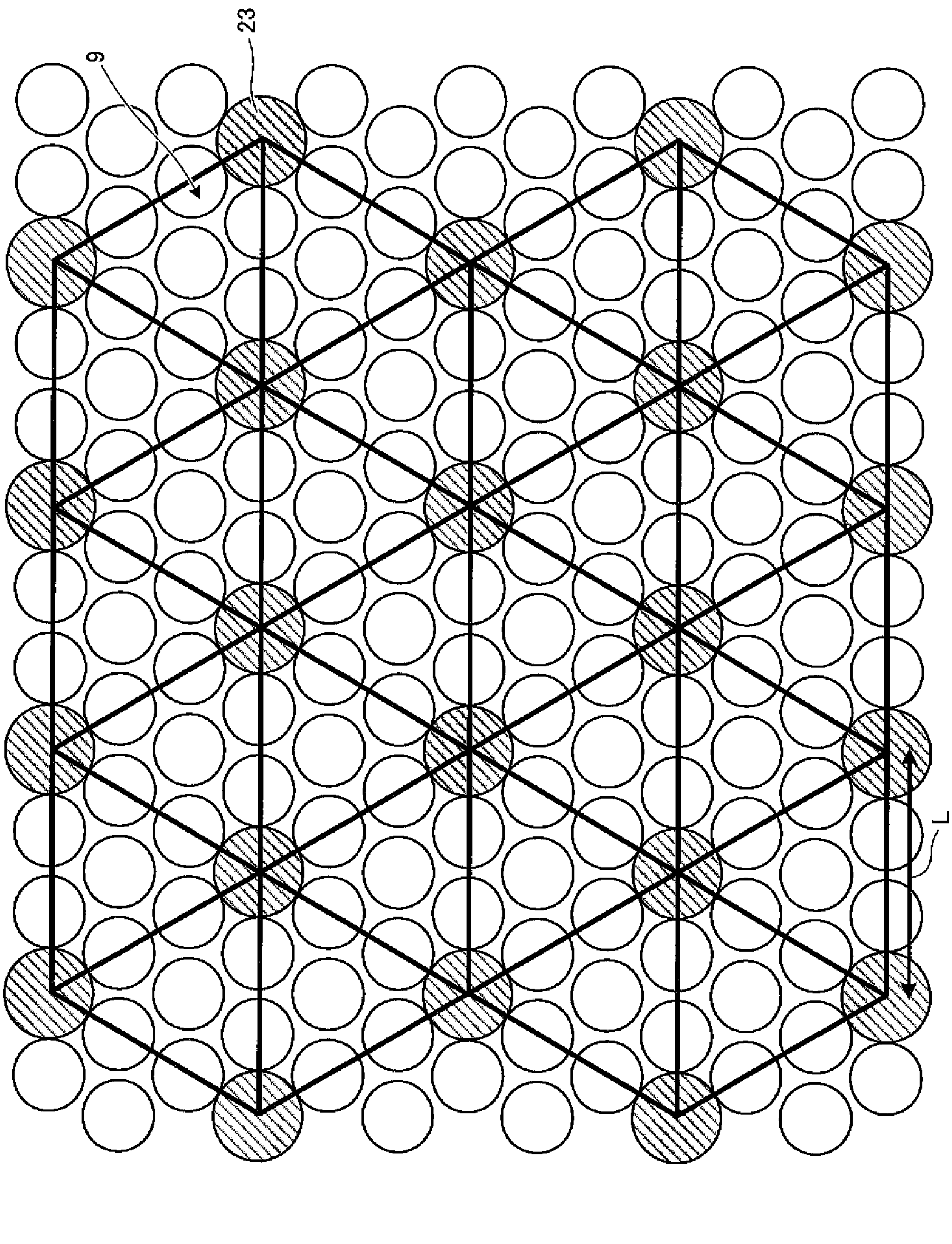

FIG. 11

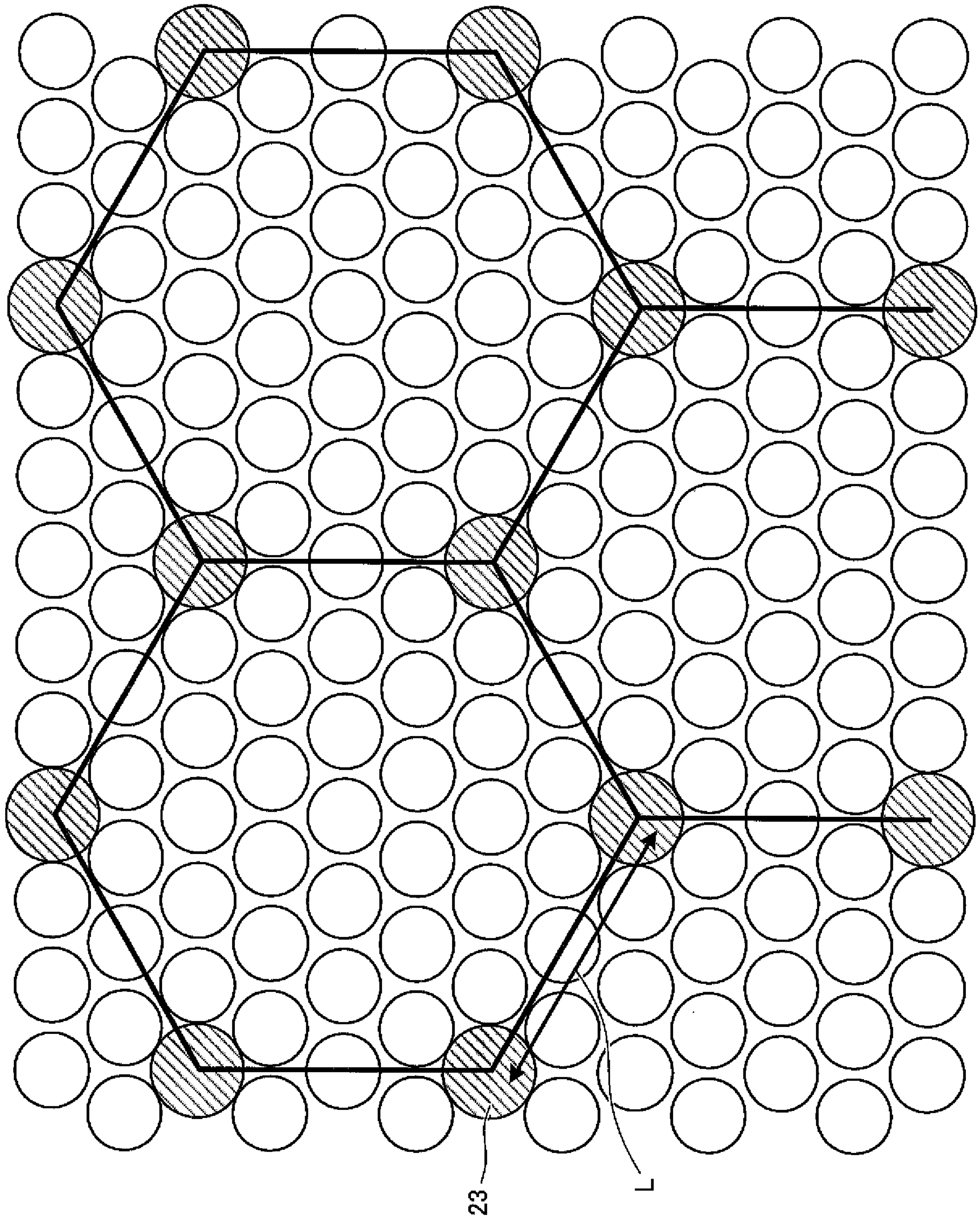

FIG. 12

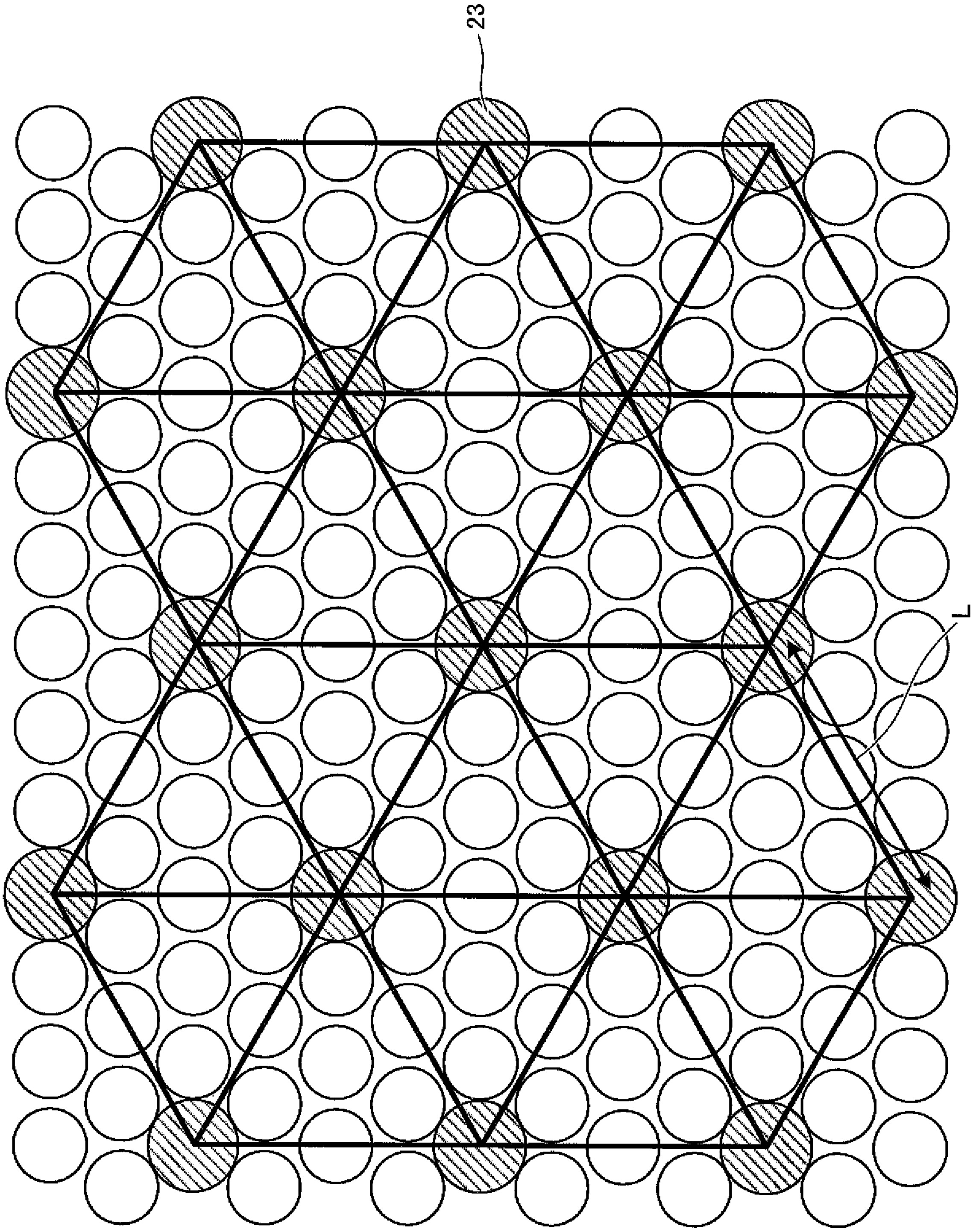

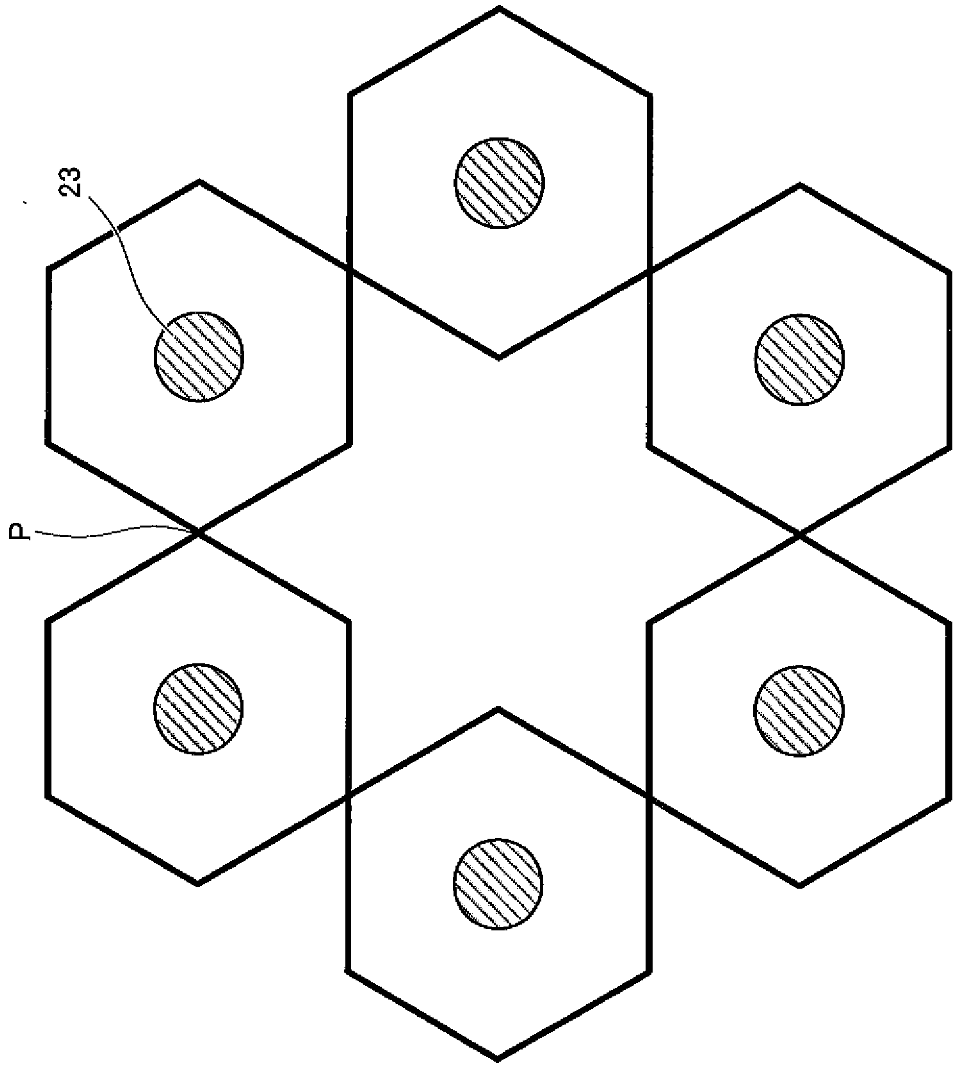


FIG. 13

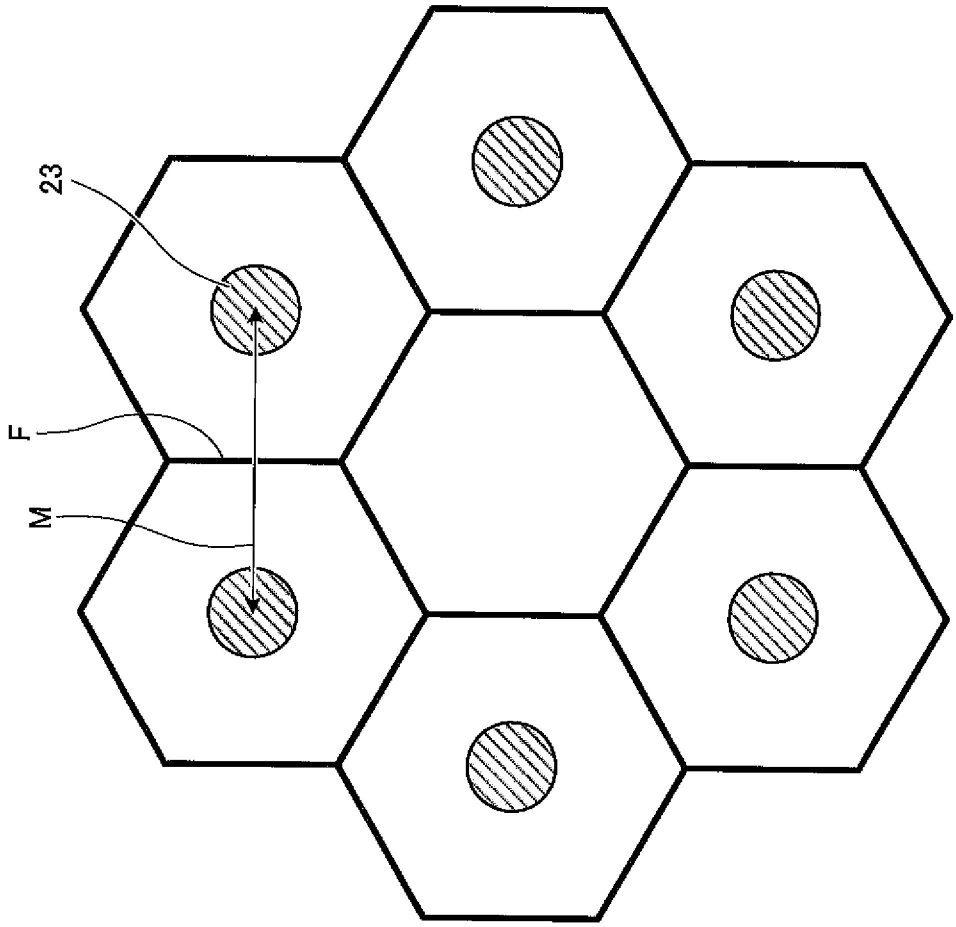


FIG. 14

FIG. 15

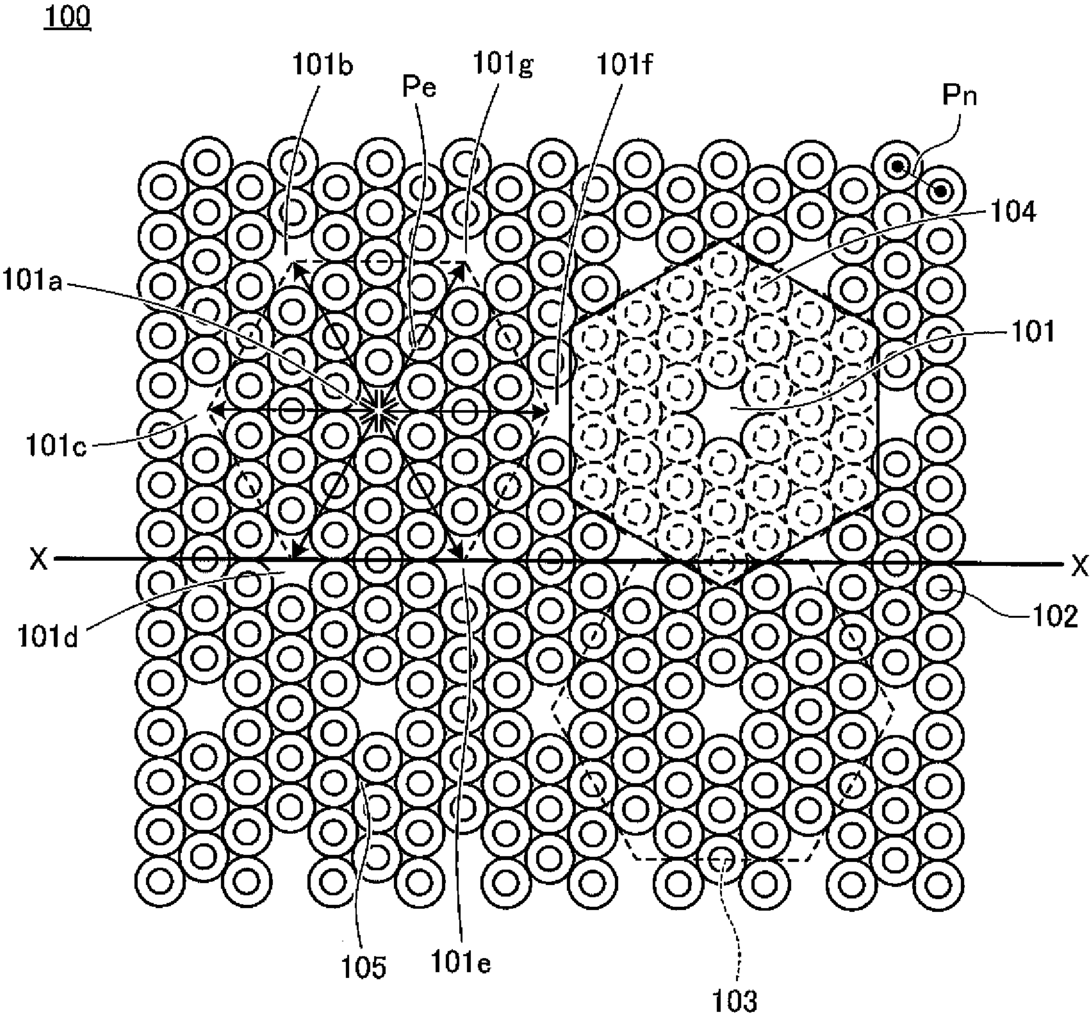
100
101b
Pe
101g
101f
Pn
104
101a
101
101c
X
X
102
101d
105
101e
103

FIG. 16

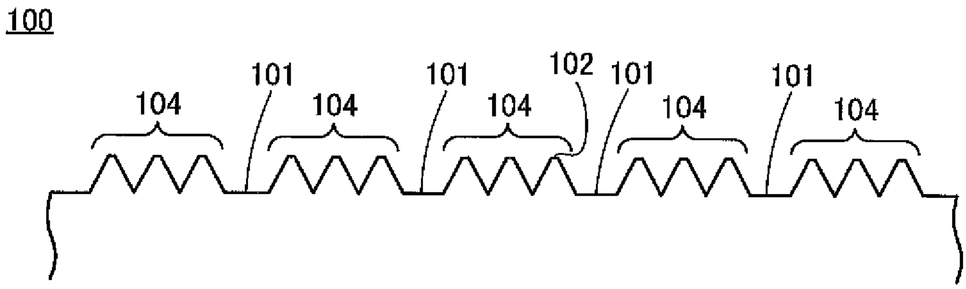

FIG. 17

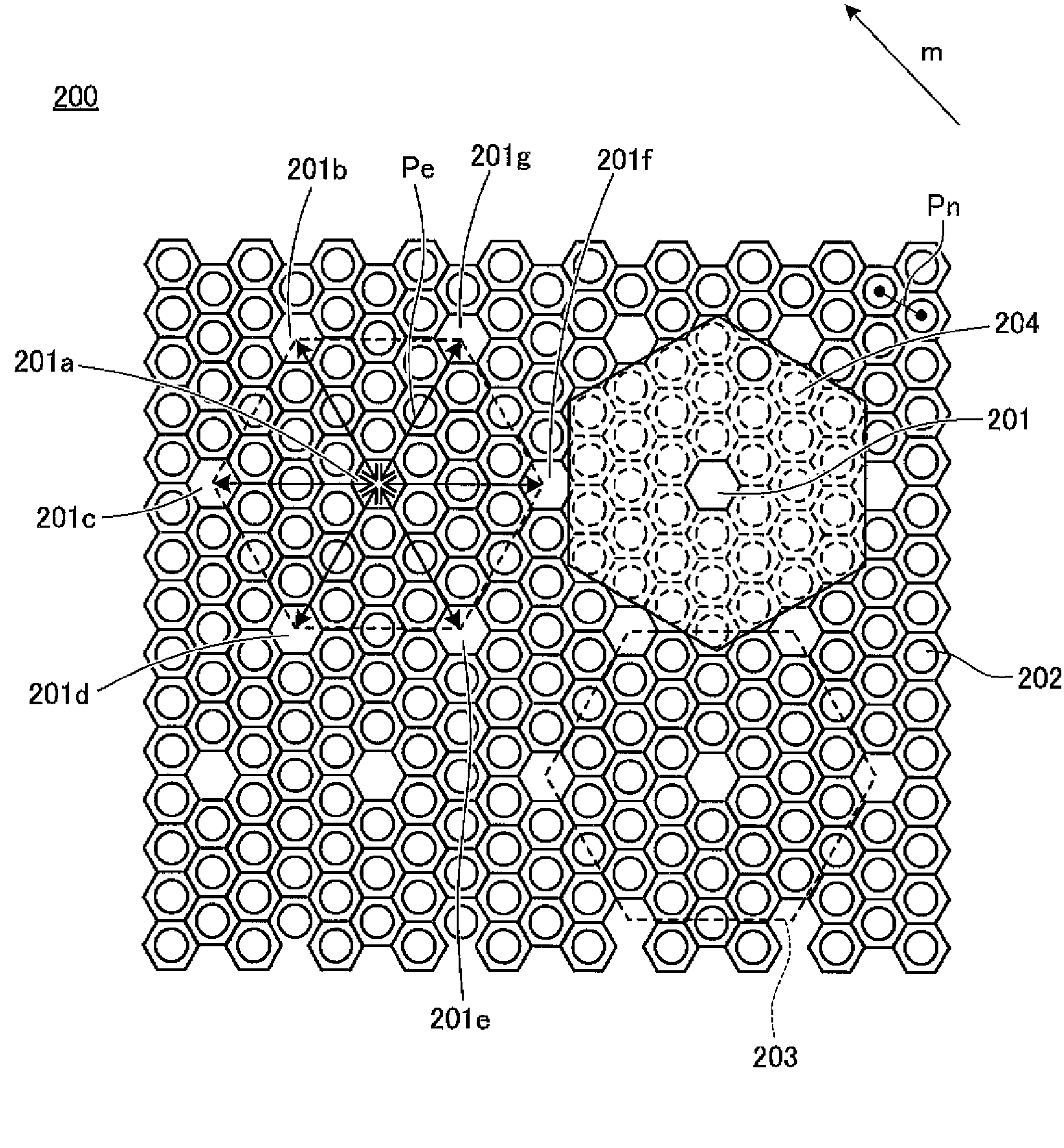

FIG. 18

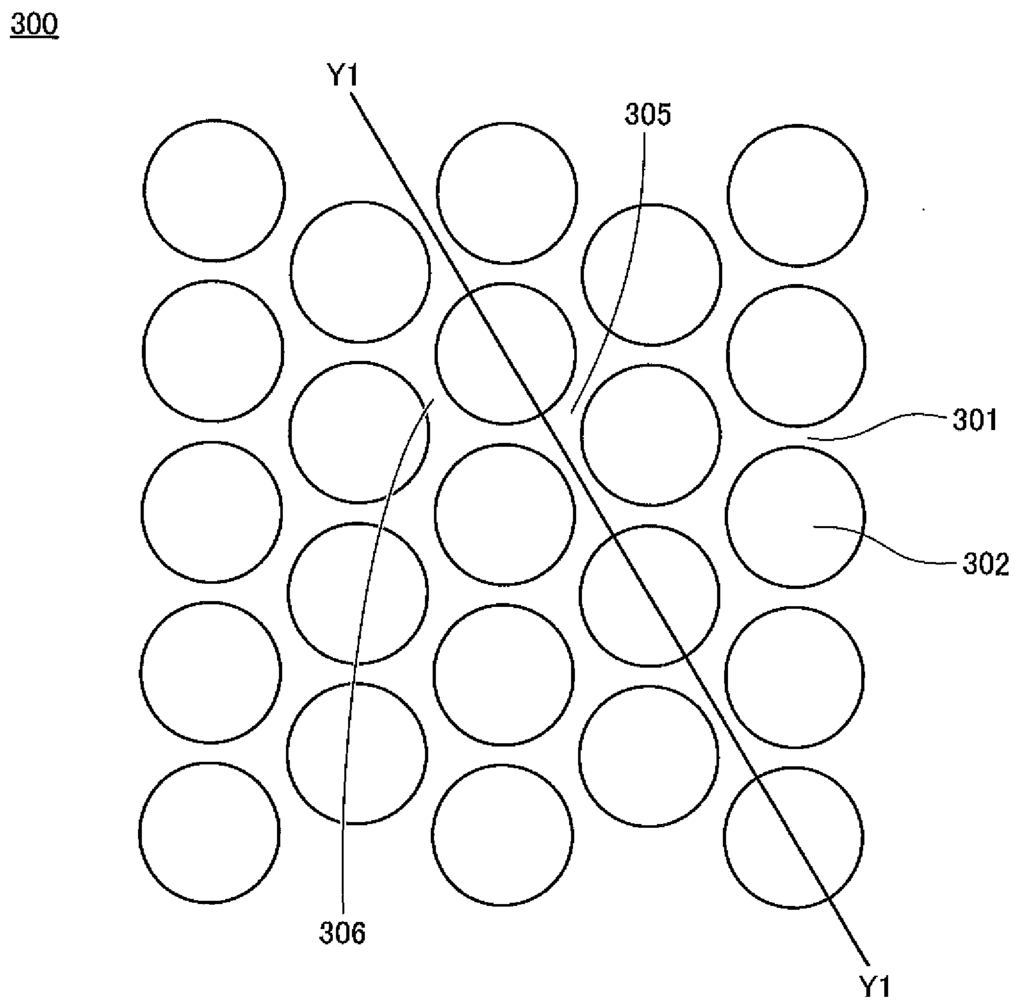

FIG. 19A

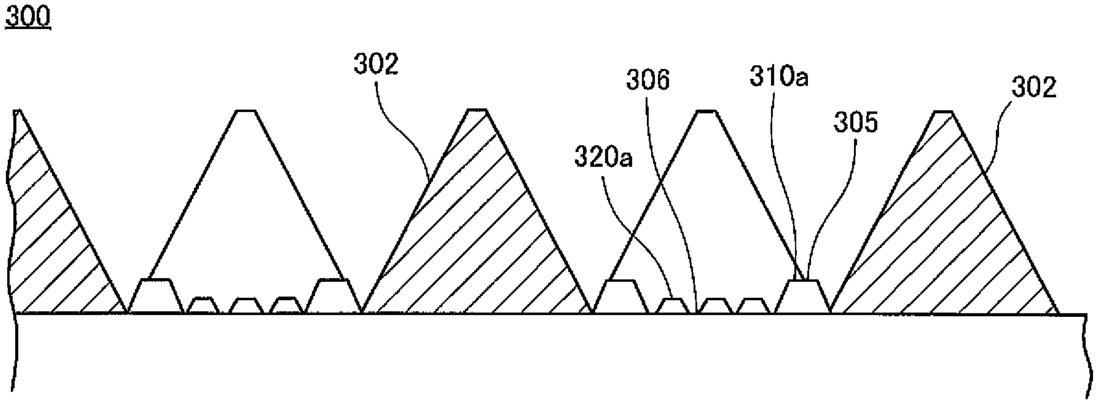


FIG. 19B

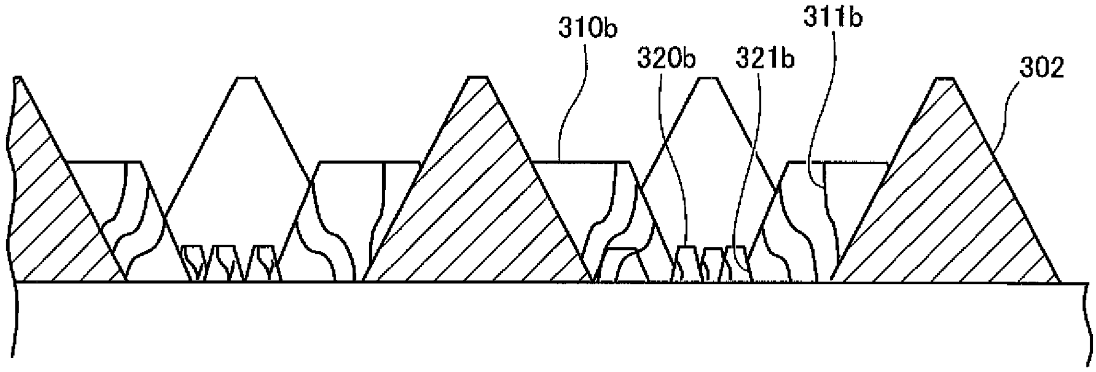


FIG. 19C

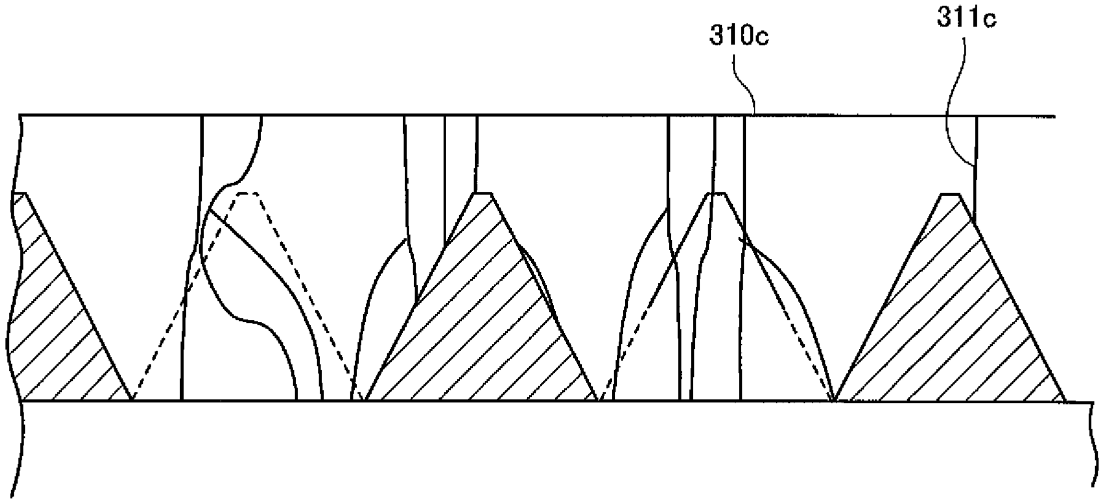

FIG. 20A

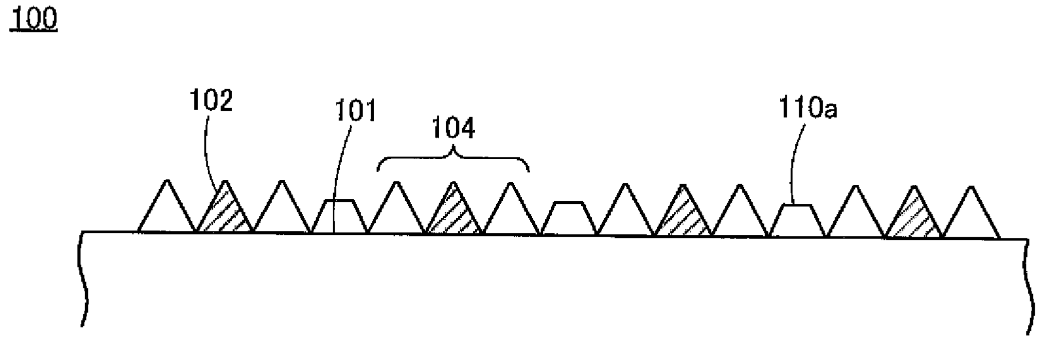


FIG. 20B

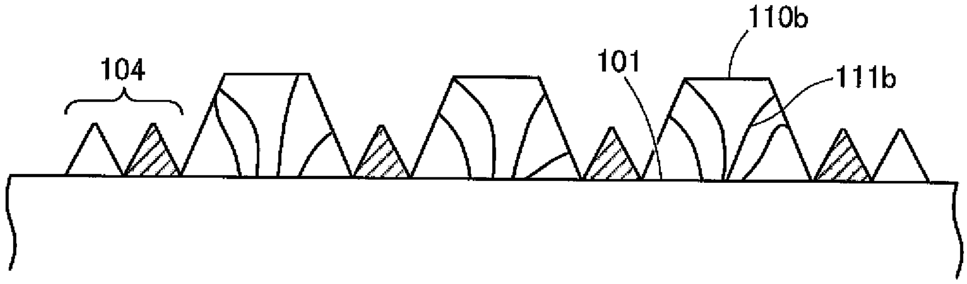


FIG. 20C

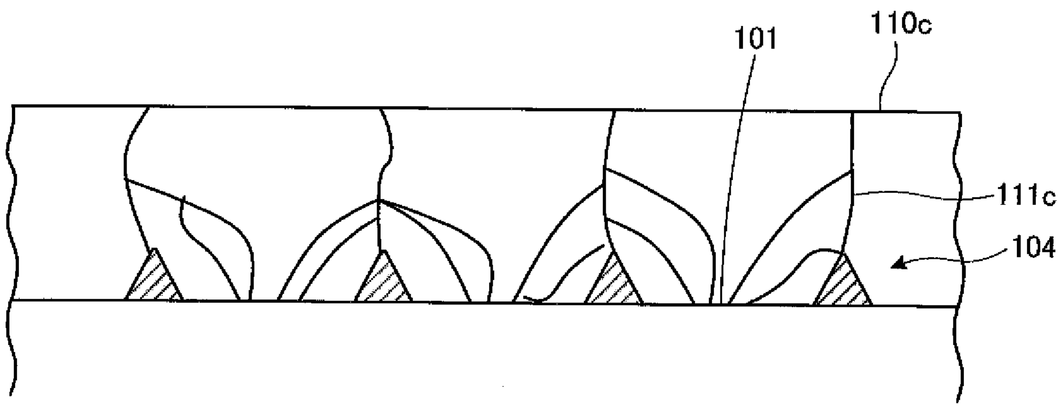

FIG. 21

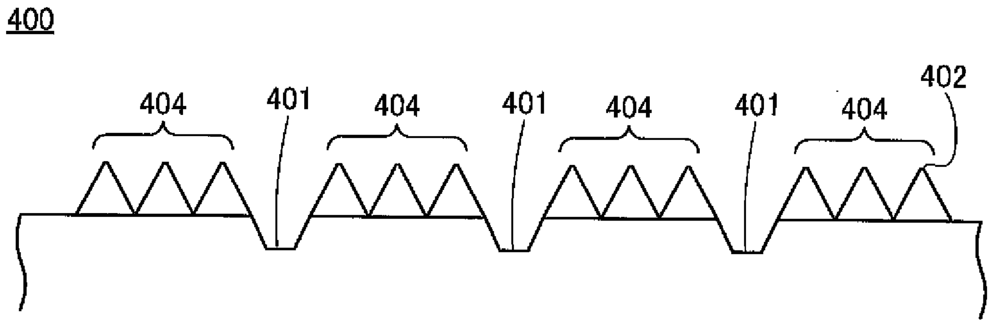

FIG. 22

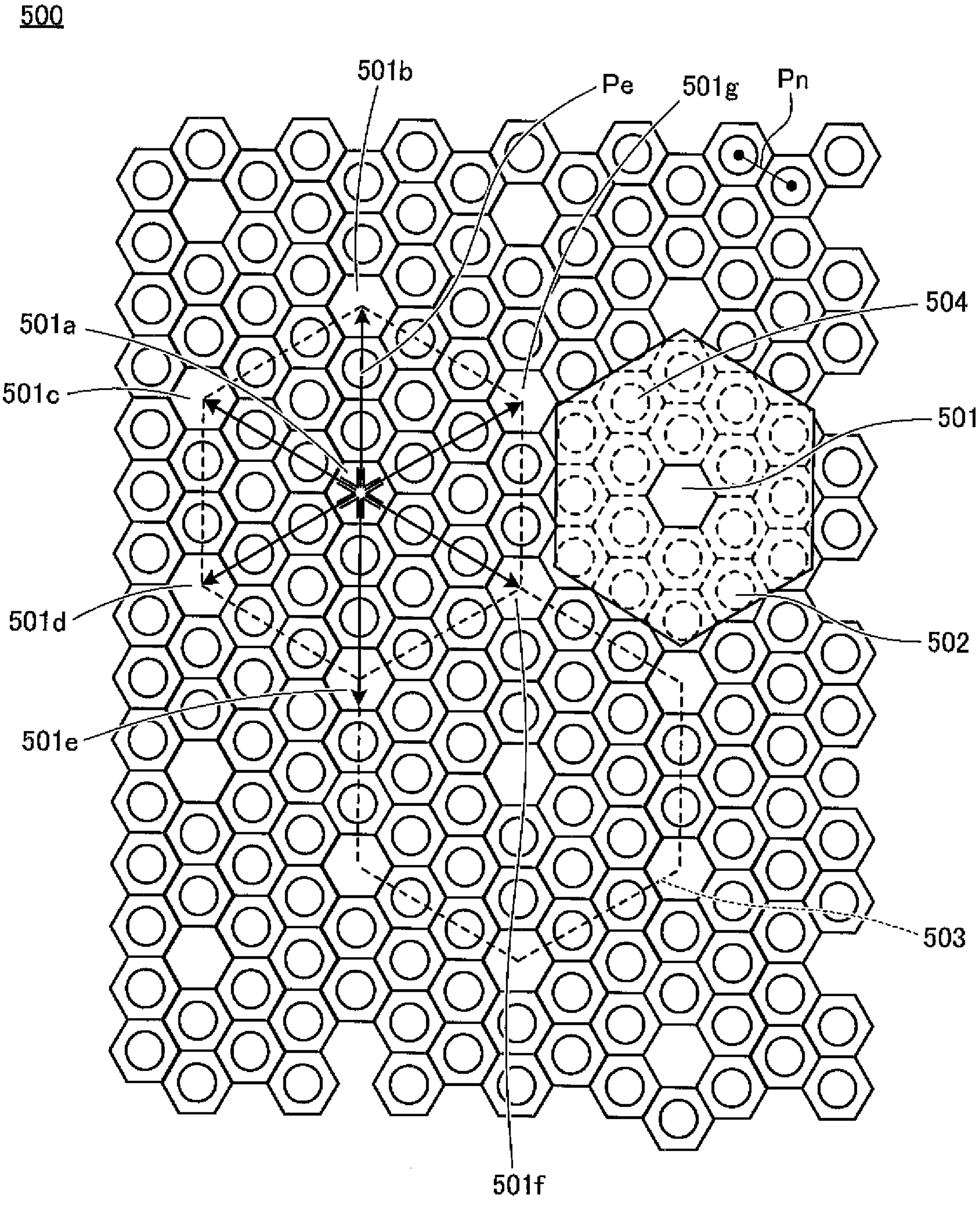

FIG. 23

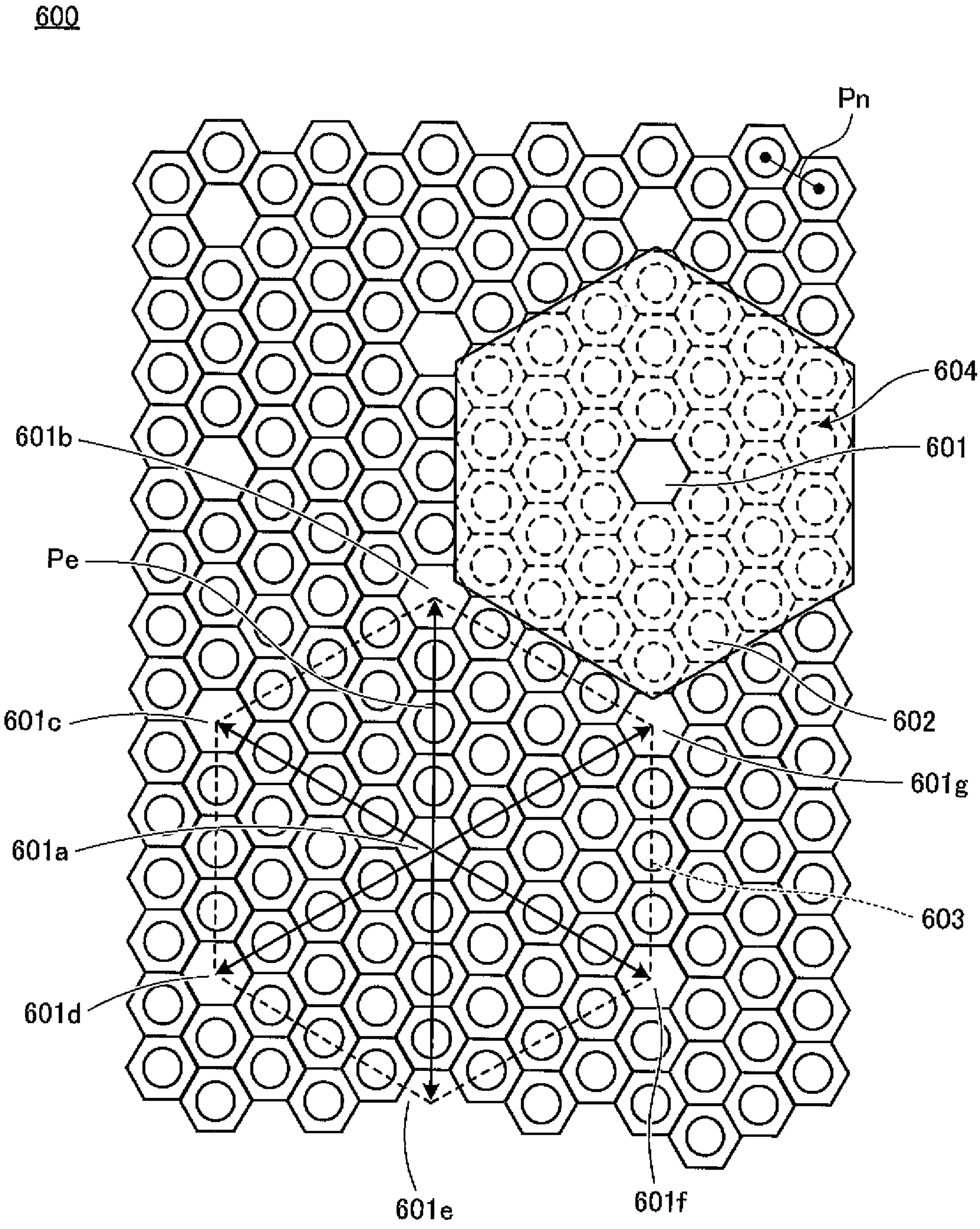

FIG. 24

650

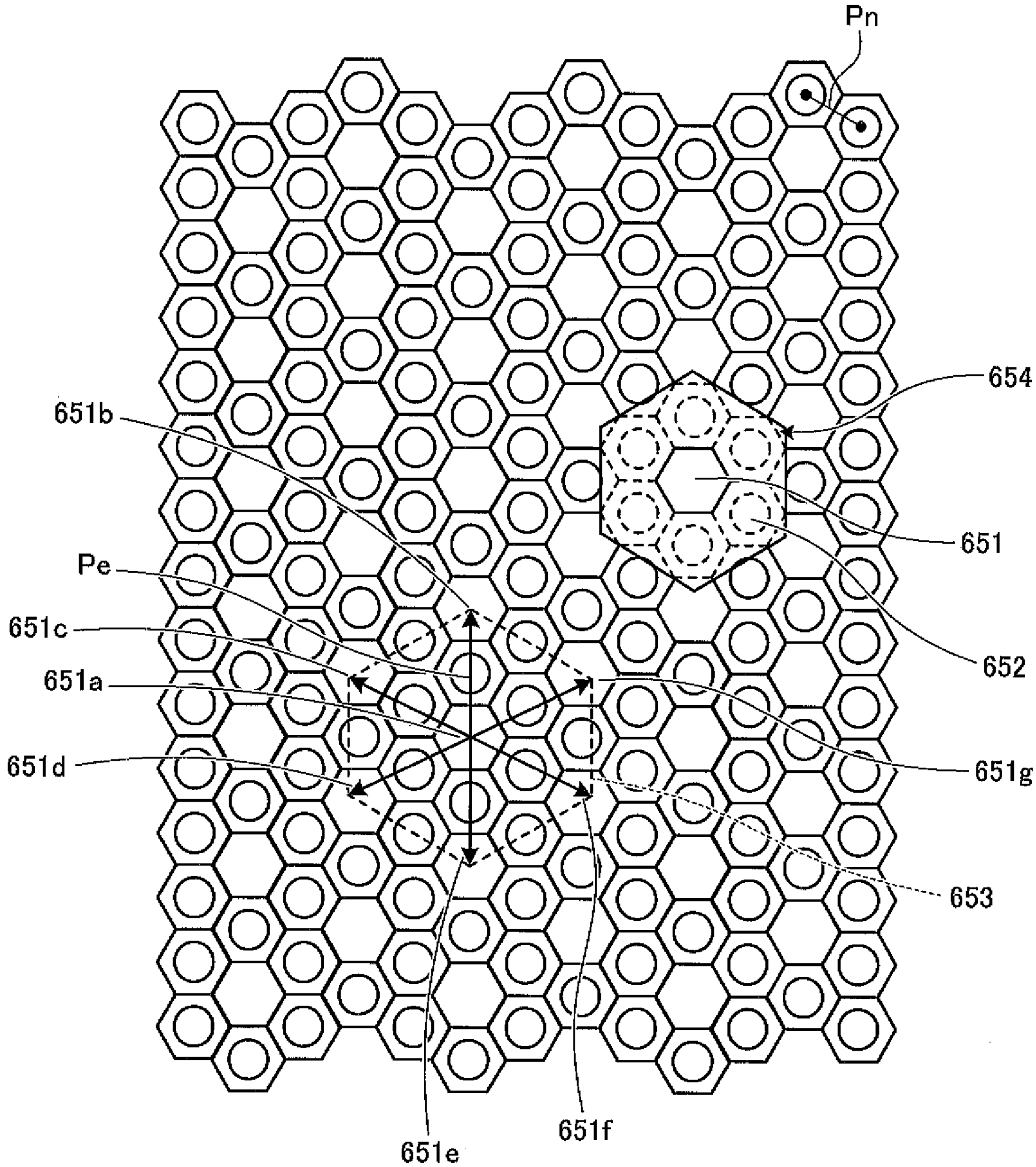

FIG. 25

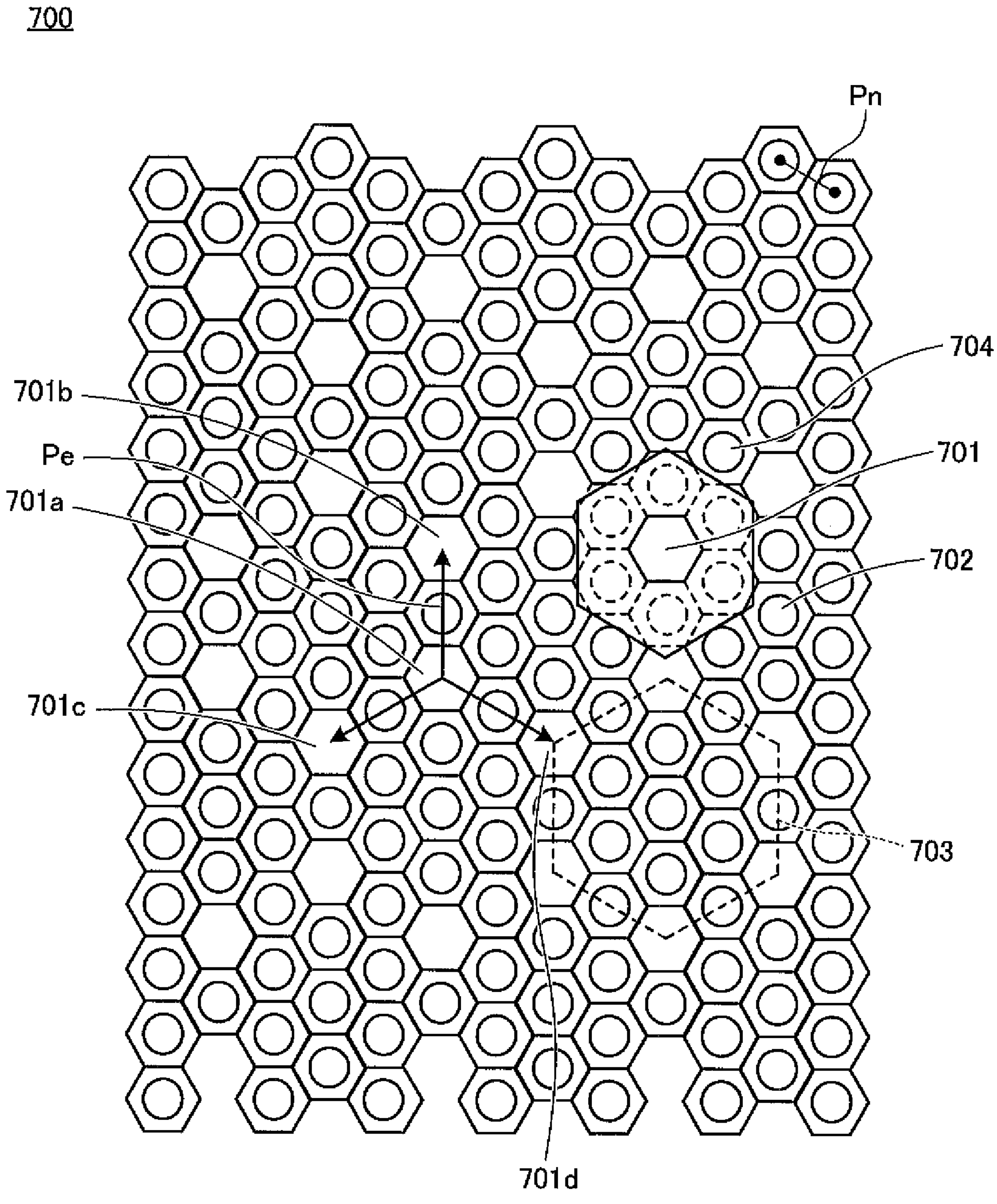

FIG. 26

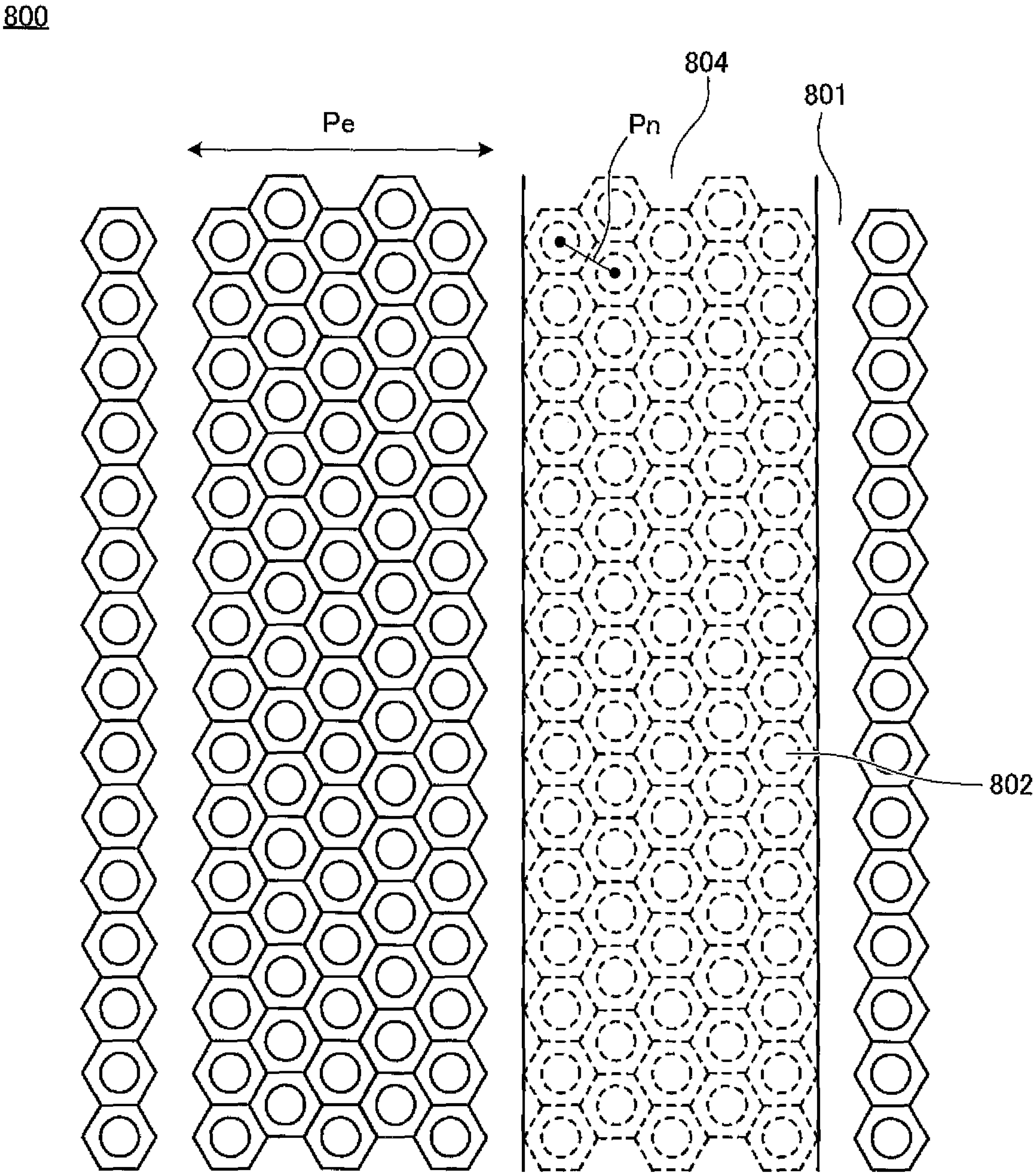

FIG. 27

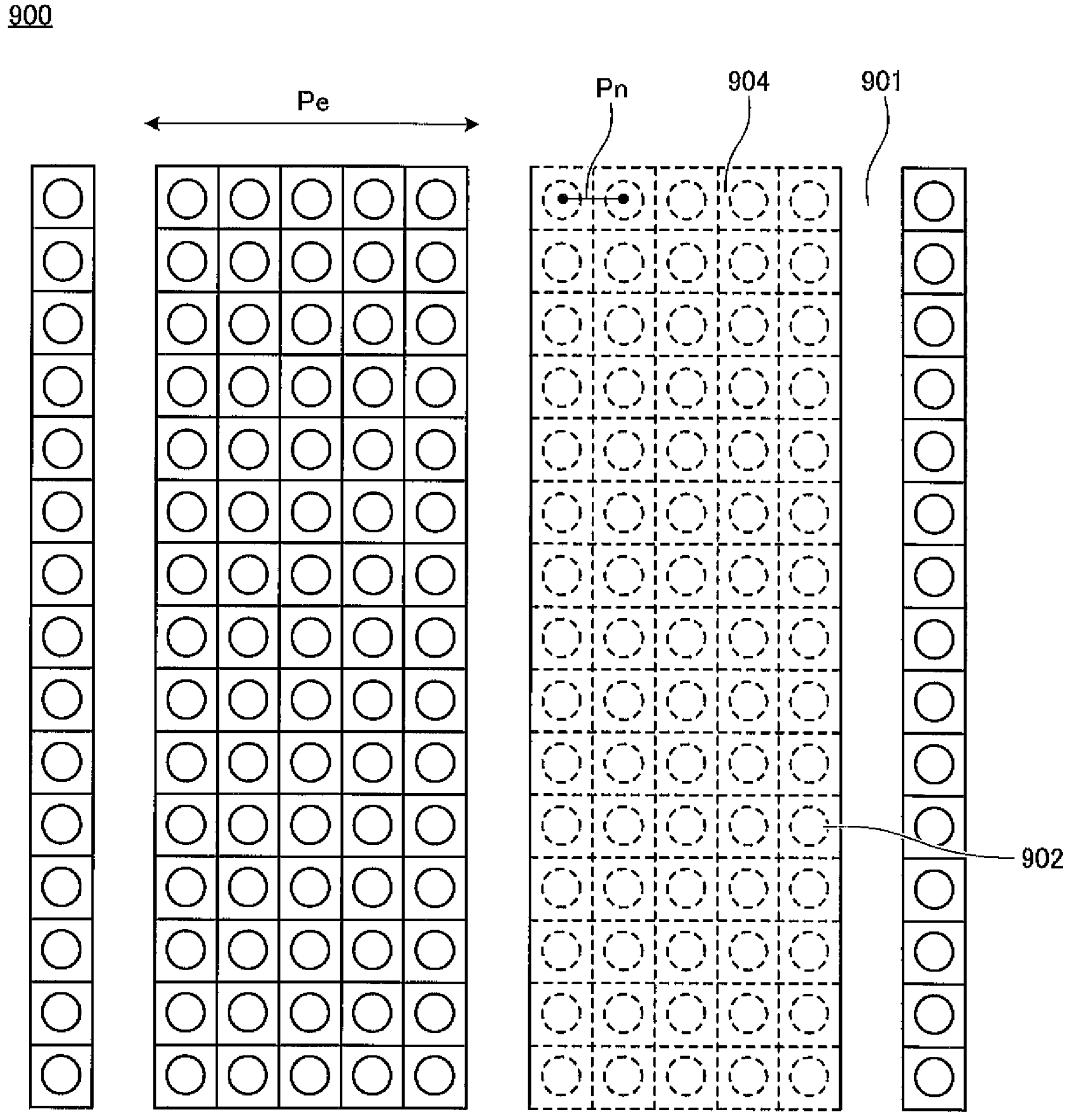

FIG. 28

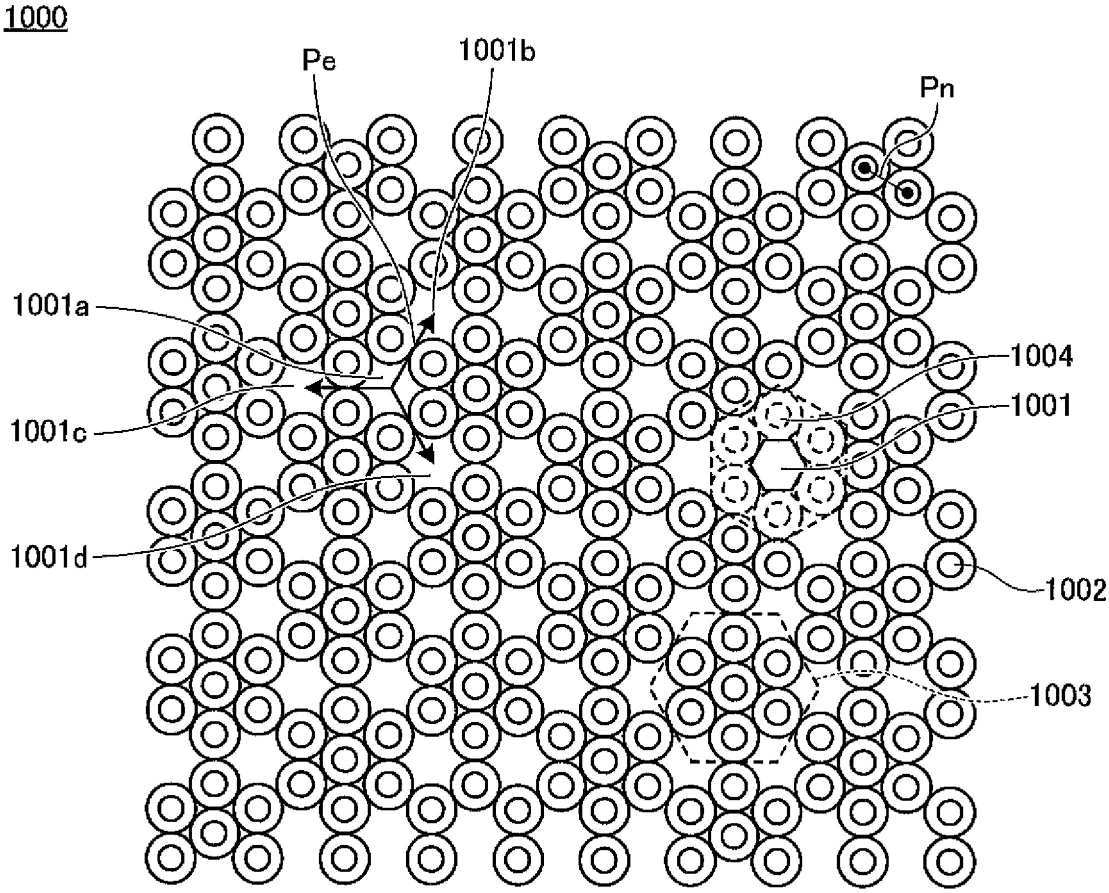

FIG. 29

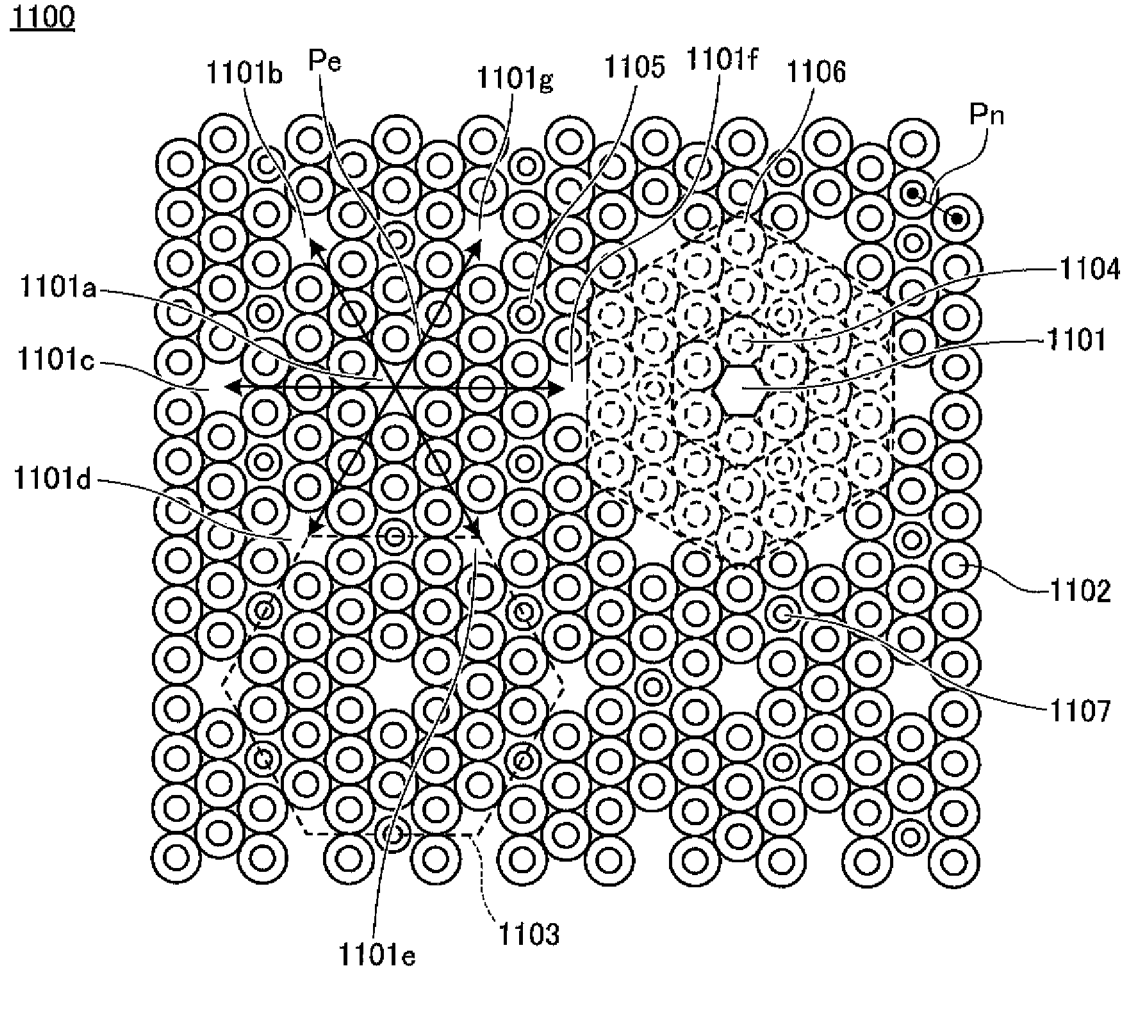
1100
1101b
Pe
1101g
1105
1101f
1106
Pn
1104
1101a
1101
1101c
1101d
1102
1107
1103
1101e

FIG. 30

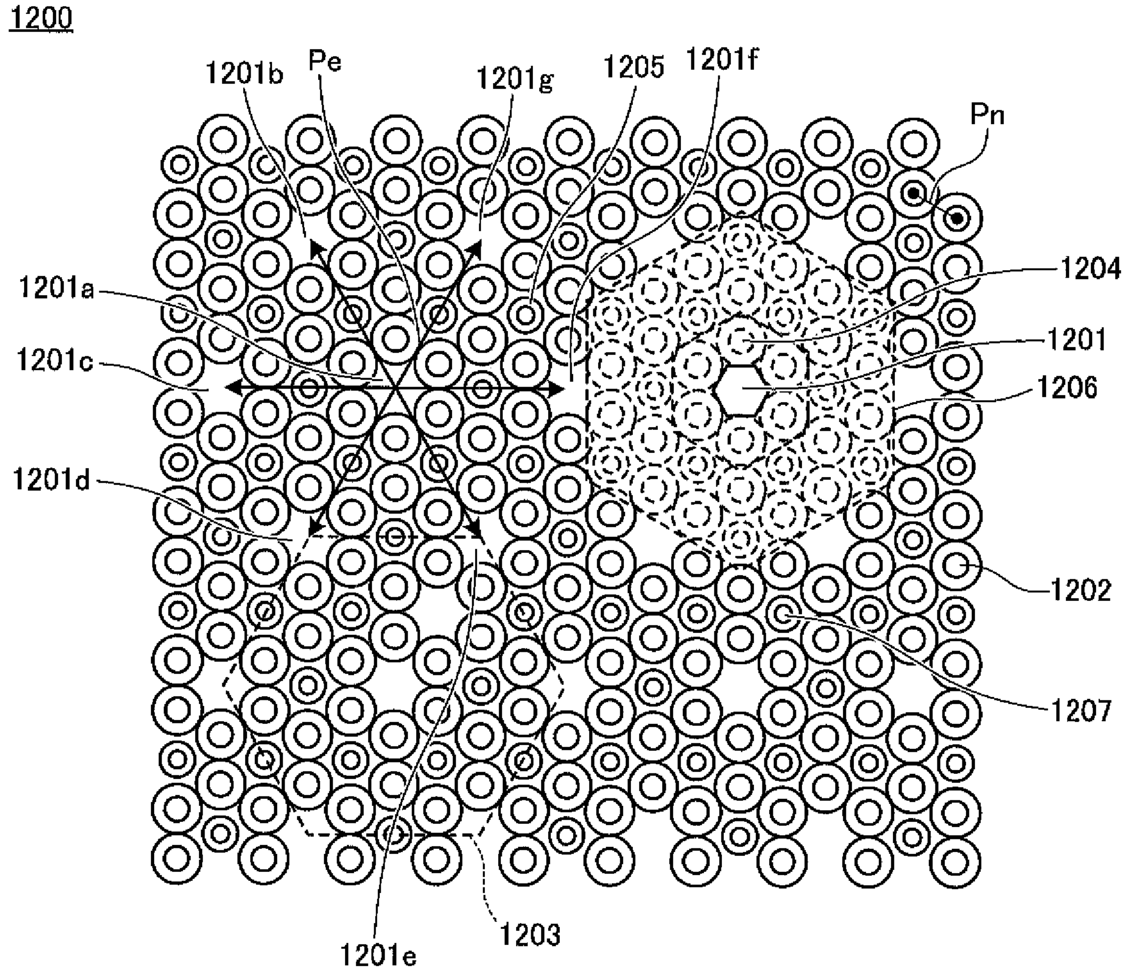
1200
1201b
Pe
1201g
1205
1201f
Pn
1204
1201a
1201
1201c
1206
1201d
1202
1207
1201e
1203

FIG. 31A

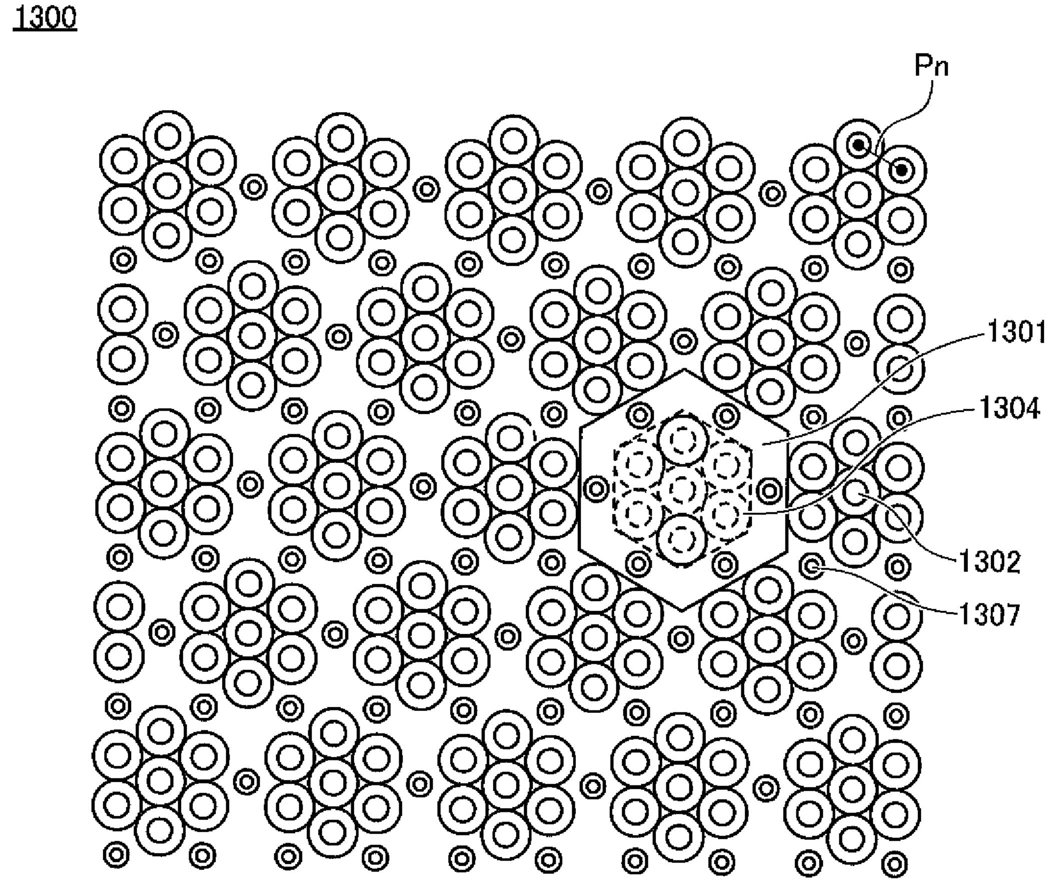


FIG. 31B

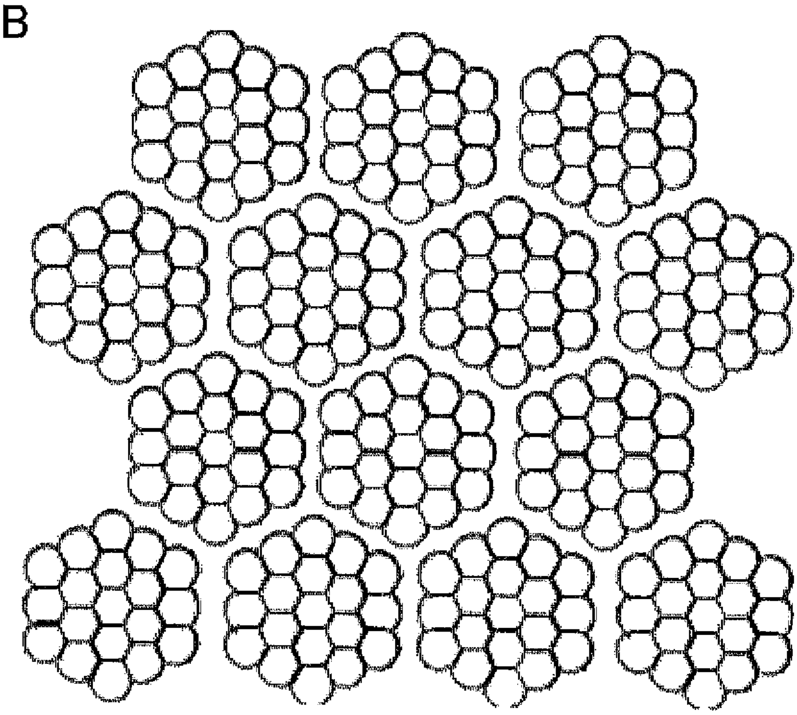

FIG. 32

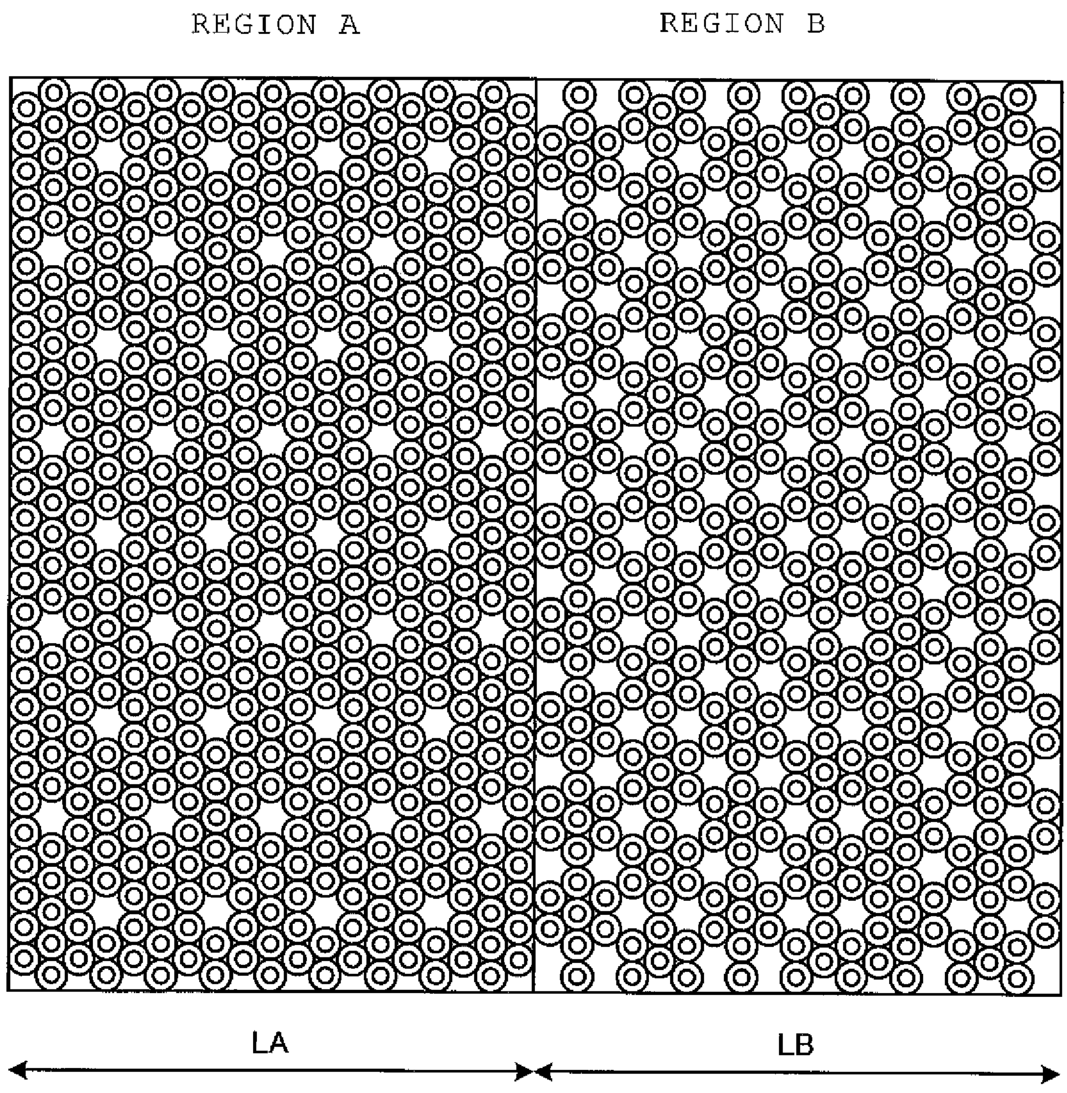

FIG. 33A

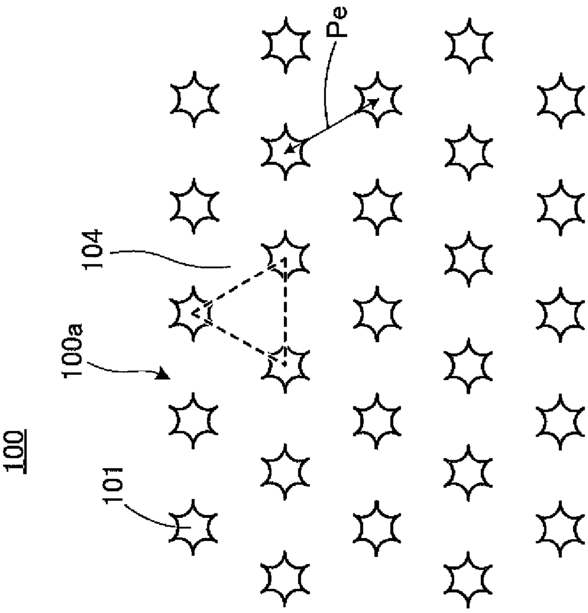


FIG. 33B

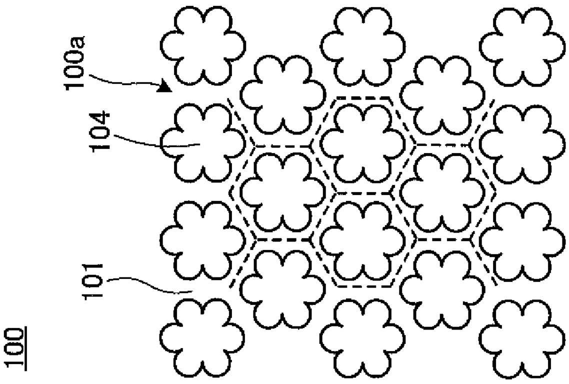


FIG. 33C

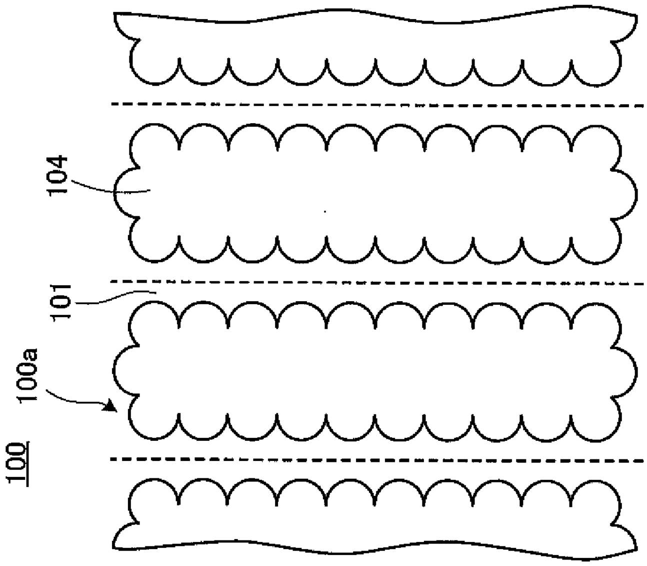

FIG. 34A

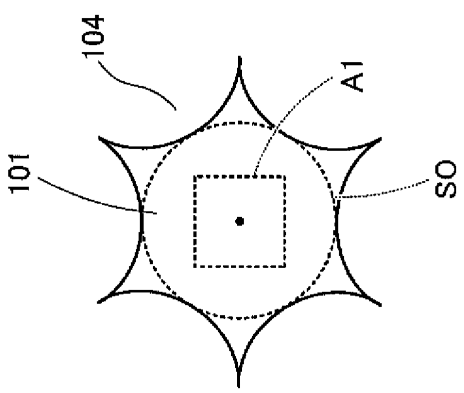


FIG. 34B

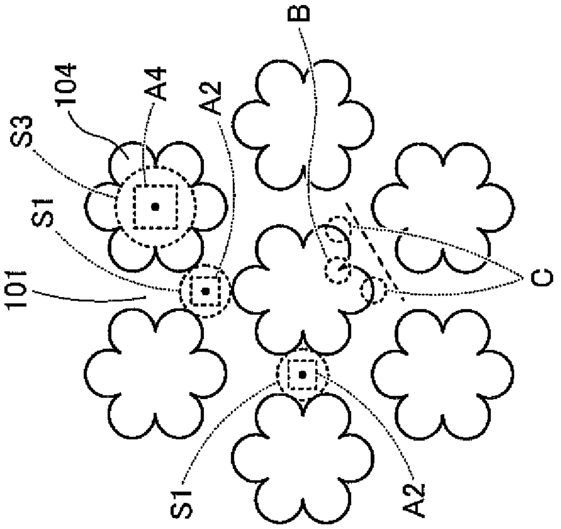


FIG. 34C

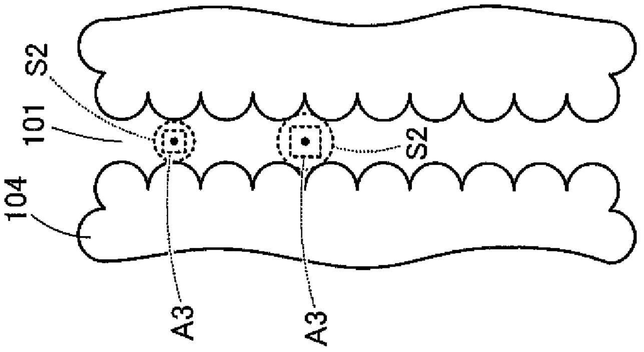

FIG. 35A

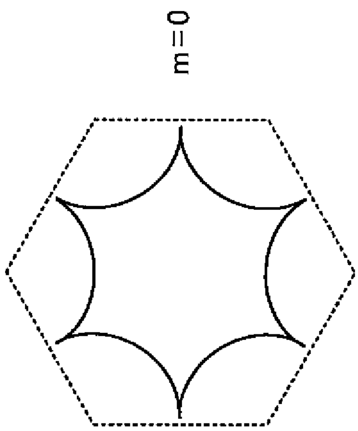


FIG. 35B

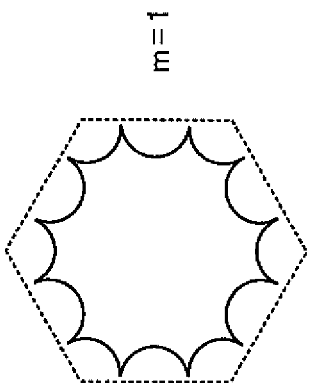


FIG. 35C

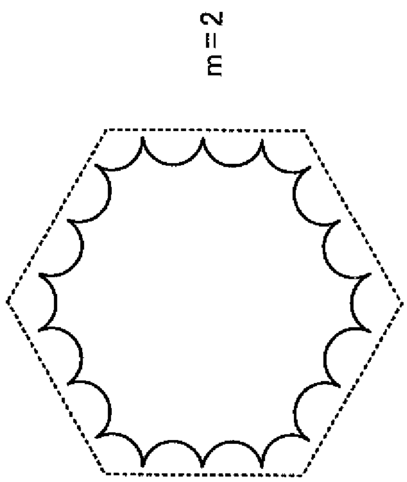


FIG. 35D

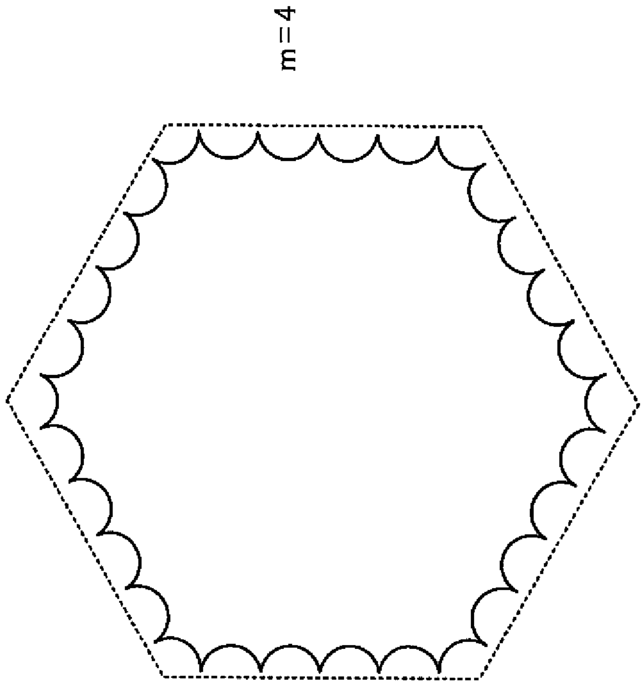

FIG. 36A

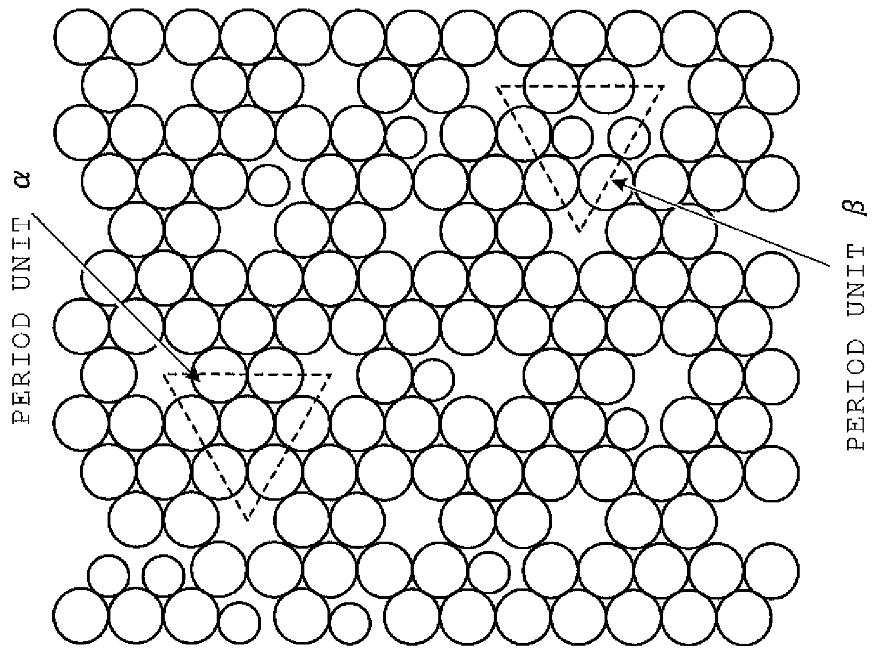


FIG. 36B

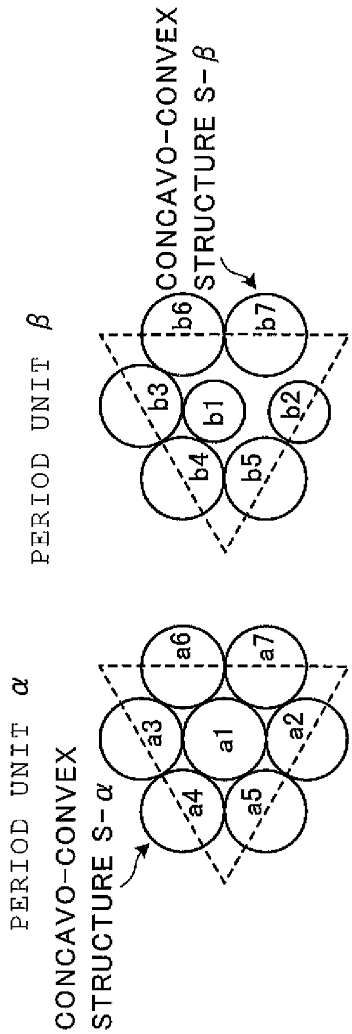


FIG.36C

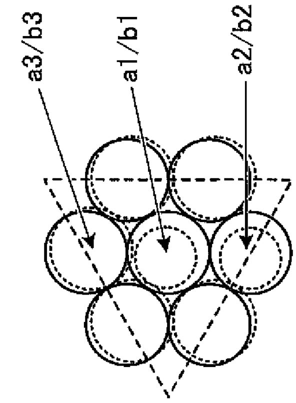

FIG. 37

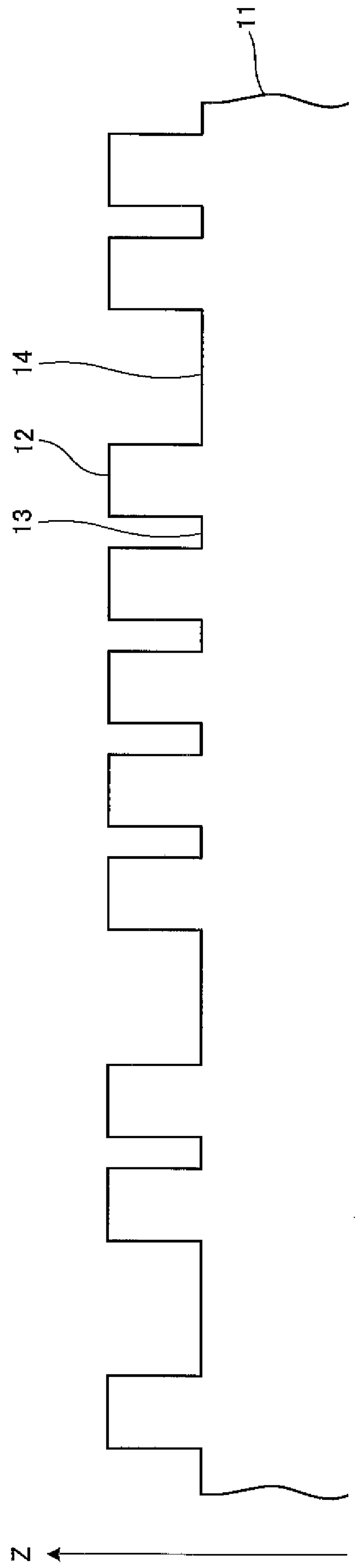

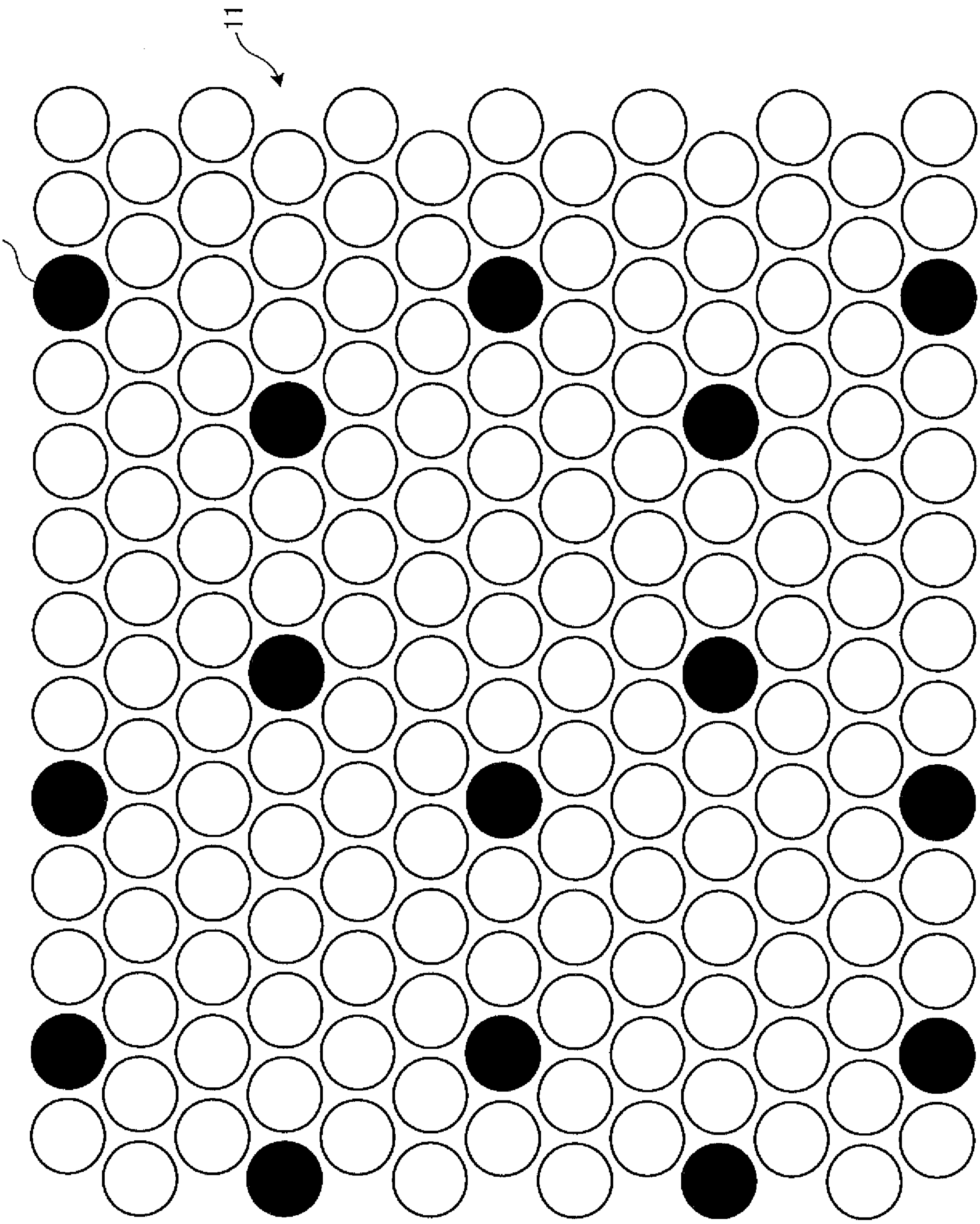


FIG. 38

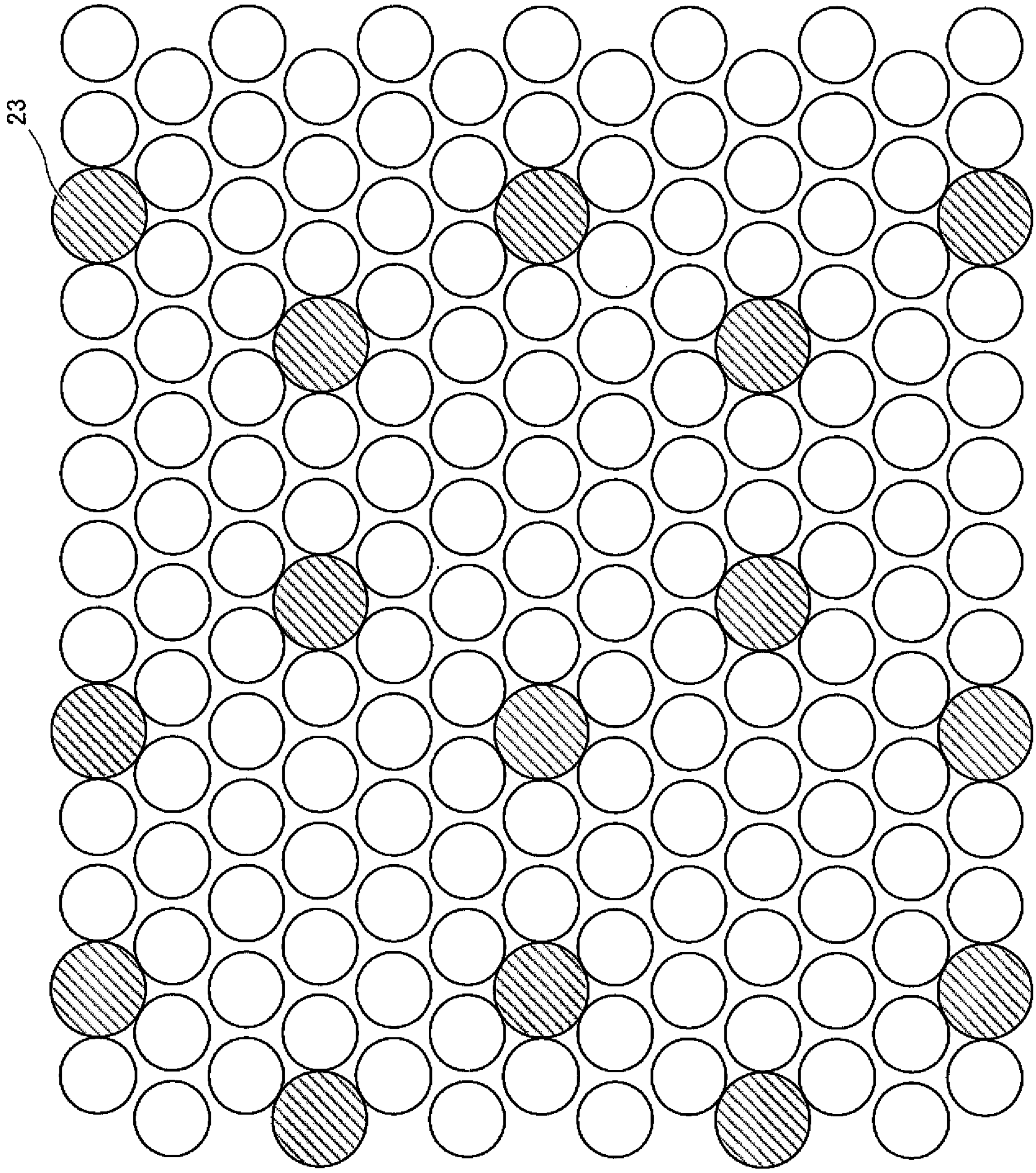


FIG. 39

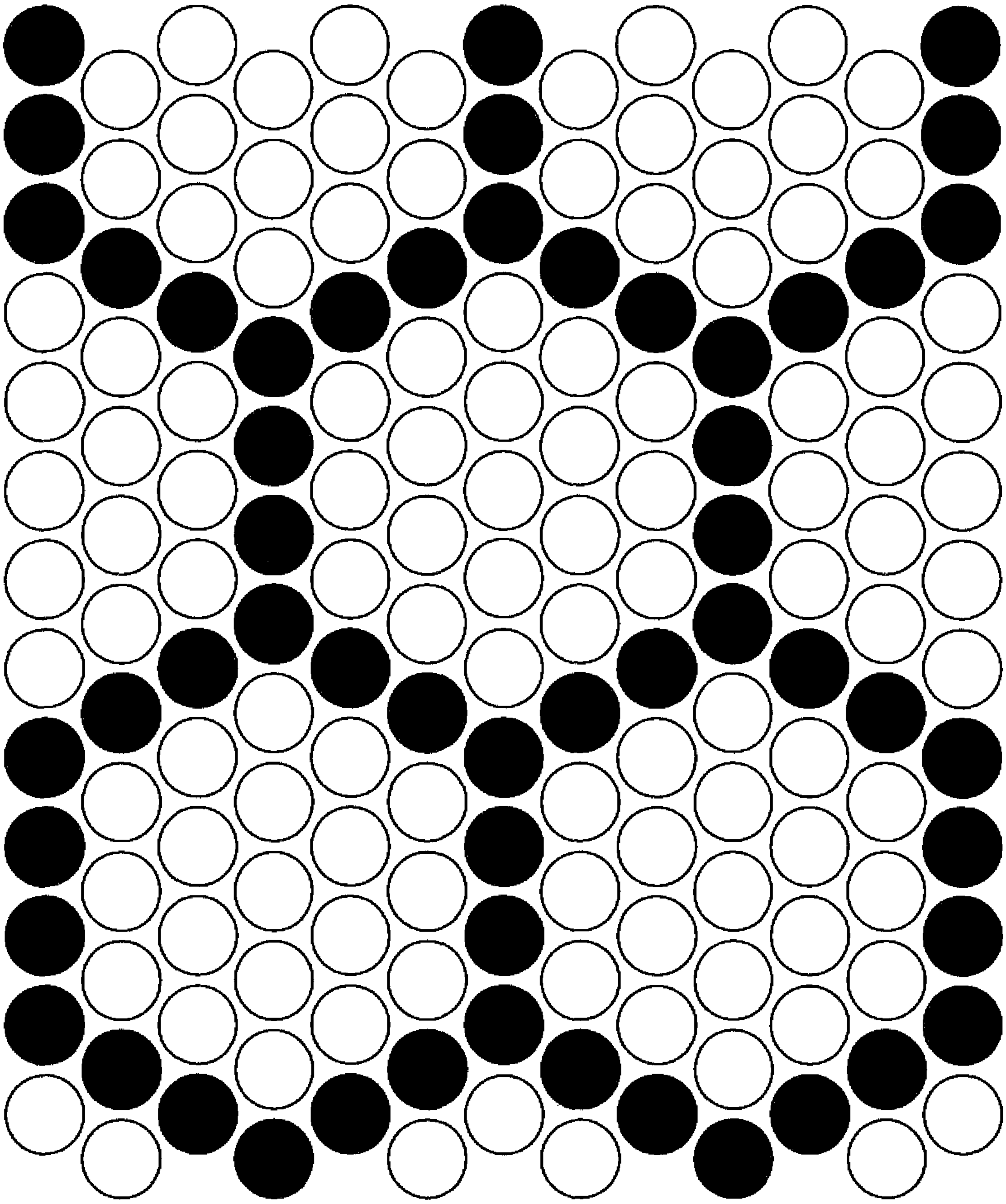

FIG. 40

FIG. 41

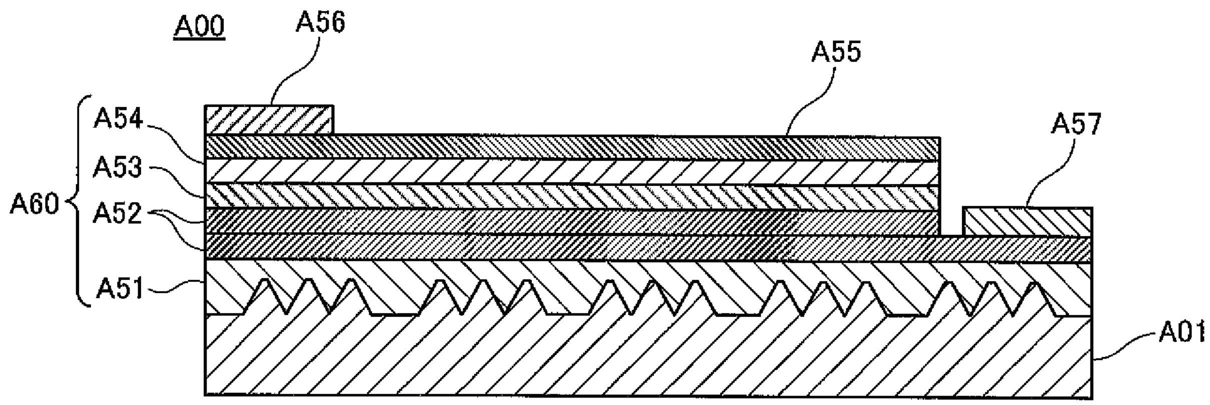

FIG. 42A

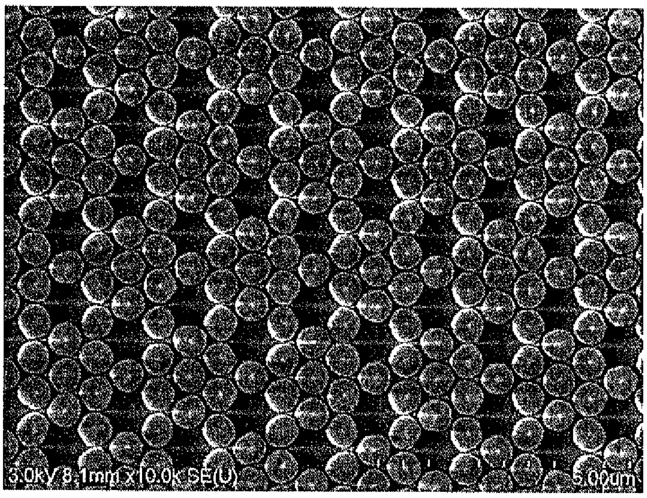


FIG. 42B

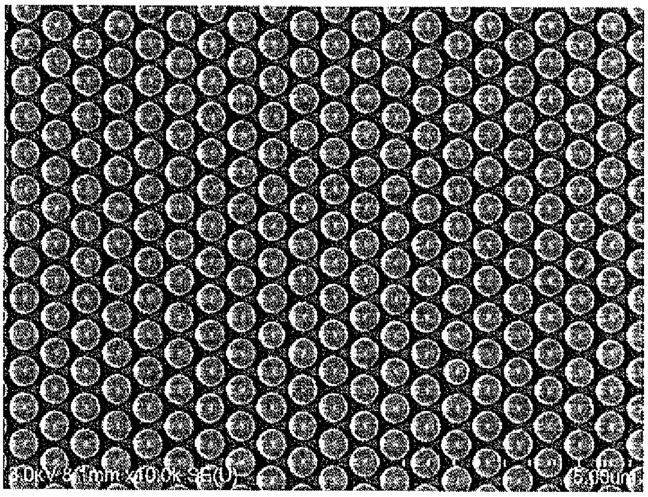

FIG. 42C

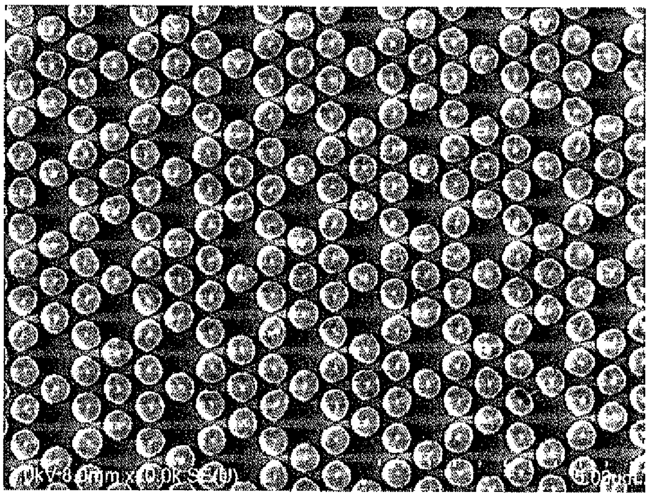

FIG. 43A

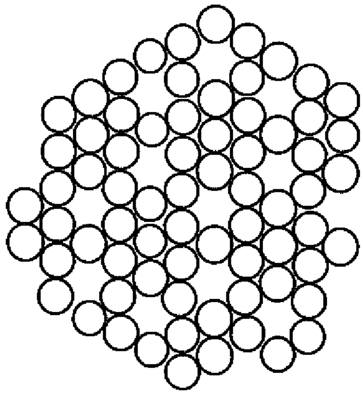

FIG. 43B

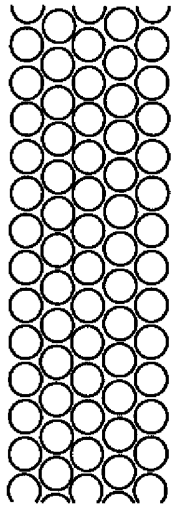

FIG. 43C

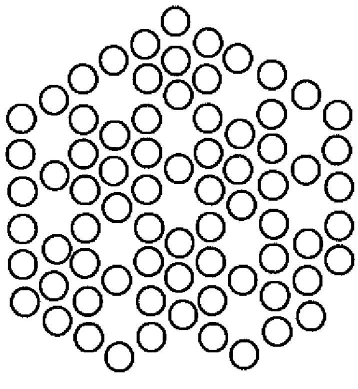

## INTERNATIONAL SEARCH REPORT

International application No.
PCT/JP2016/078748

A. CLASSIFICATION OF SUBJECT MATTER
*H01L33/22*(2010.01)i

According to International Patent Classification (IPC) or to both national classification and IPC

B. FIELDS SEARCHED

Minimum documentation searched (classification system followed by classification symbols)
H01L33/00-33/64

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 5707978 B1 (Nichia Chemical Industries, Ltd.), 13 March 2015 (13.03.2015), paragraphs [0001], [0011] to [0017], [0024] to [0025]; fig. 1, 3, 4 (Family: none) | 1,3-8,10-13, 15-18<br>2,9,14 |
| X<br>A | JP 2003-197961 A (Toyoda Gosei Co., Ltd.), 11 July 2003 (11.07.2003), paragraphs [0001], [0020]; fig. 4 (Family: none) | 1,18<br>2-17 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 October 2016 (31.10.16) | 08 November 2016 (08.11.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No. PCT/JP2016/078748

C (Continuation). DOCUMENTS CONSIDERED TO BE RELEVANT

| Category* | Citation of document, with indication, where appropriate, of the relevant passages | Relevant to claim No. |
|---|---|---|
| A | JP 2015-110333 A (Asahi Kasei E-materials Corp.), 18 June 2015 (18.06.2015), fig. 6 & US 2014/0217449 A1 fig. 6 & WO 2013/031887 A & EP 2752895 A1 & CN 103748699 A & KR 10-2014-0030311 A | 1-18 |
| A | JP 2012-109491 A (Kyocera Corp.), 07 June 2012 (07.06.2012), fig. 5 to 7 (Family: none) | 1-18 |
| A | JP 2012-209294 A (Kyocera Corp.), 25 October 2012 (25.10.2012), fig. 3 (Family: none) | 1-18 |

Form PCT/ISA/210 (continuation of second sheet) (January 2015)

## INTERNATIONAL SEARCH REPORT

International application No.
PCT/JP2016/078748

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☒ Claims Nos.: 1-7 (partial)
because they relate to parts of the international application that do not comply with the prescribed requirements to such an extent that no meaningful international search can be carried out, specifically:
(See extra sheet.)

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (January 2015)

INTERNATIONAL SEARCH REPORT

International application No.
PCT/JP2016/078748

Continuation of Box No.II-2 of continuation of first sheet(2)

The invention of claims 1-7 encompasses any optical material comprising a projection-and-depression structure having regular tooth-lost parts, while the description of the subject application discloses that, in order to solve a problem, premised on a board used for LED, of achieving both improvement of light-deriving efficiency and reduction of crystalline deficiency, the board is so made as to have such a projection-and-depression structure having regular tooth-lost parts.

Then, it was an ordinary technical knowledge at the time of filing the subject application that any optical base material other than the optical base materials used for LED did not necessarily also have the aforementioned problem. Besides, no basis for broadening or generalizing the disclosure made in the description to the scope of the invention of claims 1-7 encompassing any optical base material can be found.

Consequently, the inventions of claims 1-7 exceed the content set forth in the description, and do not comply with the requirement concerning the support prescribed under PCT Article 6.

Therefore, no significant search could be done and hence no search was done with respect to anything other than the "optical base material used for LED" and comprising such a projection-and-depression structure having regular tooth-lost parts.

Form PCT/ISA/210 (extra sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006352084 A
- JP 2011129718 A
- WO 2009102033 A
- JP 5707978 B
- WO 2015053363 A
- JP 2015195310 A
- JP 2015195311 A
- JP 2015195314 A
- JP 2015232931 A
- JP 2015233916 A
- JP 2015233917 A
- JP 2015248577 A
- JP 2016125838 A